(19) Europäisches Patentamt
European Patent Office
Office européen des brevets

(11) EP 3 358 406 A1

(12) **EUROPEAN PATENT APPLICATION**
published in accordance with Art. 153(4) EPC

(43) Date of publication:
**08.08.2018 Bulletin 2018/32**

(21) Application number: **16841310.2**

(22) Date of filing: **19.07.2016**

(51) Int Cl.:
***G03F 7/004*** *(2006.01)* ***G06F 3/041*** *(2006.01)*
***G06F 3/044*** *(2006.01)*

(86) International application number:
**PCT/JP2016/071128**

(87) International publication number:
**WO 2017/038278 (09.03.2017 Gazette 2017/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **28.08.2015 JP 2015169121**

(71) Applicant: **Fujifilm Corporation**
**Minato-ku**
**Tokyo 106-8620 (JP)**

(72) Inventors:
- **ARIDOMI Takashi**
**Fujinomiya-shi**
**Shizuoka 418-8666 (JP)**
- **KANNA Shinichi**
**Fujinomiya-shi**
**Shizuoka 418-8666 (JP)**

(74) Representative: **Jeffrey, Philip Michael**
**Dehns Germany**
**Theresienstraße 6-8**
**80333 München (DE)**

# (54) TRANSFER FILM, ELECTRODE PROTECTION FILM FOR CAPACITANCE-TYPE INPUT DEVICE, LAMINATED BODY, METHOD FOR MANUFACTURING LAMINATED BODY, AND CAPACITANCE-TYPE INPUT DEVICE

(57) Provided is a transfer film having a temporary support and a photosensitive transparent resin layer, in which the photosensitive transparent resin layer includes a binder polymer, a photopolymerizable compound having an ethylenic unsaturated group, a photopolymerization initiator, and a compound capable of reacting with acids by heating, at least one of the following condition 1 or the following condition 2 is satisfied, and the transfer film is used for an electrode protective film in an electrostatic capacitance-type input device, an electrode protective film for an electrostatic capacitance-type input device for which the transfer film is used, a laminate, a method for manufacturing a laminate, and an electrostatic capacitance-type input device including the laminate;
condition 1: the compound capable of reacting with acids by heating has a hydrophilic group in a molecule; and
condition 2: the photosensitive transparent resin layer further includes a compound having an ethylene oxide chain or a propylene oxide chain.

FIG. 14

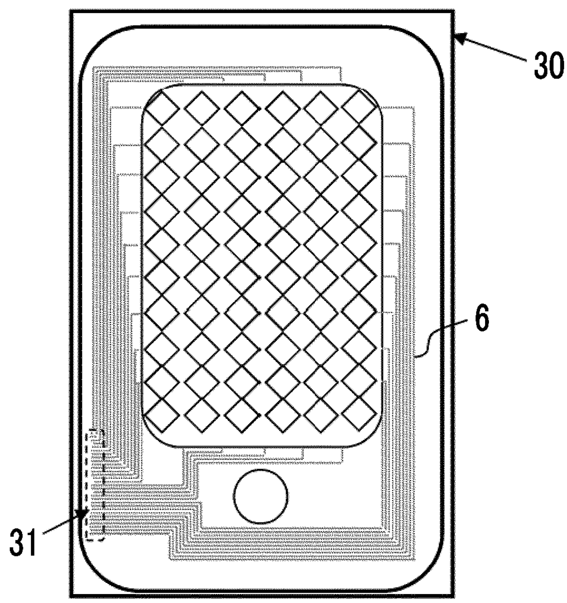


EP 3 358 406 A1

## Description

## BACKGROUND OF THE INVENTION

1. Field of the Invention

The present invention relates to a transfer film, an electrode protective film for an electrostatic capacitance-type input device, a laminate, a method for manufacturing a laminate, and an electrostatic capacitance-type input device. Specifically, the present invention relates to an electrostatic capacitance-type input device in which locations touched by a finger can be detected from changes in electrostatic capacitance, an electrode protective film for an electrostatic capacitance-type input device which can be used in the above-described electrostatic capacitance-type input device, a laminate, a method for manufacturing a laminate, and a transfer film. More specifically, the present invention relates to a transfer film which can be used to form electrode protective films for electrostatic capacitance-type input devices being excellent in terms of both heat and moisture resistance after the supply of saline water and development residues, an electrode protective film for an electrostatic capacitance-type input device for which the transfer film is used, a laminate, a method for manufacturing this laminate, and an electrostatic capacitance-type input device including this laminate.

2. Description of the Related Art

Recently, as electronic devices such as mobile phones, car navigations, personal computers, ticket vending machines, and bank terminals, there are electronic devices in which a tablet-type input device is disposed on the surface of a liquid crystal device or the like and, in a case in which a user touches places displaying command images with a finger, a stylus, or the like with reference to the command images displayed on image display regions in the liquid crystal device, information corresponding to the command images is input.

As the above-described input device (touch panel), there are resistance film-type input devices, electrostatic capacitance-type input devices, and the like. The electrostatic capacitance-type input devices have an advantage that a translucent conductive film needs to be formed only on one substrate. As such electrostatic capacitance-type input devices, for example, there are electrostatic capacitance-type devices in which electrode patterns are extended in mutually intersecting directions and input locations are detected by detecting changes in electrostatic capacitance between electrodes caused in a case in which the input devices are touched by a finger or the like.

For the purpose of protecting guidance wires (for example, metal wires such as copper lines) arranged in electrode patterns or frame portions in electrostatic capacitance-type input devices, a transparent resin layer is provided on a side opposite to the surface touched by a finger or the like for input.

## SUMMARY OF THE INVENTION

Transparent resin layers as described above are intended to protect guidance wires arranged in electrode patterns or frame portions in electrostatic capacitance-type input devices from moisture such as sweat. Hitherto, from the viewpoint of weight reduction, there has been a demand for decreasing the thickness of transparent resin layers; however, as an adverse effect, a new problems of the deterioration of the resistance to moisture such as sweat, that is, the heat and moisture resistance after the supply of saline water has been found. The heat and moisture resistance after the supply of saline water described above is practically important performance since, when human beings touch the input surfaces of electrostatic capacitance-type input devices with fingers, attached sweat intrudes into electrostatic capacitance-type input devices through gaps and reaches protective layers in the devices, and then electrostatic capacitance-type input devices are used in hot and humid environments or high-temperature and high-humidity environments are formed in electrostatic capacitance-type input devices due to charging.

Therefore, the present inventors studied methods for enhancing heat and moisture resistance and consequently found that it is effective to use photosensitive transparent resin layers in which a binder polymer and a compound capable of reacting with acids by heating such as a blocked isocyanate or an epoxy compound are used.

However, as a result of observing patterns obtained by exposing and developing photosensitive transparent resin layers in which a compound capable of reacting with acids by heating such as a blocked isocyanate or an epoxy compound having a viscosity in a certain range is used, it was found that there were cases in which development residues remained in non-exposed portions. It was found that, in a case in which development residues remained in non-exposed portions as described above, particulate foreign substances were observed in a case in which patterns were combined into electrostatic capacitance-type input devices, and a so-called surface defect after development was caused. The above-described problem of development residues generated in the presence of certain specific compounds was a new problems that has not been studied in the field of electrode protective films for electrostatic capacitance-type input devices and a problem caused for the first time in a case in which electrode protective films for electrostatic capacitance-type input devices were produced using photosensitive transparent resin layers in which a binder polymer and a compound capable of reacting with acids by heating were used.

Transfer films that can be used to form electrode protective films for electrostatic capacitance-type input devices being excellent in terms of both the heat and moisture resistance after the supply of saline water and developability including development residues as described above have not been known so far.

Meanwhile, for applications other than electrostatic capacitance-type input devices, photosensitive resin compositions in which a binder polymer and a compound capable of reacting with acids by heating are used are known.

JP2006-208824A describes a photosensitive resin composition used as solder resists or the like for printed-wiring assemblies. Specifically, JP2006-208824A describes a photosensitive resin composition containing (A) a resin having a specific structure, (B) a photopolymerizable compound having an ethylenic unsaturated group in the molecule, (C) a photopolymerization initiator, and (D) a blocked isocyanate compound. In addition, JP2006-208824A also describes a dry film including a dried coated film obtained by applying and drying the photosensitive resin composition on a film.

However, solder resists for printed-wiring assemblies or production of plates for screen printing are assumed to be not used in hot and humid environments after being touched by human fingers, and, for photosensitive resin compositions for solder resists for printed-wiring assemblies or photosensitive resin compositions for production of plates for screen printing, there are no cases in which heat and moisture resistance after the supply of saline water after curing has been a problem. Actually, no attention has been paid to heat and moisture resistance after the supply of saline water in JP2006-208824A.

In addition, in JP2006-208824A, there are no descriptions implying the use of the photosensitive resin compositions for the application of electrostatic capacitance-type input devices. Actually, since the photosensitive resin composition for solder resists for printed-wiring assemblies or the photosensitive resin composition for production of plates for screen printing is not intended to be laminated on image display portions in image display devices, generally, solder resists or plates are colored, or the transparency deteriorates. Therefore, those skilled in the art have not thus far studied the alternative use of the photosensitive resin composition for solder resists for printed-wiring assemblies or the photosensitive resin composition for production of plates for screen printing for the application of electrostatic capacitance-type input devices.

An object of the present invention is to provide a transfer film which can be used to form electrode protective films for electrostatic capacitance-type input devices being excellent in terms of both heat and moisture resistance after the supply of saline water and development residues.

The present inventors found that the use of a photosensitive transparent resin layer in which a binder polymer and a compound which has a hydrophilic group in the molecule and is capable of reacting with acids by heating are jointly used or a photosensitive transparent resin layer in which a binder polymer, a compound capable of reacting with acids by heating, and a compound having a specific hydrophilic group are jointly used enables the formation of electrode protective films for electrostatic capacitance-type input devices being excellent in terms of both the heat and moisture resistance after the supply of saline water and development residues.

Here, JP2014-065833A describes that a high degree of wash durability can be imparted using a fiber treatment agent composition including an aqueous blocked polyisocyanate in which at least some of isocyanate groups in the polyisocyanate are blocked isocyanate groups blocked with an amine-based compound and aqueous isocyanate groups to which a hydrophilic group is added and the initial glass transition temperature is 0°C or higher. However, the fiber treatment agent composition does not include any of (A) a binder polymer, (B) the photopolymerizable compound having an ethylenic unsaturated group, and (C) the photopolymerization initiator, and the fiber treatment agent composition is not photosensitive, and thus JP2014-065833A is a document regarding a technical field that is totally different from electrode protective films for electrostatic capacitance-type input devices.

The present invention which is specific means for achieving the above-described objects will be described below.

[1] A transfer film comprising: a temporary support; and a photosensitive transparent resin layer located on the temporary support, in which the photosensitive transparent resin layer includes (A) a binder polymer, (B) a photopolymerizable compound having an ethylenic unsaturated group, (C) a photopolymerization initiator, and (D) a compound capable of reacting with acids by heating, at least one of the following condition 1 or the following condition 2 is satisfied, and the transfer film is used for an electrode protective film in an electrostatic capacitance-type input device;

condition 1: (D) the compound capable of reacting with acids by heating has a hydrophilic group in a molecule; and
condition 2: the photosensitive transparent resin layer further includes (E) a compound having an ethylene oxide chain or a propylene oxide chain.

[2] The transfer film according to [1], in which a viscosity at 25°C of (D) the compound capable of reacting with acids by heating is preferably 0.1 to 100 Pa·s.

[3] The transfer film according to [1] or [2], in which the viscosity at 25°C of (D) the compound capable of reacting with acids by heating is preferably 5 to 60 Pa·s.
[4] The transfer film according to any one of [1] to [3], in which (D) the compound capable of reacting with acids by heating is preferably a blocked isocyanate.
[5] The transfer film according to any one of [1] to [4], in which the hydrophilic group in the molecule of (D) the compound capable of reacting with acids by heating is preferably an ethylene oxide chain or a propylene oxide chain.
[6] The transfer film according to any one of [1] to [5], in which a thickness of the photosensitive transparent resin layer is preferably 1 to 20 μm.
[7] The transfer film according to any one of [1] to [6], comprising: a second transparent resin layer on the photosensitive transparent resin layer, in which a refractive index of the second transparent resin layer is preferably higher than a refractive index of the photosensitive transparent resin layer.
[8] An electrode protective film for an electrostatic capacitance-type input device, in which the temporary support is removed from the transfer film according to any one of [1] to [7].
[9] A laminate comprising: a substrate including an electrode of an electrostatic capacitance-type input device; and a photosensitive transparent resin layer located on the substrate, in which the photosensitive transparent resin layer is formed by transferring the photosensitive transparent resin layer from the transfer film according to any one of [1] to [7].
[10] A laminate comprising: a substrate including an electrode of an electrostatic capacitance-type input device; and a photosensitive transparent resin layer located on the substrate, in which the photosensitive transparent resin layer includes (A) a binder polymer, (B) a photopolymerizable compound having an ethylenic unsaturated group, (C) a photopolymerization initiator, and (D) a compound capable of reacting with acids by heating, and at least one of the following condition 1 or the following condition 2 is satisfied;

condition 1: (D) the compound capable of reacting with acids by heating has a hydrophilic group in a molecule; and
condition 2: the photosensitive transparent resin layer further includes (E) a compound having an ethylene oxide chain or a propylene oxide chain.

[11] The laminate according to [10], in which a viscosity at 25°C of (D) the compound capable of reacting with acids by heating is preferably 0.1 to 100 Pa·s.
[12] The laminate according to [10] or [11], in which the viscosity at 25°C of (D) the compound capable of reacting with acids by heating is preferably 5 to 60 Pa·s.
[13] The laminate according to any one of [9] to [12], in which the electrode is a transparent electrode pattern.
[14] The laminate according to any one of [9] to [13], in which the substrate is a transparent film substrate.
[15] A method for manufacturing a laminate comprising: transferring a photosensitive transparent resin layer from the transfer film according to any one of [1] to [7] onto a substrate including an electrode of an electrostatic capacitance-type input device.
[16] The method for manufacturing a laminate according to [15], in which the substrate is preferably a transparent film substrate.
[17] A laminate manufactured by using the method for manufacturing a laminate according to [15] or [16].
[18] An electrostatic capacitance-type input device comprising: the laminate according to any one of [9] to [14] and [17].

According to the present invention, it is possible to provide a transfer film which can be used to form electrode protective films for electrostatic capacitance-type input devices being excellent in terms of both heat and moisture resistance after the supply of saline water and development residues.

## BRIEF DESCRIPTION OF THE DRAWINGS

Fig. 1A is a schematic cross-sectional view illustrating an example of a constitution of an electrostatic capacitance-type input device of the present invention.
Fig. 1B is a schematic cross-sectional view illustrating another example of the constitution of the electrostatic capacitance-type input device of the present invention.
Fig. 2 is an explanatory view illustrating an example of a front plate in the present invention.
Fig. 3 is an explanatory view illustrating an example of a relationship between a transparent electrode pattern and non-patterned regions in the present invention.
Fig. 4 is a top view illustrating an example of the front plate in which an opening portion is formed.
Fig. 5 is a top view illustrating an example of the front plate on which a mask layer is formed.

Fig. 6 is a top view illustrating an example of the front plate on which a first transparent electrode pattern is formed.
Fig. 7 is a top view illustrating an example of the front plate on which the first transparent electrode pattern and a second transparent electrode pattern are formed.
Fig. 8 is a top view illustrating an example of the front plate on which a conductive element different from the first and second transparent electrode patterns is formed.
Fig. 9 is an explanatory view illustrating a cross-section of a metal nanowire.
Fig. 10 is an explanatory view illustrating an example of a taper shape of an end portion of the transparent electrode pattern.
Fig. 11 is a schematic cross-sectional view illustrating an example of a constitution of a laminate of the present invention.
Fig. 12 is a schematic cross-sectional view illustrating an example of the constitution of the transfer film of the present invention.
Fig. 13 is a top view illustrating another example of the constitution of the electrostatic capacitance-type input device of the present invention and illustrates an aspect including a terminal portion (edge portion) of a guidance wire which is pattern-exposed and is not covered with a photosensitive transparent resin layer.
Fig. 14 is a schematic view illustrating an example of a state in which the transfer film of the present invention having the photosensitive transparent resin layer and a second transparent resin layers is laminated on the transparent electrode pattern in the electrostatic capacitance-type input device by means of lamination and is yet to be cured by means of exposure or the like.
Fig. 15 is a schematic view illustrating an example of a desired pattern in which the photosensitive transparent resin layer and the second transparent resin layer are cured.

## DESCRIPTION OF THE PREFERRED EMBODIMENTS

Hereinafter, a transfer film, an electrode protective film for an electrostatic capacitance-type input device, a laminate, and an electrostatic capacitance-type input device of the present invention will be described. Hereinafter, constituent requirements will be described on the basis of typical embodiments or specific examples of the present invention in some cases, but the present invention is not limited to these embodiments or specific examples. Meanwhile, in the present specification, numerical ranges expressed using "to" includes numerical values before and after the "to" as the lower limit value and the upper limit value.

[Transfer film]

The transfer film of the present invention is a transfer film having a temporary support and a photosensitive transparent resin layer located on the temporary support,
in which the photosensitive transparent resin layer includes (A) a binder polymer, (B) a photopolymerizable compound having an ethylenic unsaturated group, (C) a photopolymerization initiator, and (D) a compound capable of reacting with acids by heating,
at least one of the following condition 1 or the following condition 2 is satisfied, and
the transfer film is used for an electrode protective film in an electrostatic capacitance-type input device;
condition 1: (D) the compound capable of reacting with acids by heating has a hydrophilic group in a molecule; and
condition 2: the photosensitive transparent resin layer further includes (E) a compound having an ethylene oxide chain or a propylene oxide chain.
The above-described constitution enables the transfer film of the present invention to be used to form electrode protective films for electrostatic capacitance-type input devices being excellent in terms of both heat and moisture resistance after the supply of saline water and development residues.
Although not confined to any theories, it is anticipated that, even in a case in which developability is enhanced using a binder polymer and a compound capable of reacting with acids by heating, according to the constitution of the present invention, in the photosensitive transparent resin layer that has been irradiated with light (ultraviolet rays) and heated, the photopolymerizable compound forms a crosslinking structure densely enough to sufficiently shield saline water. Therefore, it is assumed that the heat and moisture resistance after the supply of saline water after the exposure of the transferred photosensitive transparent resin layer can be improved.
Meanwhile, the present inventors found that, in a pattern of the transparent resin layer obtained by exposing and developing the photosensitive transparent resin layer in which the binder polymer and the compound capable of reacting with acids by heating are used, development residues remain in non-exposed portions in a case in which a compound which is highly lipophilic and is capable of reacting acids by heating is used. Therefore, the fact that the compound capable of reacting acids by heating is highly lipophilic is assumed to be a cause of development residues after development. Therefore, it is anticipated that, as a result of changing the photosensitive transparent resin layer to

be hydrophilic from lipophilic, the generation of development residues can be suppressed.

However, in a case in which the photosensitive transparent resin layer is changed to be hydrophilic without adding the compound capable of reacting with acids by heating, it is anticipated that the heat and moisture resistance including the heat and moisture resistance after the supply of saline water degrades. In contrast, in the constitution of the present invention, in a case in which a hydrophilic group is introduced into the compound capable of reacting with acids by heating or, separately from the compound capable of reacting with acids by heating, a compound having a specific hydrophilic group is added to the photosensitive transparent resin layer, due to the synergetic effect of the compound capable of reacting with acids by heating and the hydrophilic group, the generation of development residues can be suppressed without causing the degradation of the heat and moisture resistance after the supply of saline water.

Meanwhile, in a case in which the reaction percentage of the photopolymerizable compound in the photosensitive transparent resin layer is increased by increasing the light irradiation amount and thus the three-dimensional crosslinking density is increased, cured films significantly contract due to curing, and thus a possibility of the adhesiveness between the transferred photosensitive transparent resin layer and a substrate being impaired can be considered. According to a preferred aspect of the transfer film of the present invention, it is possible to form electrode protective films for electrostatic capacitance-type input devices being excellent in terms of both heat and moisture resistance after the supply of saline water and development residues without increasing the light irradiation amount, and thus the adhesiveness between the transferred photosensitive transparent resin layer and a substrate is also likely to be favorable.

Hereinafter, a preferred aspect of the transfer film of the present invention will be described.

The transfer film of the present invention may satisfy both the condition 1 and the condition 2.

Meanwhile, the transfer film of the present invention is used to form electrode protective layers in electrostatic capacitance-type input devices and, among electrode protective films, is preferably used to form transparent insulating layers or transparent protective layers for electrostatic capacitance-type input devices. Since the photosensitive transparent resin layer is in a non-cured state, the transfer film of the present invention can be used as a transfer film for forming the laminate patterns of electrode protective films for electrostatic capacitance-type input devices, more preferably as a transfer film for forming the laminate patterns of refractive index-adjusting layers and overcoat layers (transparent protective layers) on transparent electrode patterns by means of the photolithography.

<Temporary support>

The temporary support that is used in the transfer film is not particularly limited.

(Thickness)

The thickness of the temporary support is not particularly limited, but generally in a range of 5 to 200 μm and, particularly, preferably in a range of 10 to 150 μm from the viewpoint of easy handling, versatility, and the like.

(Material)

The temporary support is preferably a film and more preferably a resin film.

As the film that is used as the temporary support, it is possible to use flexible materials that do not significantly deform, contract, or extend under pressurization or under pressurization and heating. Examples of the above-described temporary support include polyethylene terephthalate films, triacetylcellulose films, polystyrene films, polycarbonate films, and the like, and, among these, biaxially-stretched polyethylene terephthalate films are particularly preferred.

In addition, the temporary support may be transparent and may contain dyed silicon, an alumina sol, a chromium salt, a zirconium salt, or the like.

In addition, the temporary support can be imparted with a conductive property using the method described in JP2005-221726A.

<Constitution of photosensitive transparent resin layer>

The photosensitive transparent resin layer may be photocurable or heat-curable and photocurable. Among these, the photosensitive transparent resin layer and a second transparent resin layer described below are preferably heat-curable transparent resin layers and photocurable transparent resin layers since it is easy to form films by photocuring the layer after transfer and reliability can be imparted to films by means of heat-curing after the formation of films.

Meanwhile, in the present specification, for the convenience in description, in a case in which the photosensitive transparent resin layer and the second transparent resin layer in the transfer film of the present invention are transferred onto a transparent electrode pattern, are photocured, and thus become no longer photocurable, these layers will be continuously termed as the photosensitive transparent resin layer and the second transparent resin layer respectively

regardless of whether or not the layers are heat-curable. Furthermore, there are cases in which these layers are photocured and then heat-cured, and even in these cases, these layers will be continuously termed as the photosensitive transparent resin layer and the second transparent resin layer respectively regardless of whether or not the layers are curable.

Similarly, in a case in which the photosensitive transparent resin layer and the second transparent resin layer in the transfer film of the present invention are transferred onto a transparent electrode pattern, are heat-cured, and thus become no longer heat-curable, these layers will be continuously termed as the photosensitive transparent resin layer and the second transparent resin layer respectively regardless of whether or not the layers are photocurable.

(Thickness)

In the transfer film of the present invention, the thickness of the photosensitive transparent resin layer is preferably 1 to 25 μm, more preferably 1 to 20 μm, still more preferably 2 to 15 μm, and particularly preferably 3 to 12 μm. In a case in which the thickness of the photosensitive transparent resin layer is sufficiently thick, it is possible to improve the heat and moisture resistance after the supply of saline water of the transferred photosensitive transparent resin layer (particularly, after being exposed, developed, and heated). The photosensitive transparent resin layer is preferably used in image display portions of electrostatic capacitance-type input devices, and, in this case, an increase in the transparency and the light transmittance is preferred, and, in a case in which the thickness of the photosensitive transparent resin layer is sufficiently thin, a decrease in the light transmittance of the photosensitive transparent resin layer due to absorption is not easily caused, and it becomes difficult to absorb short wavelengths, and thus yellow coloration is also not easily caused.

(Refractive index)

In the transfer film of the present invention, the refractive index of the photosensitive transparent resin layer is preferably 1.5 to 1.53, more preferably 1.5 to 1.52, and particularly preferably 1.51 to 1.52.

(Composition)

The transfer film of the present invention may be a negative-type material or a positive-type material.

The transfer film of the present invention is preferably a negative-type material.

The method for controlling the refractive index of the photosensitive transparent resin layer is not particularly limited, and it is possible to singly use a photosensitive transparent resin layer having a desired refractive index, use a photosensitive transparent resin layer to which particles such as metal particles or metal oxide particles are added, or use a complex of a metal salt and a macromolecule.

Furthermore, in the photosensitive transparent resin layer, additives may be used. Examples of the additives include the surfactants described in Paragraph 0017 in the specification of JP4502784B and Paragraphs 0060 to 0071 of JP2009-237362A, the thermopolymerization inhibitors described in Paragraph 0018 in the specification of JP4502784B, and, furthermore, other additives described in Paragraphs 0058 to 0071 of JP2000-310706A.

Hitherto, a case in which the transfer film of the present invention is a negative-type material has been mainly described, but the transfer film of the present invention may be a positive-type material.

- (A) Binder polymer -

The transfer film of the present invention includes (A) a binder polymer in the photosensitive transparent resin layer.

The binder polymer is preferably a carboxyl group-containing acrylic resin having an acid value of 60 mgKOH/g or more. It is assumed that, in a case in which a blocked isocyanate is added to the carboxyl group-containing acrylic resin so as to form thermal crosslinking, an increase in the three-dimensional crosslinking density, the anhydrization and hydrophobilization of the carboxyl group in the carboxyl group-containing acrylic resin, or the like contributes to the improvement of the heat and moisture resistance after the supply of saline water.

The photosensitive transparent resin layer may include an additional binder polymer other than the carboxyl group-containing acrylic resin having an acid value of 60 mgKOH/g or more.

As the additional binder polymer included in the photosensitive transparent resin layer, an arbitrary polymer component can be used without any particular limitation, and, from the viewpoint of using the photosensitive transparent resin layer as transparent protective films in electrostatic capacitance-type input devices, polymer components having high surface hardness and favorable heat resistance are preferred, alkali-soluble resins are more preferred, and, among the alkali-soluble resins, well-known photosensitive siloxane resin materials and the like can be used.

The binder polymer included in the organic solvent-based resin composition that is used to form the photosensitive transparent resin layer is preferably a carboxyl group-containing acrylic resin having an acid value of 60 mgKOH/g or more, and it is more preferable that both the binder polymer included in the organic solvent-based resin composition that is used to form the photosensitive transparent resin layer and a resin or binder polymer having an acidic group included in water-based resin compositions that are used to form the second transparent resin layer described below contain an acrylic resin from the viewpoint of enhancing interlaminar adhesiveness before and after the transfer of the photosensitive transparent resin layer and the second transparent resin layer. A preferred range of the binder polymer for the photosensitive transparent resin layer will be specifically described.

The binder polymer which is used in the photosensitive transparent resin layer and is a carboxyl group-containing acrylic resin having an acid value of 60 mgKOH/g or more (referred to as binder or polymer) is not particularly limited within the scope of the gist of the present invention, can be appropriately selected from well-known binder polymers, and, for example, it is preferable to use binder polymers that are carboxyl group-containing acrylic resins having an acid value of 60 mgKOH/g or more among the polymers described in Paragraph 0025 of JP2011-95716A and binder polymers that are carboxyl group-containing acrylic resins having an acid value of 60 mgKOH/g or more among the polymers described in Paragraphs 0033 to 0052 of JP2010-237589A.

The acid value of the binder polymer that is a carboxyl group-containing acrylic resin having an acid value of 60 mgKOH/g or more is preferably 60 to 200 mgKOH/g, more preferably 70 to 150 mgKOH/g, and particularly preferably 80 to 120 mgKOH/g.

As the acid value of the binder polymer in the present invention, the value of a theoretical acid value computed using the calculation method described in the following publications and the like is used. <0063> of JP2004-149806A and <0070> of JP2012-211228A.

In addition, the photosensitive transparent resin layer may include polymer latex as the binder polymer. The polymer latex mentioned herein refers to latex obtained by dispersing water-insoluble polymer particles in water. The polymer latex is described in, for example, "Chemistry of high-molecular-weight latex (published by Kobunshi Kankokai (1973))" by Muroi Soichi.

The polymer particles that can be used are preferably polymer particles of a polymer such as an acrylic polymer, a vinyl acetate-based polymer, a rubber-based (for example, styrene-butadiene-based or chloroprene-based) polymer, an olefin-based polymer, a polyester-based polymer, a polyurethane-based polymer, or a polystyrene-based polymer or a copolymer thereof.

It is preferable to strengthen the mutual bonding force between polymer chains that constitute the polymer particles. Examples of means for strengthening the mutual bonding force between polymer chains include methods in which an interaction by a hydrogen bond is used and methods in which a covalent bond is used. Means for imparting a hydrogen bonding force is preferably the introduction of a monomer having a polar group into a polymer chain by means of copolymerization or graft polymerization.

Examples of the polar group in the binder polymer include carboxyl groups (included in acrylic acid, methacrylic acid, itaconic acid, fumaric acid, maleic acid, crotonic acid, partially-esterified maleic acid, and the like), primary, secondary, and tertiary amino groups, ammonium salt groups, sulfonic acid groups (styrene sulfonate), and the like, and the binder polymer that is a carboxyl group-containing acrylic resin having an acid value of 60 mgKOH/g or more has at least a carboxyl group.

A preferred range of the copolymerization proportion of the monomer having the polar group is 5% to 50% by mass, more preferably 5% to 40% by mass, and still more preferably 20% to 30% by mass with respect to 100% by mass of the polymer. In the binder polymer which is a carboxyl group-containing acrylic resin having an acid value of 60 mgKOH/g or more, a preferred range of the copolymerization proportion of a monomer having a carboxyl group is in a range of 5% to 50% by mass, more preferably 5% to 40% by mass, and still more preferably 20% to 30% by mass with respect to 100% by mass of the polymer. Meanwhile, examples of means for generating a covalent bond include methods in which an epoxy compound, a blocked isocyanate, an isocyanate, a vinylsulfone compound, an aldehyde compound, a methylol compound, a carboxylic acid anhydride, or the like is reacted with a hydroxyl group, a carboxyl group, a primary or secondary amino group, an acetoacetyl group, a sulfonic acid, or the like.

The weight-average molecular weight of the polymer is preferably 10,000 or more and more preferably 20,000 to 100,000.

The polymer latex that can be used in the present invention may be polymer latex obtained by emulsification polymerization or polymer latex obtained by emulsification. Methods for preparing the polymer latex are described in, for example, "Emulsion Latex Handbook" (edited by the emulsion latex handbook editorial committee, published by Taiseisha Ltd. (1975)).

Examples of the polymer latex that can be used in the present invention include polymer latex obtained by means of the ammonia-neutralization and emulsification of alkyl acrylate copolymer-ammonium (trade name: JURYMER AT-210, manufactured by Nippon Junyaku Co., Ltd.), alkyl acrylate copolymer-ammonium (trade name: JURYMER ET-410, manufactured by Nippon Junyaku Co., Ltd.), alkyl acrylate copolymer-ammonium (trade name: JURYMER AT-510,

manufactured by Nippon Junyaku Co., Ltd.), or polyacrylic acid (trade name: JURYMER AC-10L, manufactured by Nippon Junyaku Co., Ltd.).

- (B) Photopolymerizable compound -

In the transfer film of the present invention, the photosensitive transparent resin layer includes (B) a photopolymerizable compound having an ethylenic unsaturated group. The photopolymerizable compound having an ethylenic unsaturated group needs to have at least one ethylenic unsaturated group as a photopolymerizable group and may have an epoxy group or the like in addition to the ethylenic unsaturated group. The transfer film more preferably includes a compound having a (meth)acryloyl group as the photopolymerizable compound in the photosensitive transparent resin layer.

As the photopolymerizable compound used in the transfer film, only one compound may be used singly or a combination of two or more compounds may be used, but a combination of two or more compounds is preferably used from the viewpoint of improving heat and moisture resistance after the supply of saline water after the exposure of the transferred photosensitive transparent resin layer. As the photopolymerizable compound used in the transfer film of the present invention, a combination of a tri- or higher-functional photopolymerizable compound and a difunctional photopolymerizable compound is more preferably used from the viewpoint of improving heat and moisture resistance after the supply of saline water after the exposure of the transferred photosensitive transparent resin layer. The proportion of the difunctional photopolymerizable compound used in all of the photopolymerizable compounds is preferably 10% to 90% by mass, more preferably 20% to 85% by mass, and particularly preferably 30% to 80% by mass. The proportion of the tri- or higher-functional photopolymerizable compound used in all of the photopolymerizable compounds is preferably 10% to 90% by mass, more preferably 15% to 80% by mass, and particularly preferably 20% to 70% by mass. The transfer film preferably includes, as the photopolymerizable compounds, at least a compound having two ethylenic unsaturated groups or a compound having at least three ethylenic unsaturated groups and more preferably includes at least a compound having two (meth)acryloyl groups or a compound having at least three ethylenic (meth)acryloyl groups.

In addition, in the transfer film, at least one photopolymerizable compound having an ethylenic unsaturated group preferably contains a carboxyl group since the carboxyl group in the binder polymer and the carboxyl group in the photopolymerizable compound having an ethylenic unsaturated group form a carboxylic acid anhydride and heat and moisture resistance after the supply of saline water can be further enhanced.

The photopolymerizable compound having an ethylenic unsaturated group containing a carboxyl group is not particularly limited, and commercially available compounds can be used. For example, ARONIX TO-2349 (manufactured by Toagosei Co., Ltd.), ARONIX M-520 (manufactured by Toagosei Co., Ltd.), ARONIX M-510 (manufactured by Toagosei Co., Ltd.), and the like can be preferably used. The proportion of the photopolymerizable compound having an ethylenic unsaturated group containing a carboxyl group used in all of the photopolymerizable compounds is preferably 1% to 50% by mass, more preferably 1% to 30% by mass, and particularly preferably 5% to 15% by mass.

The transfer film preferably includes, as the photopolymerizable compound, a urethane (meth)acrylate compound. The amount of the urethane (meth)acrylate compound mixed is preferably 10% by mass or more and more preferably 20% by mass or more of all of the photopolymerizable compounds. In the urethane (meth)acrylate compound, the number of functional groups in the photopolymerizable group, that is, the number of (meth)acryloyl groups is preferably three or more and more preferably four or more.

The photopolymerizable compound having a difunctional ethylenic unsaturated group is not particularly limited as long as the compound has two ethylenic unsaturated groups in the molecule, and commercially available (meth)acrylate compounds can be used. For example, it is possible to preferably use tricyclodecane dimethanol diacrylate (A-DCP, manufactured by Shin-Nakamura Chemical Co., Ltd.), tricyclodecane dimethanol dimethacrylate (DCP, manufactured by Shin-Nakamura Chemical Co., Ltd.), 1,9-nonanediol diacrylate (A-NOD-N, manufactured by Shin-Nakamura Chemical Co., Ltd.), 1,6-hexanediol diacrylate (A-HD-N, manufactured by Shin-Nakamura Chemical Co., Ltd.), and the like.

The photopolymerizable compound having a tri- or higher-functional ethylenic unsaturated group is not particularly limited as long as the compound has three or more ethylenic unsaturated groups in the molecule, and, for example, it is possible to use (meth)acrylate compounds having a skeleton such as dipentaerythritol (tri/tetra/penta/hexa)acrylates, pentaerythritol (tri/tetra)acrylates, trimethylolpropane triacrylate, ditrimethylolpropane tetraacrylate, and isocyanurate acrylate, and (meth)acrylate compounds having a long span length between (meth)acrylic acids are preferred. Specifically, it is possible to preferably use the caprolactone-modified compounds (KAYARAD DPCA manufactured by Nippon Kayaku Co., Ltd., A-9300-1CL manufactured by Shin-Nakamura Chemical Co., Ltd., and the like) and the alkylene oxide-modified compounds (KAYARAD RP-1040 manufactured by Nippon Kayaku Co., Ltd., ATM-35E and A-9300 manufactured by Shin-Nakamura Chemical Co., Ltd., EBECRYL 135 manufactured by Daicel-Allnex Ltd., and the like) of the above-described (meth)acrylate compounds having a skeleton such as dipentaerythritol (tri/tetra/penta/hexa)acrylates, pentaerythritol (tri/tetra)acrylates, trimethylolpropane triacrylate, ditrimethylolpropane tetraacrylate, and isocyanurate acrylate. In addition, it is preferable to use tri- or higher-functional urethane (meth)acrylates. As the tri- or higher-functional

urethane (meth)acrylates, it is possible to preferably use 8UX-015A (manufactured by Taisei Fine Chemical Co., Ltd.), UA-32P (manufactured by Shin-Nakamura Chemical Co., Ltd.), UA-1100H (manufactured by Shin-Nakamura Chemical Co., Ltd.,), and the like.

The average molecular weight of the photopolymerizable compound used in the transfer film is preferably 200 to 3,000, more preferably 250 to 2,600, and particularly preferably 280 to 2,200.

- (C) Photopolymerization initiator -

In the transfer film of the present invention, the photosensitive transparent resin layer includes (C) a photopolymerization initiator. In a case in which the photosensitive transparent resin layer includes the photopolymerizable compound and the photopolymerization initiator, it is possible to facilitate the formation of patterns of the photosensitive transparent resin layer.

As the photopolymerization initiator that is used in organic solvent-based resin compositions, it is possible to use the photopolymerization initiators described in Paragraphs 0031 to 0042 of JP2011-95716A. For example, it is possible to preferably use 1,2-octane dione, 1-[4-(phenylthio)-2-(O-benzoyloxime)] (trade name: IRGACURE OXE-01, manufactured by BASF), additionally, ethanone, 1-[9-ethyl-6-(2-methylbenzoyl)-9H-carbazole-3-yl]-, 1-(O-acetyloxime) (trade name: IRGACURE OXE-02, manufactured by BASF), 2-(dimethylamino)-2-[(4-methylphenyl)methyl]-1-[4-(4-morpholinyl)phenyl]-1-butanone (trade name: IRGACURE 379EG, manufactured by BASF), 2-methyl-1-(4-methyl thiophenyl)-2-morpholino-propan-1-one (trade name: IRGACURE 907, manufactured by BASF), 2-hydroxy-1-{4-[4-(2-hydroxy-2-methyl-propionyl)-benzyl]phenyl}-2-methyl-propan-1 -one (trade name: IRGACURE 127, manufactured by BASF), 2-benzyl-2-dimethylamino-1-(4-morpholinophenyl)-butanone-1 (trade name: IRGACURE 369, manufactured by BASF), 2-hydroxy-2-methyl-1-phenyl-erypropan-1-one (trade name: IRGACURE 1173, manufactured by BASF), 1-hydroxy-cyclohexyl-phenyl-ketone (trade name: IRGACURE 184, manufactured by BASF), 2,2-dimethoxy-1,2-diphenyl ethan-1-one (trade name: IRGACURE 651, manufactured by BASF), oxime ester-based photopolymerization initiator (trade name: Lunar 6, manufactured by DKSH Japan K.K.), and the like.

In the photosensitive transparent resin layer, the content of the photopolymerization initiator is preferably 1% by mass or more and more preferably 2% by mass or more of the photosensitive transparent resin layer. In the photosensitive transparent resin layer, the content of the photopolymerization initiator is preferably 10% by mass or less and more preferably 5% by mass or less of the photosensitive transparent resin layer from the viewpoint of improving the patterning property and substrate adhesiveness of the laminate of the present invention.

- (D) Compound capable of reacting with acids by heating -

In the transfer film of the present invention, the photosensitive transparent resin layer includes (D) a compound capable of reacting with acids by heating. The viscosity at 25°C of (D) the compound capable of reacting with acids by heating is preferably 0.1 to 100 Pa·s, more preferably 5 to 60 Pa·s, and still more preferably 20 to 40 Pa·s.

The viscosity at 25°C of the compound capable of reacting with acids by heating is preferably equal to or more than the lower limit value since the volatilization of this component during application and drying or post baking is suppressed, and the reactivity of the isocyanate during heating can be ensured.

The viscosity at 25°C of the compound capable of reacting with acids by heating is preferably equal to or less than the upper limit value since the fluidity of this component in the film during post baking is ensured, and thus the reactivity of the isocyanate during heating can be ensured.

It was found that, in the above-described viscosity range, (D) the compound capable of reacting with acids by heating is likely to remain on substrates even after development and turn into development residues.

(D) The compound capable of reacting with acids by heating is not particularly limited within the scope of the gist of the present invention. The compound capable of reacting with acids by heating is preferably a compound that becomes more highly reactive with acids after being heated to higher than 25°C than at 25°C. The compound capable of reacting with acids by heating is preferably a compound which has a group capable of reacting with acids that are temporarily inactivated by blocking agents and in which blocking agent-derived groups are dissociated at a predetermined dissociation temperature.

Examples of the compound capable of reacting with acids by heating include carboxylic acid compounds, alcohol compounds, amine compounds, blocked isocyanates, epoxy compounds, and the like, and the compound capable of reacting with acids by heating is preferably a blocked isocyanate or an epoxy compound.

In a case in which the transfer film of the present invention satisfies the condition 1, (D) the compound capable of reacting with acids by heating has a hydrophilic group in the molecule.

The compound capable of reacting with acids by heating which has a hydrophilic group in the molecule is not particularly limited, and well-known compounds can be used. The method for preparing the compound capable of reacting with acids by heating which has a hydrophilic group in the molecule is not particularly limited, and the compound can

be prepared by means of, for example, synthesis.

The compound capable of reacting with acids by heating which has a hydrophilic group in the molecule is preferably blocked isocyanate having a hydrophilic group in the molecule. The detail of the compound capable of reacting with acids by heating which has a hydrophilic group in the molecule will be described in the section of a blocked isocyanate below.

- (D1) Blocked isocyanate -

The blocked isocyanate refers to "a compound having a structure in which isocyanate groups are protected (masked) with a blocking agent".

The initial glass transition temperature (Tg) of the blocked isocyanate is preferably -40°C to 10°C and more preferably -30°C to 0°C.

The dissociation temperature of the blocked isocyanate is preferably 100°C to 160°C and more preferably 130°C to 150°C.

In the present specification, the dissociation temperature of the blocked isocyanate refers to "the temperature of an endothermic peak generated by a deprotection reaction of the blocked isocyanate in the case of being measured by means of differential scanning calorimetry (DSC) using a differential scanning calorimeter (manufactured by Seiko Instruments Inc., DSC6200)".

Examples of the blocking agent having a dissociation temperature of 100°C to 160°C include pyrazole-based compounds (3,5-dimethylpyrazole, 3-methylpyrazole, 4-bromo-3,5-dimethylpyrazole, 4-nitro-3,5-dimethylpyrazole, and the like), active methylene-based compounds (malonic acid diesters (dimethyl malonate, diethyl malonate, di-n-butyl malonate, and di-2-ethylhexyl malonate) and the like), triazole-based compounds (1,2,4-triazole and the like), oxime-based compounds (compounds having a structure represented by -C(=N-OH)- in the molecule such as formaldoxime, acetoaldoxime, acetoxime, methyl ethyl ketoxime, and cyclohexanone oxime), and the like. Among these, from the viewpoint of storage stability, oxime-based compounds and pyrazole-based compounds are preferred, and oxime-based compounds are particularly preferred.

In the transfer film of the present invention, the blocked isocyanate preferably an isocyanurate structure from the viewpoint of the brittleness of films and base material bonding forces. The blocked isocyanate having an isocyanurate structure can be prepared by, for example, turning hexamethylene diisocyanate into isocyanurate.

Among blocked isocyanates having an isocyanurate structure, compounds having an oxime structure for which an oxime-based compound is used as a blocking agent are more preferred than compounds not having an oxime structure since it is easy to set the dissociation temperature in a preferred range and decrease development residues.

In the blocked isocyanate, the number of blocked isocyanate groups per molecule is preferably 1 to 10, more preferably 2 to 6, and particularly preferably 3 or 4.

As the blocked isocyanate, the blocked isocyanate compounds described in 0074 to 0085 of JP2006-208824A may be used, the content of which is incorporated into the present specification.

Specific examples of the blocked isocyanate that is used in the transfer film of the present invention include the following compounds. However, the blocked isocyanate that is used in the present invention is not limited to the following specific examples.

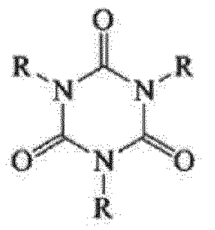

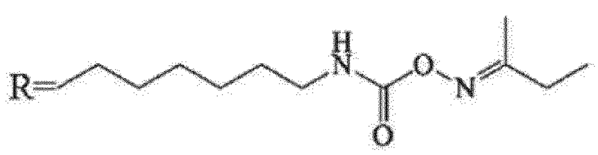

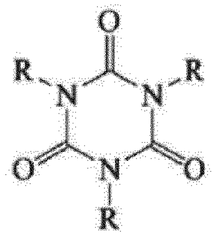

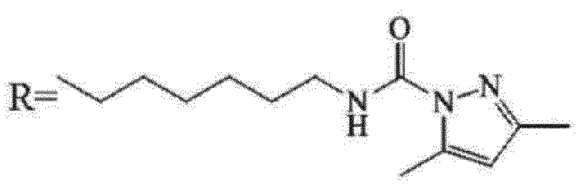

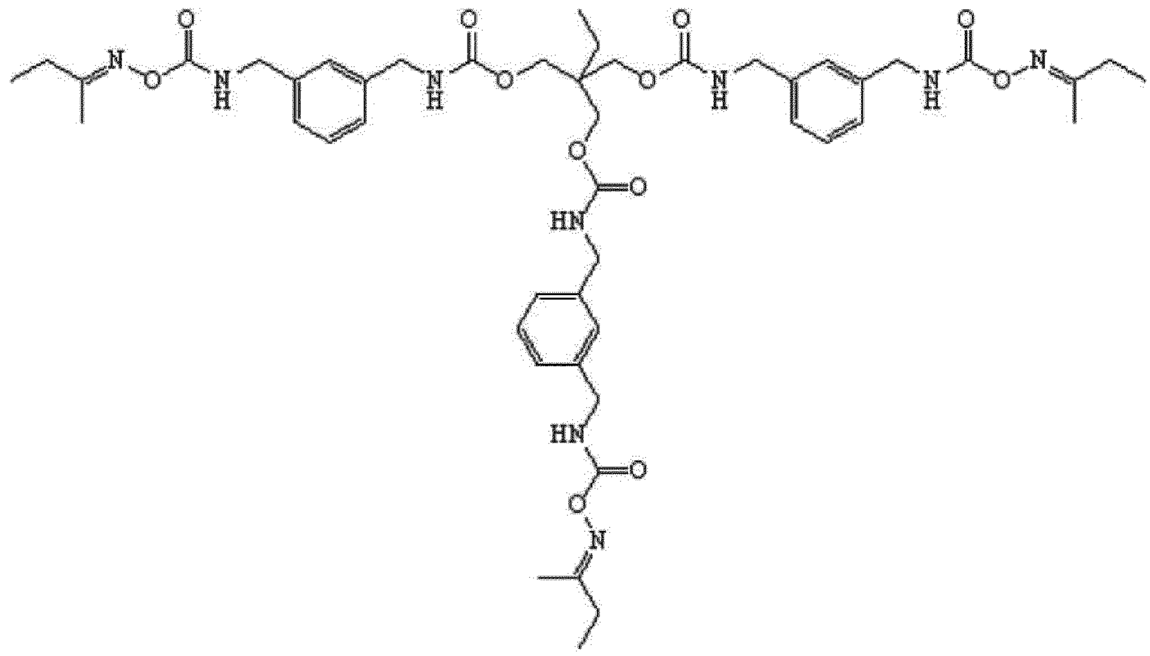

As the blocked isocyanate that is used in the transfer film, it is possible to use commercially available blocked isocyanates. Examples thereof include TAKENATE (registered trademark) B870N (manufactured by Mitsui Chemicals, Inc.) which is a methyl ethyl ketone oxime blocked body of isophorone diisocyanate, DURANATE (registered trademark) MF-K60B (manufactured by Asahi Kasei Corporation) which is a hexamethylene diisocyanate-based blocked isocyanate compound, and the like.

In the blocked isocyanate having a hydrophilic group in the molecule, at least some of isocyanate groups are preferably a blocked isocyanate which is an aqueous isocyanate group to which a hydrophilic group is added. The blocked isocyanate having a hydrophilic group in the molecule can be obtained by reacting an isocyanate group in a polyisocyanate and a blocking agent (in some cases, also referred to as the amine-based compound). Examples of the reaction method include a method in which a hydrophilic group is added to some of isocyanate groups in a polyisocyanate by chemical reactions.

The hydrophilic group in the compound capable of reacting with acids by heating is not particularly limited, and specific examples thereof include nonionic hydrophilic groups, cationic hydrophilic groups, and the like.

The nonionic hydrophilic groups are not particularly limited, and specific examples thereof include compounds obtained by adding ethylene oxide or propylene oxide to hydroxyl groups of alcohols such as methanol, ethanol, butanol, ethylene glycol, or diethylene glycol. That is, the hydrophilic group in the compound capable of reacting with acids by heating which has the hydrophilic group in the molecule is preferably an ethylene oxide chain or a propylene oxide chain. These compounds have active hydrogen that reacts with isocyanate groups and thus can be added to isocyanate groups. Among these, monoalcohols that can be dispersed in water in a small amount used are preferred.

In addition, the addition number of ethylene oxide chains or propylene oxide chains is preferably 4 to 30 and more preferably 4 to 20. In a case in which the addition number is 4 or more, there is a tendency that the water dispersibility further improves. In addition, in a case in which the addition number is 30 or less, there is a tendency that the initial Tg of the obtained blocked isocyanate further improves.

Examples of the method for adding the cationic hydrophilic group include a method in which a compound having both the cationic hydrophilic group and active hydrogen that reacts with isocyanate groups is used; a method in which, for example, a functional group such as a glycidyl group is introduced in advance into a polyisocyanate and then, for example, a specific compound such as sulfide or phosphine is reacted with the functional group, and the like, and the former method is easy.

The active hydrogen that reacts with isocyanate groups is not particularly limited, and specific examples thereof include a hydroxyl group, a thiol group, and the like. The compound having both the cationic hydrophilic group and active hydrogen that reacts with isocyanate groups is not particularly limited, and specific examples thereof include dimethylethanolamine, diethylethanolamine, diethanolamine, methyl diethanolamine, and the like. Tertiary amino groups that are introduced using the above-described compound can also be quaternized using dimethyl sulfate, diethyl sulfate, or the like.

The equivalent ratio between the isocyanate group to which the hydrophilic group is added and the blocked isocyanate group is preferably 1:99 to 80:20, more preferably 2:98 to 50:50, and particularly preferably 5:95 to 30:70.

The equivalent ratio is preferably set in the above-described range from the viewpoint of satisfying both the isocyanate reactivity and development residues.

As the blocked isocyanate having a hydrophilic group in the molecule and the method for synthesizing the blocked isocyanate, the aqueous blocked polyisocyanate described in 0010 to 0045 of JP2014-065833A can be preferably used, and the content of the publication is incorporated into the present specification by reference.

In a case in which the blocked isocyanate having a hydrophilic group in the molecule is synthesized, the addition reaction of a hydrophilic group or the blocking reaction of an isocyanate group can be caused in the presence of synthesis solvents. The synthesis solvents in this case preferably do not include any active hydrogen, and examples thereof include dipropylene glycol monomethyl ether, propylene glycol monomethyl ether acetate, methoxy propyl acetate, and the like.

In a case in which the blocked isocyanate having a hydrophilic group in the molecule is synthesized, the amount of the compound having a hydrophilic group added is preferably 1% to 100% by mass and more preferably 2% to 80% by mass of the polyisocyanate.

In a case in which the blocked isocyanate having a hydrophilic group in the molecule is synthesized, the amount of a blocking agent added is preferably 10% to 100% by mass and more preferably 20% to 99% by mass of the polyisocyanate.

The molecular weight of the blocked isocyanate that is used in the transfer film is preferably 200 to 3,000, more preferably 250 to 2,600, and particularly preferably 280 to 2,200.

-- (D2) epoxy compound --

The epoxy compound is not particularly limited, and well-known compounds can be used.

As the epoxy compound, the compound described in <0096> to <0098> of JP2015-135396A can be preferably used, and the content of the publication is incorporated into the present specification by reference.

Examples of the epoxy compound include EPOX-MK R151 (manufactured by Printec Corporation) and the like.

The content of the epoxy compound is preferably 5% to 50% by mass and more preferably 5% to 30% by mass of the photosensitive transparent resin layer.

(E) Compound having ethylene oxide chain or propylene oxide chain

In a case in which the transfer film of the present invention satisfies the condition 2, the photosensitive transparent resin layer further includes (E) a compound having an ethylene oxide chain or a propylene oxide chain.

The compound having an ethylene oxide chain or a propylene oxide chain is not particularly limited, and well-known compounds can be used.

The compound having an ethylene oxide chain or a propylene oxide chain is preferably a nonionic surfactant. As the compound having an ethylene oxide chain or a propylene oxide chain which is a nonionic surfactant, the compound described in <0021> to <0026> of WO2011/052620A can be preferably used, and the content of the publication is incorporated into the present specification by reference.

Examples of the compound having an ethylene oxide chain or a propylene oxide chain include EMULGEN B-66, EMULGEN A-90 (manufactured by Kao Corporation) and the like.

The content of the compound having an ethylene oxide chain or a propylene oxide chain is preferably 0.1% to 10% by mass, more preferably 0.3% to 8% by mass, and particularly preferably 0.5% to 5% by mass of the photosensitive transparent resin layer.

- Metal oxide particles -

The photosensitive transparent resin layer may or may not include particles (preferably metal oxide particles) for the purpose of adjusting the refractive index or the light transmittance. In order to control the refractive index of the photosensitive transparent resin layer in the above-described range, it is possible to add metal oxide particles to the resin layer in an arbitrary ratio depending on the kind of the polymer or the polymerizable compound being used. In the photosensitive transparent resin layer, the content of the metal oxide particles is preferably 0% to 35% by mass, more preferably 0% to 10% by mass, and particularly preferably 0% by mass of the photosensitive transparent resin layer.

Since the metal oxide particles are highly transparent and light-transmissible, it is possible to obtain photosensitive transparent resin layers having a high refractive index and excellent transparency.

The metal oxide particles preferably have a refractive index higher than the refractive index of a composition made of a material obtained by excluding these particles from the photosensitive transparent resin layer.

Meanwhile, the metal of the above-described metal oxide particles may also be a semi-metal such as B, Si, Ge, As, Sb, or Te.

The metal oxide particles which are light-transmissible and have a high refractive index are preferably oxide

particles including atoms such as Be, Mg, Ca, Sr, Ba, Sc, Y, La, Ce, Gd, Tb, Dy, Yb, Lu, Ti, Zr, Hf, Nb, Mo, W, Zn, B, Al, Si, Ge, Sn, Pb, Sb, Bi, and Te, more preferably titanium oxide, titanium complex oxide, zinc oxide, zirconium oxide, indium/tin oxide, or antimony/tin oxide, still more preferably titanium oxide, titanium complex oxide, or zirconium oxide, particularly preferably titanium oxide or zirconium oxide, and most preferably titanium dioxide. Particularly, titanium dioxide is preferably rutile-type titanium oxide having a high refractive index. The surfaces of these metal oxide particles can also be treated with an organic material in order to impart dispersion stability.

From the viewpoint of the transparency of the photosensitive transparent resin layer, the average primary particle diameter of the metal oxide particles is preferably 1 to 200 nm and particularly preferably 3 to 80 nm. Here, the average primary particle diameter of particles refers to the arithmetic average obtained by measuring the particle diameters of 200 arbitrary particles using an electronic microscope. In addition, in a case in which the shapes of particles are not spherical, the longest sides are considered as the diameters.

In addition, one kind of the metal oxide particles may be used or two or more kinds of the metal oxide particles can be jointly used.

In the transfer film of the present invention, the photosensitive transparent resin layer preferably has at least one of $ZrO_2$ particles, $Nb_2O_5$ particles, or $TiO_2$ particles from the viewpoint of controlling the refractive index in the range of the refractive index of the photosensitive transparent resin layer and more preferably has at least one of $ZrO_2$ particles or $Nb_2O_5$ particles.

<Constitution of second transparent resin layer>

The transfer film of the present invention preferably has a second transparent resin layer on the photosensitive transparent resin layer and more preferably has a second transparent resin layer disposed adjacent to the photosensitive transparent resin layer.

The second transparent resin layer may be heat-curable, photocurable, or heat-curable and photocurable. Among these, the second transparent resin layer is preferably at least a heat-curable transparent resin layer since reliability can be imparted to films by means of heat-curing after transfer and more preferably a heat-curable transparent resin layer and a photocurable transparent resin layer since it is easy to form films by photo-curing the layer after transfer and reliability can be imparted to films by means of heat-curing after the formation of films.

(Refractive index)

The transfer film of the present invention preferably has the second transparent resin layer on the photosensitive transparent resin layer, and the refractive index of the second transparent resin layer is more preferably higher than the refractive index of the photosensitive transparent resin layer.

In a case in which the refractive index difference between a transparent electrode pattern (preferably ITO) and the second transparent resin layer and the refractive index difference between the second transparent resin layer and the photosensitive transparent resin layer are decreased, light reflection is alleviated and thus the transparent electrode pattern becomes barely visible, and it is possible to improve the visibility of the transparent electrode pattern. In addition, even in a case in which the photosensitive transparent resin layer is laminated and then the second transparent resin layer is laminated without curing the photosensitive transparent resin layer, layer differentiation becomes favorable, and thus the visibility of the transparent electrode pattern can be improved with the above-described mechanism. Additionally, after the refractive index-adjusting layers (that is, the photosensitive transparent resin layer and the second transparent resin layer) are transferred onto the transparent electrode pattern from the transfer film, it is possible to develop the refractive index-adjusting layers in desired patterns by means of photolithography. Meanwhile, in a case in which the layer differentiation between the photosensitive transparent resin layer and the second transparent resin layer is favorable, the refractive index adjustment effect of the above-described mechanism is likely to be sufficient, and the improvement of the visibility of the transparent electrode pattern is likely to be sufficient.

The refractive index of the second transparent resin layer is preferably 1.60 or higher.

Meanwhile, the refractive index of the second transparent resin layer needs to be adjusted using the refractive index of the transparent electrode pattern, and the upper limit value of the refractive index is not particularly limited, but is preferably 2.1 or lower and more preferably 1.78 or lower, and may be 1.74 or lower.

Particularly, in a case in which the refractive index of the transparent electrode pattern exceeds 2.0 as in the case of an oxide of In and Zn (IZO), the refractive index of the second transparent resin layer is preferably 1.7 or higher and 1.85 or lower.

(Thickness)

In the transfer film of the present invention, the film thickness of the second transparent resin layer is preferably

500 nm or less and is more preferably 110 nm or less. The film thickness of the second transparent resin layer is preferably 20 nm or more. The film thickness of the second transparent resin layer is more preferably 55 to 100 nm, more particularly preferably 60 to 100 nm, and still more particularly preferably 70 to 100 nm.

(Composition)

The transfer film of the present invention may be a negative-type material or a positive-type material.

In a case in which the transfer film of the present invention is a negative-type material, the second transparent resin layer preferably includes metal oxide particles, a binder polymer (preferably an alkali-soluble resin), a photopolymerizable compound, and a polymerization initiator. Furthermore, additives and the like can be used, but components in the layer are not limited thereto.

In the transfer film of the present invention, the second transparent resin layer preferably includes a binder polymer, a photopolymerizable compound, and a photopolymerization initiator.

The method for controlling the refractive index of the second transparent resin layer is not particularly limited, and it is possible to singly use a transparent resin layer having a desired refractive index, use a transparent resin layer to which particles such as metal particles or metal oxide particles are added, or use a complex of a metal salt and a macromolecule.

Furthermore, in the second transparent resin layer, additives may be used. Examples of the additives include the surfactants described in Paragraph 0017 in the specification of JP4502784B and Paragraphs 0060 to 0071 of JP2009-237362A, the thermal polymerization inhibitors described in Paragraph 0018 in the specification of JP4502784B, and, furthermore, other additives described in Paragraphs 0058 to 0071 of JP2000-310706A.

Hitherto, a case in which the transfer film of the present invention is a negative-type material has been mainly described, but the transfer film of the present invention may be a positive-type material. In a case in which the transfer film of the present invention is a positive-type material, for example, the material and the like described in JP2005-221726A are used in the second transparent resin layer, but components are not limited thereto.

- Ammonium salt of monomer having acidic group or ammonium salt of resin having acidic group -

The second transparent resin layer preferably includes an ammonium salt of a monomer having an acidic group or an ammonium salt of a resin having an acidic group.

The ammonium salt of a monomer having an acidic group or the ammonium salt of a resin having an acidic group is not particularly limited.

The ammonium salt of a monomer having an acidic group or the ammonium salt of a resin having an acidic group in the second transparent resin layer is preferably an ammonium salt of an acrylic monomer or an acrylic resin having an acidic group.

The method for manufacturing the transfer film preferably includes a step of preparing a water-based resin composition including a monomer or a resin obtained by dissolving the monomer having an acidic group or the resin having an acidic group in an ammonia aqueous solution and turning at least some of the acidic group into an ammonium salt.

-- Resin having acidic group --

The monomer having an acidic group or the resin having an acidic group is preferably a resin having an acidic group and more preferably a resin having a monovalent acidic group (a carboxyl group or the like). The binder polymer in the second transparent resin layer is particularly preferably a binder polymer having a carboxyl group.

The resin which is used for the second transparent resin layer and is soluble in water-based solvents (preferably water or solvent mixtures of a lower alcohol having 1 to 3 carbon atoms and water) is not particularly limited within the scope of the gist of the present invention and can be appropriately selected from well-known resins.

The resin having an acidic group that is used for the second transparent resin layer is preferably an alkali-soluble resin. The alkali-soluble resin can be appropriately selected from alkali-soluble resins which are linear organic macromolecular polymers and have at least one group that accelerates alkali solubility (that is, an acidic group: for example, a carboxyl group, a phosphoric acidic group, a sulfonic acidic group, or the like) in a molecule (preferably a molecule having an acrylic copolymer or a styrene-based copolymer as the main chain). Among these, alkali-soluble resins which are soluble in organic solvents and can be developed using a weak alkaline aqueous solution are more preferred. The acidic group is preferably a carboxyl group.

To the manufacturing of the alkali-soluble resin, it is possible to apply, for example, a method in which a well-known radical polymerization method is used. The polymerization conditions such as temperature, pressure, the kind and amount of radical initiators, and the kind of solvents in the case of manufacturing the alkali-soluble resin using a

radical polymerization method can be easily set by those skilled in the art, and the conditions can also be experimentally determined.

The linear organic macromolecular polymer is preferably a polymer having a carboxylic acid in the side chain. Examples thereof include poly(meth)acrylic acids, methacrylic acid copolymers, acrylic acid copolymers, itaconic acid copolymers, crotonic acid copolymers, maleic acid copolymers such as styrene/maleic acid, partially-esterified maleic acid copolymers, and the like, which are respectively described in JP1984-44615A (JP-S59-44615A), JP1979-34327B (JP-S54-34327B), JP1983-12577B (JP-S58-12577B), JP1979-25957B (JP-S54-25957B), JP1984-53836A (JP-S59-53836A), JP1984-71048A (JP-S59-71048A), JP1971-2121A (JP-S46-2121A), and JP1981-40824B (JP-S56-40824B) and, furthermore, acidic cellulose derivatives having a carboxylic acid in the side chain such as carboxyalkyl cellulose and carboxyalkyl starch, polymers obtained by adding an acid anhydride to a polymer having a hydroxyl group, and the like, and, furthermore, macromolecular polymers having a reactive functional group such as a (meth)acryloyl group in the side chain are also preferred.

Among these, particularly, benzyl (meth)acrylate/(meth)acrylic acid copolymers or multicomponent copolymers made of benzyl (meth)acrylate/(meth)acrylic acid/other monomers are preferred.

Additionally, polymers obtained by copolymerizing 2-hydroxyethylmethacrylate are also useful. The amount of the polymer being mixed and used can be arbitrary.

Additionally, examples thereof include 2-hydroxypropyl (meth)acrylate/polystyrene macromonomer/benzyl methacrylate/methacrylic acid copolymers, 2-hydroxy-3-phenoxypropyl acrylate/polymethyl methacrylate macromonomer/benzyl methacrylate/methacrylic acid copolymers, 2-hydroxyethyl methacrylate/polystyrene macromonomer/methyl methacrylate/methacrylic acid copolymers, 2-hydroxyethyl methacrylate/polystyrene macromonomer/benzyl methacrylate/methacrylic acid copolymers, and the like which are described in JP1995-140654A (JP-H07-140654A).

Regarding the specific constitutional unit of the alkali-soluble resin, particularly, copolymers of (meth)acrylic acid and an additional monomer capable of being copolymerized with (meth)acrylic acid are preferred.

Examples of the additional monomer capable of being copolymerized with (meth)acrylic acid include alkyl (meth)acrylates, aryl (meth)acrylates, vinyl compounds, and the like. Here, hydrogen atoms in alkyl groups and aryl groups may be substituted with substituents.

Specific examples of alkyl (meth)acrylate and aryl (meth)acrylate include methyl (meth)acrylates, ethyl (meth)acrylates, propyl (meth)acrylates, butyl (meth)acrylates, isobutyl (meth)acrylates, pentyl (meth)acrylates, hexyl (meth)acrylates, octyl (meth)acrylates, phenyl (meth)acrylates, benzyl acrylates, tolyl acrylates, naphthyl acrylates, cyclohexyl acrylates, and the like.

In addition, examples of the vinyl compounds include styrene, $\alpha$-methyl styrene, vinyl toluene, glycidyl methacrylate, acrylonitrile, vinyl acetate, N-vinyl pyrrolidone, tetrahydrofurfuryl methacrylate, polystyrene macromonomers, polymethyl methacrylate macromonomers, $CH_2=CR^1R^2$, $CH_2=C(R^1)(COOR^3)$ [here, $R^1$ represents a hydrogen atom or an alkyl group having 1 to 5 carbon atoms, $R^2$ represents an aromatic hydrocarbon ring having 6 to 10 carbon atoms, and $R^3$ represents an alkyl group having 1 to 8 carbon atoms or an aralkyl group having 6 to 12 carbon atoms.], and the like.

The additional monomer capable of being copolymerized with (meth)acrylic acid can be used singly or a combination of two or more monomers capable of being copolymerized with (meth)acrylic acid can be used. A preferred additional monomer capable of being copolymerized with (meth)acrylic acid is at least one monomer selected from $CH_2=CR^1R^2$, $CH_2=C(R^1)(COOR^3)$, phenyl (meth)acrylates, benzyl (meth)acrylates, and styrene and particularly preferably $CH_2=CR^1R^2$ and/or $CH_2=C(R^1)(COOR^3)$.

Additionally, examples thereof include resins having an ethylenic unsaturated double bond introduced into a linear macromolecule which is obtained by reacting a (meth)acrylic compound having a reactive functional group, cinnamic acid, or the like with the linear macromolecule having a substituent capable of reacting with this reactive functional group. Examples of the reactive functional group include a hydroxyl group, a carboxyl group, an amino group, and the like, and examples of the substituent capable of being reacted with this reactive functional group include an isocyanate group, an aldehyde group, an epoxy group, and the like.

Among these, acrylic resins having an acidic group are preferred as the resin having an acidic group. Meanwhile, in the present specification, acrylic resins refer to both methacrylic resins and acrylic resins, and, similarly, (meth)acrylic resins refers to methacrylic resins and acrylic resins.

-- Monomer having acidic group --

As the monomer having an acidic group, it is possible to preferably use an acrylic monomer such as (meth)acrylic acid or a derivative thereof or the following monomer.

Examples thereof include tri- or tetrafunctional radical polymerizable monomers (monomers obtained by introducing a carboxylic acid group into a pentaerythritol tri- and tetraacrylate [PETA] skeleton (acid value=80 to 120 mg-KOH/g)), penta- or hexafunctional radical polymerizable monomers (monomers obtained by introducing a carboxylic acid group into a dipentaerythritol penta- and hexaacrylate [DPHA] skeleton (acid value=25 to 70 mg-KOH/g)), and the

like. Specific titles are not described, but difunctional alkali-soluble radical polymerizable monomers may also be used as necessary.

Additionally, it is possible to preferably use the monomers having an acidic group described in <0025> to <0030> of JP2004-239942A, the content of which is incorporated into the present invention.

Among these, acrylic monomers such as (meth)acrylic acids or derivatives thereof can be more preferably used. Meanwhile, in the present specification, acrylic monomers refer to both methacrylic monomers and acrylic monomers.

-- Other binder polymers --

Other binder polymers having no acidic group which can be used in the second transparent resin layer are not particularly limited, and it is possible to use binder polymers that can be used in organic solvent-based resin compositions that are used to form the photosensitive transparent resin layer.

- Polymerizable compound -

The second transparent resin layer preferably includes a polymerizable compound such as the photopolymerizable compound or thermopolymerizable compound since the compound increases the strength or the like of films by being cured. The resin layer more preferably includes a photopolymerizable compound other than the monomer having an acidic group.

As the polymerizable compound that is used in the second transparent resin layer, it is possible to use the polymerizable compounds described in Paragraphs 0023 and 0024 in the specification of JP4098550B. Among these, pentaerythritol tetraacrylate, pentaerythritol triacrylate, and tetraacrylates of pentaerythritol ethylene oxide (EO) adducts can be preferably used. These polymerizable compounds may be used singly or a plurality of polymerizable compounds may be used in combination. In a case in which a mixture of pentaerythritol tetraacrylate and pentaerythritol triacrylate is used, the percentage of pentaerythritol triacrylate is preferably 5% to 80% and more preferably 10% to 60% in terms of the mass ratio.

Specific examples of the photopolymerizable compound that is used in the second transparent resin layer include water-soluble polymerizable compounds represented by Structural Formula 1, pentaerythritol tetraacrylate mixtures (NK ester A-TMMT manufactured by Shin-Nakamura Chemical Co., Ltd., containing approximately 10% of triacrylate as an impurity), mixtures of pentaerythritol tetraacrylate and triacrylate (NK ester A-TMM3LM-N manufactured by Shin-Nakamura Chemical Co., Ltd., 37% triacrylate), mixtures of pentaerythritol tetraacrylate and triacrylate (NK ester A-TMM-3L manufactured by Shin-Nakamura Chemical Co., Ltd., 55% triacrylate), mixtures of pentaerythritol tetraacrylate and triacrylate (NK ester A-TMM3 manufactured by Shin-Nakamura Chemical Co., Ltd., 57% triacrylate), tetraacrylates of a pentaerythritol ethylene oxide (EO) adduct (KAYARAD RP-1040 manufactured by Nippon Kayaku Co., Ltd.), and the like.

As the photopolymerizable compound that is used in the second transparent resin layer, among these, it is possible to preferably use the water-soluble polymerizable compound represented by Structural Formula 1, a pentaerythritol tetraacrylate mixture (NK ester A-TMMT manufactured by Shin-Nakamura Chemical Co., Ltd.), a mixture of pentaerythritol tetraacrylate and triacrylate (NK ester A-TMM3LM-N manufactured by Shin-Nakamura Chemical Co., Ltd., 37% triacrylate), or a mixture of pentaerythritol tetraacrylate and triacrylate (NK ester A-TMM-3L manufactured by Shin-Nakamura Chemical Co., Ltd., 55% triacrylate) from the viewpoint of improving the reticulation of the transfer film.

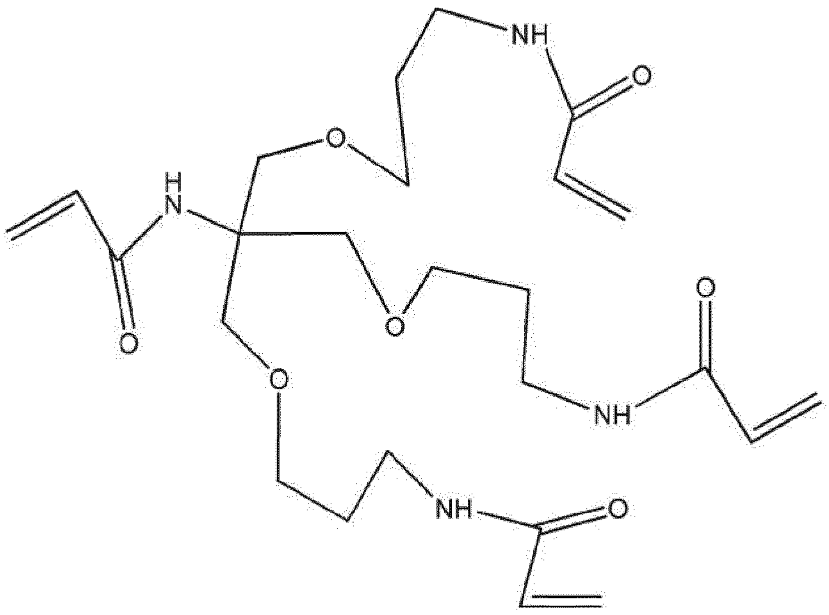

・・・Structural Formula 1

Examples of additional photopolymerizable compounds that are used in the second transparent resin layer include polymerizable compounds that are soluble in water or solvent mixtures of a lower alcohol having 1 to 3 carbon atoms and water, and it is possible to use, for example, monomers having a hydroxyl group and monomers having an ethylene oxide or polypropylene oxide and a phosphoric acid group in the molecule.

- Photopolymerization initiator -

As the photopolymerization initiator which can be used for the second transparent resin layer and is soluble in water or solvent mixtures of a lower alcohol having 1 to 3 carbon atoms and water, it is possible to use IRGACURE 2959 or initiators of Structural Formula 2.

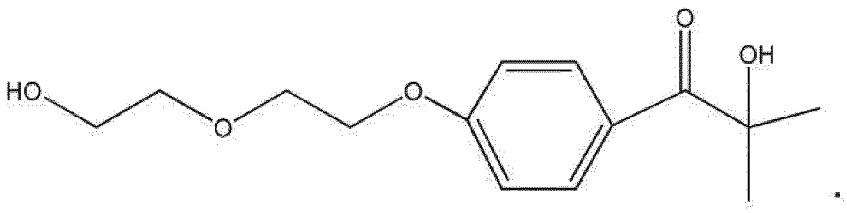

・・・Structural Formula 2

- Metal oxide particles -

The second transparent resin layer may or may not include particles (preferably metal oxide particles) for the purpose of adjusting the refractive index or the light transmittance, but preferably includes metal oxide particles from the viewpoint of controlling the refractive index of the second transparent resin layer in the above-described range. To the second transparent resin layer, it is possible to add metal oxide particles in an arbitrary ratio depending on the kind of the polymer or the polymerizable compound being used, and, in the second transparent resin layer, the content of the metal oxide particles is preferably 40% to 95% by mass, more preferably 55% to 95% by mass, still more preferably 62% to 90% by mass from the viewpoint of improving cracks in the transfer film, particularly preferably 62% to 75% by mass from the viewpoint of further improving cracks in the transfer film and improving the substrate adhesiveness of the laminate of the present invention, and more particularly preferably 62% to 70% by mass of the second transparent resin layer.

The refractive index of the metal oxide particles is preferably higher than the refractive index of a composition made of a material obtained by removing the particles from the second transparent resin layer. Specifically, in the transfer film of the present invention, the second transparent resin layer more preferably contains particles having a refractive index of 1.50 or higher, still more preferably contains particles having a refractive index of 1.55 or higher, particularly preferably contains particles having a refractive index of 1.70 or higher, and most preferably contains particles having a refractive index of 1.90 or higher with respect to light rays having wavelengths of 400 to 750 nm.

Here, the refractive index being 1.50 or higher with respect to light rays having wavelengths of 400 to 750 nm means that the average refractive index is 1.50 or higher with respect to light having wavelengths in the above-described range, and the refractive index is not necessarily 1.50 or higher with respect to all of the light rays having wavelengths in the above-described range. In addition, the average refractive index refers to a value obtained by dividing the sum of the measurement values of the refractive index of individual light rays having wavelengths in the above-described range by the number of measurement points.

In addition, only one kind of the metal oxide particles may be used or two or more kinds of the metal oxide particles can be jointly used.

In the transfer film of the present invention, the second transparent resin layer preferably has at least one of $ZrO_2$ particles, $Nb_2O_5$ particles, or $TiO_2$ particles from the viewpoint of controlling the refractive index in the range of the refractive index of the second transparent resin layer, more preferably has at least one of $ZrO_2$ particles or $Nb_2O_5$ particles.

<Thermoplastic resin layer>

In the transfer film of the present invention, it is also possible to provide a thermoplastic resin layer between the temporary support and the photosensitive transparent resin layer. In a case in which a laminate is formed by transferring the photosensitive transparent resin layer and the second transparent resin layer using a transfer material having the thermoplastic resin layer, air bubbles are not easily generated in individual elements formed by transferring the layers. As a result, image unevenness or the like is not easily caused in image display devices, and excellent display characteristics can be obtained.

The thermoplastic resin layer is preferably alkali-soluble. The thermoplastic resin layer plays a role of a cushion material so as to be capable of absorbing protrusions and recesses (also including protrusions, recesses, and the like caused by images and the like which have been previously formed) on the base surface and is preferably capable of transforming in accordance with protrusions and recesses on the subject surface.

The thermoplastic resin layer preferably includes the organic macromolecular substance described in JP1993-72724A (JP-H05-72724A) as a component and particularly preferably includes at least one substance selected from organic macromolecular substances having a softening point of approximately 80°C or lower which is obtained using the Vicat method [specifically, the polymer softening point measurement method based on ASTM D1235].

Specific examples thereof include organic macromolecules such as polyolefins such as polyethylene and polypropylene, ethylene copolymers of ethylene and vinyl acetate or a saponified substance thereof, copolymers of ethylene and an acrylic acid ester or a saponified substance thereof, vinyl chloride copolymers of polyvinyl chloride or vinyl chloride and vinyl acetate or a saponified substance thereof, polyvinylidene chloride, vinylidene chloride copolymers, polystyrene, styrene copolymers of styrene and a (meth)acrylic acid ester or a saponified substance thereof, polyvinyl toluene, vinyl toluene copolymers of vinyl toluene and a (meth)acrylic acid ester or a saponified substance thereof, poly(meth)acrylic acid esters, (meth)acrylic acid ester copolymers of butyl (meth)acrylate and vinyl acetate, polyamide resins such as vinyl acetate copolymer nylon, copolymerized nylon, N-alkoxymethylated nylon, and N-dimethylaminated nylon, and the like.

The layer thickness of the thermoplastic resin layer is preferably 3 to 30 μm. In a case in which the layer thickness of the thermoplastic resin layer is less than 3 μm, there are cases in which followability during lamination is insufficient and protrusions and recesses on the base surface cannot be fully absorbed. In addition, in a case in which the layer thickness exceeds 30 μm, there are cases in which loads are applied to drying (solvent removal) during the formation of the thermoplastic resin layer on the temporary support, time is taken for the development of the thermoplastic resin layer, and the process suitability is deteriorated. The layer thickness of the thermoplastic resin layer is more preferably 4 to 25 μm and particularly preferably 5 to 20 μm.

The thermoplastic resin layer can be formed by means of the application or the like of a prepared liquid including a thermoplastic organic macromolecule, and the prepared liquid that is used in the case of application or the like can be prepared using a solvent. The solvent is not particularly limited as long as the solvent is capable of dissolving macromolecular components constituting the thermoplastic resin layer, and examples thereof include methyl ethyl ketone, cyclohexanone, propylene glycol monomethyl ether acetate, n-propanol, 2-propanol, and the like.

(Viscosities of thermoplastic resin layer and photocurable resin layer)

It is preferable that the viscosity of the thermoplastic resin layer measured at 100°C is in a region of 1,000 to 10,000 Pa·sec and the viscosity of the photocurable resin layer measured at 100°C is in a region of 2,000 to 50,000 Pa·sec.

<Interlayer>

In the transfer film of the present invention, it is also possible to provide an interlayer between the thermoplastic resin layer and the photosensitive transparent resin layer. The interlayer is described in JP1993-72724A (JP-H05-72724A)

as "separation layer".

<Protective film>

The transfer film of the present invention is preferably further provided with a protective film (hereinafter, also referred to as the "protective peeling layer") or the like on the surface of the second transparent resin layer.
As the protective film, it is possible to appropriately use the protective film described in Paragraphs 0083 to 0087 and 0093 of JP2006-259138A.
Fig. 12 illustrates an example of a preferred constitution of the transfer film of the present invention. Fig. 12 is a schematic cross-sectional view of a transfer film 30 of the present invention in which a temporary support 26, a photosensitive transparent resin layer 7, the second transparent resin layer 12, and the protective peeling layer (protective film) 29 are laminated adjacent to each other in this order.

<Method for manufacturing transfer film>

The method for manufacturing the transfer film is not particularly limited, and well-known methods can be used.
In a case in which the transfer film further having the second transparent resin layer in addition to the photosensitive transparent resin layer on the temporary support is manufactured, the method for manufacturing the above-described transfer film preferably includes a step of forming the photosensitive transparent resin layer on the temporary support and a step of forming the second transparent resin layer directly on the photosensitive transparent resin layer. The step of forming the photosensitive transparent resin layer is preferably a step of applying an organic solvent-based resin composition onto the temporary support. The step of forming the second transparent resin layer is preferably a step of applying a water-based resin composition including an ammonium salt of a monomer having an acidic group or an ammonium salt of a resin having an acidic group. In a case in which the above-described constitution is provided, the photosensitive transparent resin layer and the second transparent resin layer are favorably differentiated from each other, and problems caused by the absorption of moisture by the second transparent resin layer formed using a water-based resin composition in a case in which the transfer film is stored at a high temperature and a high humidity can be suppressed. In a case in which the water-based resin composition including an ammonium salt of a monomer having an acidic group or an ammonium salt of a resin having an acidic group is applied onto the photosensitive transparent resin layer obtained using the organic solvent-based resin composition, even in a case in which the second transparent resin layer is formed without curing the photosensitive transparent resin layer, interlaminar mixing does not occur, and layers are favorably differentiated from each other. Furthermore, when coated film formed using the water-based resin composition including an ammonium salt of a monomer having an acidic group or an ammonium salt of a resin having an acidic group are dried, ammonia having a lower boiling point than water is likely to be volatilized from the ammonium salt of a monomer having an acidic group or the ammonium salt of a resin having an acidic group in the drying step, and thus it is possible to generate (regenerate) and provide acidic groups in the second transparent resin layer as the monomer having an acidic group or the resin having an acidic group. Therefore, in a case in which the transfer film is stored at a high temperature and a high humidity and moisture is absorbed, the monomer having an acidic group or the resin having an acidic group which constitutes the second transparent resin layer has already become insoluble in water, and thus it is possible to suppress problems caused when the transfer film absorbs moisture.

(Step of forming photosensitive transparent resin layer on temporary support)

The method for manufacturing the transfer film has a step of forming the photosensitive transparent resin layer on the temporary support, and the step of forming the photosensitive transparent resin layer is preferably a step of applying an organic solvent-based resin composition onto the temporary support.

- Organic solvent-based resin composition -

The organic solvent-based resin composition refers to a resin composition that is soluble in organic solvents.
As the organic solvents, ordinary organic solvents can be used. Examples of the organic solvents include methyl ethyl ketone, propylene glycol monomethyl ether, propylene glycol monomethyl ether acetate, cyclohexanone, methyl isobutyl ketone, ethyl lactate, methyl lactate, caprolactam, and the like.
In the method for manufacturing the transfer film, the organic solvent-based resin composition that is used to form the photosensitive transparent resin layer preferably includes a binder polymer, a photopolymerizable compound, a photopolymerization initiator, and a compound capable of reacting with acids by heating.

(Step of forming second transparent resin layer)

The method for manufacturing the transfer film has a step of forming the second transparent resin layer directly on the photosensitive transparent resin layer, and the step of forming the second transparent resin layer is preferably a step of applying a water-based resin composition including an ammonium salt of a monomer having an acidic group or an ammonium salt of a resin having an acidic group.

- Water-based resin composition -

The water-based resin composition refers to a resin composition that is soluble in water-based solvents.

The water-based solvent is preferably water or a solvent mixture of an alcohol having 1 to 3 carbon atoms and water. In a preferred aspect of the method for manufacturing the transfer film, a solvent in the water-based resin composition used to form the second transparent resin layer preferably includes water and an alcohol having 1 to 3 carbon atoms and more preferably includes water or a solvent mixture in which the content ratio of water to the alcohol having 1 to 3 carbon atoms is 90/10 to 10/90 in terms of the mass ratio. The content ratio of water to the alcohol having 1 to 3 carbon atoms is still more preferably 85/15 to 20/80 in terms of the mass ratio and particularly preferably 80/20 to 40/60.

Water, a solvent mixture of water and methanol, and a solvent mixture of water and ethanol are preferred, and a solvent mixture of water and methanol is preferred from the viewpoint of drying and coatability.

Particularly, in the case of forming the second transparent resin layer, in a case in which a solvent mixture of water and methanol is used, the mass ratio (in terms of % by mass) is preferably 90/10 to 10/90, more preferably 85/15 to 20/80, and still more preferably 80/20 to 40/60. In a case in which the amount of methanol increases and thus the mass ratio of water to methanol becomes lower than 10/90, the photosensitive transparent resin layer is dissolved or becomes white-turbide, which is not preferable.

In a case in which the content ratio is controlled to be in the above-described range, interlaminar mixing with the second transparent resin layer does not occur, and coating and rapid drying can be realized.

The power of hydrogen (pH) of the water-based resin composition at 25°C is preferably 7.0 or more and 12.0 or less, more preferably 7.0 to 10.0, and particularly preferably 7.0 to 8.5. The pH of the water-based resin composition can be adjusted to the above-described preferred range by, for example, adding the monomer having an acidic group or the resin having an acidic group to the acidic groups using an excess amount of ammonia.

In addition, in the method for manufacturing the transfer film, the water-based resin composition that is used to form the second transparent resin layer is preferably at least one of a heat-curable resin composition or a photocurable resin composition. In a case in which the photosensitive transparent resin layer and the second transparent resin layer are the above-described curable transparent resin layers, in the method for manufacturing the transfer film, even in a case in which the photosensitive transparent resin layer is laminated, and then the second transparent resin layer is laminated without curing the photosensitive transparent resin layer, the layers are favorably differentiated from each other, and thus it is possible to further improve the visibility of the transparent electrode pattern. Additionally, this constitution enables the development of the refractive index-adjusting layers (that is, the photosensitive transparent resin layer and the second transparent resin layer) in a desired pattern by means of photolithography after the refractive index-adjusting layers are transferred onto the transparent electrode pattern from the obtained transfer film.

In the method for manufacturing the transfer film, the water-based resin composition that is used to form the second transparent resin layer preferably has an ammonium salt of a monomer having an acidic group or an ammonium salt of a resin having an acidic group and includes a binder polymer, a photo- or thermopolymerizable compound, and a photo- or thermopolymerization initiator. Only the ammonium salt of a resin having an acidic group may be used as the binder polymer, or, in addition to the ammonium salt of a resin having an acidic group, other binder polymers may be further jointly used. The ammonium salt of a monomer having an acidic group may be a photo- or thermopolymerizable compound, and, in addition to the ammonium salt of a monomer having an acidic group, a photo- or thermopolymerizable compound may be further jointly used.

<Volatilization of ammonia>

Furthermore, the method for manufacturing the transfer film preferably includes a step of generating an acidic group by volatilizing ammonia from the ammonium salt of a monomer having an acidic group or the ammonium salt of a resin having an acidic group. The step of generating an acidic group by volatilizing ammonia from the ammonium salt of a monomer having an acidic group or the ammonium salt of a resin having an acidic group is preferably a step of heating the coated water-based resin composition.

Preferred ranges of the detailed conditions of the step of heating the coated water-based resin composition will be described below.

Examples of the heating and drying method include a method in which the composition is passed through a

furnace comprising a heating device and a method in which the composition is heated and dried by means of blasting. The heating and drying conditions may be appropriately set depending on organic solvents and the like being used, and the composition may be heated to a temperature of 40°C to 150°C. Among these conditions, the composition is preferably heated to a temperature of 50°C to 120°C and more preferably heated to a temperature of 60°C to 100°C. In the heated and dried composition, the moisture content is preferably set to 5% by mass or less, more preferably set to 3% by mass or less, and still more preferably set to 1% by mass or less.

<Other steps>

The method for manufacturing the transfer film may include a step of further forming a thermoplastic resin layer before the formation of the photosensitive transparent resin layer on the temporary support.

After the step of further forming the thermoplastic resin layer, a step of forming an interlayer between the thermoplastic resin layer and the photosensitive transparent resin layer may be provided. Specifically, in the case of forming a photosensitive material having the interlayer, first, a solution obtained by dissolving additives together with a thermoplastic organic macromolecule (coating fluid for the thermoplastic resin layer) is applied and dried on the temporary support so as to provide a thermoplastic resin layer. After that, a preparation liquid obtained by adding resins or additives to a solvent that does not dissolve the thermoplastic resin layer (coating fluid for the interlayer) is applied and dried on the thermoplastic resin layer so as to laminate the interlayer thereon. Subsequently, a coating fluid for a photosensitive transparent resin layer prepared using a solvent that does not dissolve the interlayer is applied and dried on this interlayer so as to laminate the photosensitive transparent resin layer, whereby the photosensitive material can be preferably produced.

As the method for manufacturing other transparent resin layers, it is possible to employ the method for producing a photosensitive transfer material described in Paragraphs 0094 to 0098 of JP2006-259138A.

[Electrode protective film for electrostatic capacitance-type input device]

An electrode protective film for an electrostatic capacitance-type input device of the present invention is the transfer film of the present invention from which the temporary support is removed.

The electrode protective film for an electrostatic capacitance-type input device of the present invention is excellent in terms of both heat and moisture resistance after the supply of saline water and development residues which are particularly important in the usages of electrostatic capacitance-type input devices.

The laminate of the present invention described below has the electrode protective film for an electrostatic capacitance-type input device of the present invention.

[Laminate]

A first aspect of the laminate of the present invention is a laminate having a substrate including an electrode of an electrostatic capacitance-type input device and a photosensitive transparent resin layer located on the substrate, in which the photosensitive transparent resin layer is formed by transferring the photosensitive transparent resin layer from the transfer film of the present invention onto the substrate.

A second aspect of the laminate of the present invention is a laminate having a substrate including an electrode of an electrostatic capacitance-type input device and a photosensitive transparent resin layer located on the substrate, in which the photosensitive transparent resin layer includes (A) the binder polymer, (B) the photopolymerizable compound having an ethylenic unsaturated group, (C) the photopolymerization initiator, and (D) the compound capable of reacting with acids by heating, and at least one of the following condition 1 or the following condition 2 is satisfied;
condition 1: (D) the compound capable of reacting with acids by heating has a hydrophilic group in a molecule; and
condition 2: the photosensitive transparent resin layer further includes (E) a compound having an ethylene oxide chain or a propylene oxide chain.

A third aspect of the laminate of the present invention is a laminate manufactured by using the method for manufacturing a laminate of the present invention described below.

Since the laminates have the above-described constitutions, the laminate of the present invention is excellent in terms of both heat and moisture resistance after the supply of saline water and development residues.

Meanwhile, films obtained by transferring the photosensitive transparent resin layer in the transfer film of the present invention onto the transparent electrode pattern and photocuring this layer are also referred to as electrode protective films. The laminate of the present invention preferably has an electrode protective film obtained by heating the photosensitive transparent resin layer on the substrate.

The electrode of the electrostatic capacitance-type input device may be a transparent electrode pattern or a guidance wire. In the laminate of the present invention, the electrode of the electrostatic capacitance-type input device

is preferably an electrode pattern and more preferably a transparent electrode pattern.

The laminate of the present invention has a substrate including an electrode of an electrostatic capacitance-type input device and a photosensitive transparent resin layer formed on the substrate, preferably has at least a substrate, a transparent electrode pattern, or a photosensitive transparent resin layer, and more preferably has a substrate, a transparent electrode pattern, a second transparent resin layer disposed adjacent to the transparent electrode pattern, and a photosensitive transparent resin layer disposed adjacent to the second transparent resin layer.

The laminate of the present invention has a substrate, a transparent electrode pattern, a second transparent resin layer disposed adjacent to the transparent electrode pattern, and a photosensitive transparent resin layer disposed adjacent to the second transparent resin layer, in which the refractive index of the second transparent resin layer is more preferably higher than the refractive index of the photosensitive transparent resin layer, and the refractive index of the second transparent resin layer is more particularly preferably 1.6 or higher. In a case in which the above-described constitution is provided, it is possible to solve problems of the transparent electrode pattern being visible, and patterning properties become favorable.

<Constitution of laminate>

The laminate of the present invention preferably further has a transparent film having a refractive index of 1.6 to 1.78 and a film thickness of 55 to 110 nm on a side of the transparent electrode pattern opposite to the side on which the second transparent resin layer is formed from the viewpoint of further improving the visibility of the transparent electrode pattern. Meanwhile, in the present specification, in the case of being simply mentioned, "transparent films" refer to the "transparent film having a refractive index of 1.6 to 1.78 and a film thickness of 55 to 110 nm".

The laminate of the present invention preferably further has a transparent substrate on a side of the transparent film having a refractive index of 1.6 to 1.78 and a film thickness of 55 to 110 nm opposite to the side on which the transparent electrode pattern is formed.

Fig. 11 illustrates an example of the constitution of the laminate of the present invention.

In Fig. 11, in laminate 13, a transparent substrate 1 and a transparent film 11 having a refractive index of 1.6 to 1.78 and a film thickness of 55 to 110 nm are provided, and, furthermore, a region 21 in which a second transparent electrode pattern 4, the second transparent resin layer 12, and the photosensitive transparent resin layer 7 are laminated in this order is provided in the plane. In addition, Fig. 11 illustrates that the laminate includes, in addition to the above-described region, a region 22 in which the transparent substrate 1, a transparent film 11 having a refractive index of 1.6 to 1.78 and a film thickness of 55 to 110 nm, the second transparent resin layer 12, and a photosensitive transparent resin layer are laminated in this order (that is, a non-patterned region 22 in which the transparent electrode pattern is not formed)).

In other words, the transparent electrode-patterned substrate includes the region 21 in which the transparent substrate 1, the transparent film 11 having a refractive index of 1.6 to 1.78 and a film thickness of 55 to 110 nm,, the second transparent electrode pattern 4, the second transparent resin layer 12, and the photosensitive transparent resin layer 7 are laminated in this order in the in-plane direction.

The in-plane direction refers to a direction that is substantially parallel to a surface parallel to the transparent substrate in the laminate. Therefore, the fact that the region in which the second transparent electrode pattern 4, the second transparent resin layer 12, and the photosensitive transparent resin layer 7 are laminated in this order is included in the in-plane direction means that the orthogonal projection of the region in which the second transparent electrode pattern 4, the second transparent resin layer 12, and the photosensitive transparent resin layer 7 are laminated in this order on the surface parallel to the transparent substrate in the laminate is present in a plane parallel to the transparent substrate in the laminate.

Here, in a case in which the laminate of the present invention is used in an electrostatic capacitance-type input device described below, there are cases in which the transparent electrode pattern is provided in two substantially orthogonal directions that are the row direction and the column direction as a first transparent electrode pattern and a second transparent electrode pattern (for example, refer to Fig. 3). For example, in the constitution of Fig. 3, the transparent electrode pattern in the laminate of the present invention may be the second transparent electrode pattern 4 or a pad portion 3a of a first transparent electrode pattern 3. In other words, in the following description of the laminate of the present invention, there are cases in which the transparent electrode pattern is representatively indicated using a reference sign "4", but the application of the transparent electrode pattern in the laminate of the present invention is not limited to the second transparent electrode pattern 4 in the electrostatic capacitance-type input device of the present invention, and the transparent electrode pattern may be used as the pad portion 3a of the first transparent electrode pattern 3.

The laminate of the present invention preferably includes a non-patterned region in which the transparent electrode pattern is not formed. In the present specification, the non-patterned region refers to a region in which the second transparent electrode pattern 4 is not formed.

Fig. 11 illustrates an aspect in which the laminate of the present invention includes the non-patterned region 22.

The laminate of the present invention preferably includes the region in which the transparent substrate, the transparent film, and the second transparent resin layer are laminated in this order in the plane at least in a part of the non-patterned region 22 in which the transparent electrode pattern is not formed.

In the laminate of the present invention, in the region in which the transparent substrate, the transparent film, and the second transparent resin layer are laminated in this order, the transparent film and the second transparent resin layer are preferably adjacent to each other.

In the other region of the non-patterned region 22, other members may be disposed in arbitrary locations within the scope of the gist of the present invention, and, for example, in a case in which the laminate of the present invention is used in the electrostatic capacitance-type input device described below, it is possible to laminate a mask layer 2, an insulating layer 5, an additional conductive element 6, and the like in Fig. 1A.

In the laminate of the present invention, the transparent substrate and the transparent film are preferably adjacent to each other.

Fig. 11 illustrates an aspect in which the transparent film 11 is adjacently laminated on the transparent substrate 1.

Within the scope of the gist of the present invention, a third transparent film may be laminated between the transparent substrate and the transparent film. For example, a third transparent film having a refractive index of 1.5 to 1.52 (not illustrated in Fig. 11) is preferably provided between the transparent substrate and the transparent film.

In the laminate of the present invention, the thickness of the transparent film is preferably 55 to 110 nm, more preferably 60 to 110 nm, and particularly preferably 70 to 90 nm.

Here, the transparent film may have a monolayer structure or a laminate structure of two or more layers. In a case in which the transparent film has a laminate structure of two or more layers, the film thickness of the transparent film refers to the total film thickness of all the layers.

In the laminate of the present invention, the transparent film and the transparent electrode pattern are preferably adjacent to each other.

Fig. 11 illustrates an aspect in which the second transparent electrode pattern 4 is adjacently laminated on a region of a part of the transparent film 11.

As illustrated in Fig. 11, the shape of the end portion of the second transparent electrode pattern 4 is not particularly limited and may be a taper shape, and, for example, the end portion may have a taper shape in which the surface on the transparent substrate side is wider than the surface on the side opposite to the transparent substrate side.

Here, when the end portion of the transparent electrode pattern has a taper shape, the angle of the end portion of the transparent electrode pattern (hereinafter, also referred to as the taper angle) is preferably 30° or less, more preferably 0.1° to 15°, and particularly preferably 0.5° to 5°.

In the present specification, the taper angle can be obtained using the following method for measuring the taper angle: a microscopic photograph of the end portion of the transparent electrode pattern is captured, the taper portion in the microscopic photograph is approximated to a triangle, and the taper angle is directly measured.

Fig. 10 illustrates an example of a case in which the end portion of the transparent electrode pattern has a taper shape. In a triangle obtained by approximating a taper portion in Fig. 10, the bottom surface is 800 nm, the height (the film thickness at the top portion substantially parallel to the bottom surface) is 40 nm, and the taper angle $\alpha$ at this time is approximately 3°. The bottom surface of the triangle obtained by approximating the taper portion is preferably 10 to 3,000 nm, more preferably 100 to 1,500 nm, and particularly preferably 300 to 1,000 nm.

Meanwhile, a preferred range of the height of the triangle obtained by approximating the taper portion is the same as the preferred range of the film thickness of the transparent electrode pattern.

The laminate of the present invention preferably includes a region in which the transparent electrode pattern and the second transparent resin layer are adjacent to each other.

Fig. 11 illustrates an aspect in which the transparent electrode pattern, the second transparent resin layer, and the photosensitive transparent resin layer are adjacent to each other in the region 21 in which the transparent electrode pattern, the second transparent resin layer, and the photosensitive transparent resin layer are laminated in this order.

In addition, in the laminate of the present invention, both of the transparent electrode pattern and the non-patterned region 22 in which the transparent electrode pattern is not formed are preferably continuously coated with the transparent film and the second transparent resin layer directly or through other layers.

Here, "being continuously coated" means that the transparent film and the second transparent resin layer are not patterned films but continuous films. That is, the transparent film and the second transparent resin layer preferably have no opening portions since the transparent electrode pattern is made to be rarely visible.

In addition, the transparent electrode pattern and the non-patterned region 22 are more preferably directly coated with the transparent film and the second transparent resin layer than coated through other layers. In a case in which the transparent electrode pattern and the non-patterned region are coated through other layers, examples of "other layers" include the insulating layer 5 included in the electrostatic capacitance-type input device of the present

invention described below, a transparent electrode pattern on the second layer in a case in which two or more transparent electrode patterns are included as in the electrostatic capacitance-type input device of the present invention described below, and the like.

Fig. 11 illustrates an aspect in which the second transparent resin layer 12 is laminated. The second transparent resin layer 12 is laminated so as to astride the region in which the second transparent electrode pattern 4 on the transparent film 11 is not laminated and the region in which the second transparent electrode pattern 4 is laminated. That is, the second transparent resin layer 12 is adjacent to the transparent film 11 and, furthermore, the second transparent resin layer 12 is adjacent to the second transparent electrode pattern 4.

In addition, in a case in which the end portion of the second transparent electrode pattern 4 has a taper shape, the second transparent resin layer 12 is preferably laminated along the taper shape (at the same slope as the taper angle).

Fig. 11 illustrates an aspect in which the photosensitive transparent resin layer 7 is laminated on the surface of the second transparent resin layer 12 on a side opposite to the surface on which the transparent electrode pattern is formed.

<Material of laminate>

(Substrate)

The laminate of the present invention has a substrate including an electrode of an electrostatic capacitance-type input device. In the substrate including an electrode of an electrostatic capacitance-type input device, the substrate and the electrode are preferably separate members.

The substrate is preferably a glass substrate or a film substrate. In addition, the substrate is preferably a transparent substrate. In the laminate of the present invention, the substrate is more preferably a transparent film substrate.

The refractive index of the substrate is particularly preferably 1.5 to 1.52.

The substrate may be constituted of a translucent substrate such as a glass substrate, and it is possible to use reinforced glass or the like represented by Coming's GORILLA glass. In addition, as the transparent substrate, it is possible to preferably use the materials used in JP2010-86684A, JP2010-152809A, and JP2010-257492A.

In a case in which a film substrate is used as the substrate, a film substrate causing no optical distortion or a film substrate having high transparency is more preferably used, specific examples of materials include transparent film substrates including polyethylene terephthalate (PET), polyethylene naphthalate, polycarbonate (PC), triacetyl cellulose (TAC), or a cycloolefine polymer (COP).

(Transparent electrode pattern)

The refractive index of the transparent electrode pattern is preferably 1.75 to 2.1.

The material of the transparent electrode pattern is not particularly limited, and well-known materials can be used. For example, it is possible to produce the transparent electrode pattern using a translucent conductive metal oxide film such as indium tin oxide (ITO) or indium zinc oxide (IZO). Examples of the above-described metal film include ITO films; metal films of Al, Zn, Cu, Fe, Ni, Cr, Mo, and the like; metal oxide films of $SiO_2$ and the like. In this case, the film thicknesses of the respective elements can be set to 10 to 200 nm. In addition, since amorphous ITO films are turned into polycrystalline ITO films by means of firing, it is also possible to reduce the electrical resistance. In addition, the first transparent electrode pattern 3, the second transparent electrode pattern 4, and the additional conductive element 6 described below can also be manufactured using a photosensitive film having a photocurable resin layer for which a conductive fiber is used. Additionally, in a case in which the first conductive pattern and the like are formed using ITO or the like, it is possible to refer to Paragraphs 0014 to 0016 in the specification of JP4506785B. Among these, the transparent electrode pattern is preferably an ITO film.

In the laminate of the present invention, the transparent electrode pattern is preferably an ITO film having a refractive index of 1.75 to 2.1.

(Photosensitive transparent resin layer and second transparent resin layer)

The preferred ranges of the photosensitive transparent resin layer and the second transparent resin layer included in the laminate of the present invention are the same as the preferred ranges of the above-described photosensitive transparent resin layer and the above-described second transparent resin layer in the transfer film of the present invention.

Among these, in the laminate of the present invention, the photosensitive transparent resin layer preferably includes a carboxylic acid anhydride since the photosensitive transparent resin layer serves as the electrode protective

film for an electrostatic capacitance-type input device which is excellent in terms of both heat and moisture resistance after the supply of saline water and development residues. In a case in which the carboxyl group-containing resin in the photosensitive transparent resin layer is thermally crosslinked by adding the blocked isocyanate thereto, an increase in the three-dimensional crosslinking density, the anhydrization and hydrophobilization of the carboxyl group in the carboxyl group-containing resin, or the like contributes to the improvement of heat and moisture resistance after the supply of saline water.

The method for adding a carboxylic acid anhydride to the photosensitive transparent resin layer is not particularly limited, but a method in which at least a part of the carboxyl group-containing acrylic resin is turned into a carboxylic acid anhydride by heating the transferred photosensitive transparent resin layer is preferred. In addition, in a case in which at least one photopolymerizable compound having an ethylenic unsaturated group contains a carboxyl group, the carboxyl group-containing acrylic resin and the photopolymerizable compound having an ethylenic unsaturated group containing a carboxyl group may form a carboxylic acid anhydride, or photopolymerizable compounds having an ethylenic unsaturated group containing a carboxyl group may form a carboxylic acid anhydride.

(Transparent film)

In the laminate of the present invention, the refractive index of the transparent film is preferably 1.6 to 1.78 and more preferably 1.65 to 1.74. Here, the transparent film may have a monolayer structure or a laminate structure of two or more layers. In a case in which the transparent film has a laminate structure of two or more layers, the refractive index of the transparent film refers to the refractive index of all the layers.

The material of the transparent film is not particularly limited as long as the above-described range of the refractive index is satisfied.

The preferred range of the material of the transparent film and the preferred range of the physical properties such as the refractive index are the same as the preferred ranges of those of the second transparent resin layer.

In the laminate of the present invention, the transparent film and the second transparent resin layer are preferably constituted of the same material from the viewpoint of optical homogeneity.

In the laminate of the present invention, the transparent film is preferably a transparent resin film.

Metal oxide particles, resins (binders), and other additives that are used in the transparent resin film are not particularly limited within the scope of the gist of the present invention, and it is possible to preferably use the resin and other additives that are used in the second transparent resin layer in the transfer film of the present invention.

In the laminate of the present invention, the transparent film may be an inorganic film. As the material that is used in the inorganic film, the materials that are used in the second transparent resin layer in the transfer film of the present invention can be preferably used.

(Third transparent film)

The refractive index of the third transparent film is preferably 1.5 to 1.55 since the refractive index is approximated to the refractive index of the transparent substrate and the visibility of the transparent electrode pattern improves and more preferably 1.5 to 1.52.

[Method for manufacturing laminate]

The method for manufacturing a laminate according to the present invention includes a step of transferring the photosensitive transparent resin layer from the transfer film of the present invention onto the substrate including the electrodes of the electrostatic capacitance-type input device.

The method for manufacturing the laminate preferably includes a step of laminating the second transparent resin layer and the photosensitive transparent resin layer of the transfer film of the present invention in this order on the transparent electrode pattern.

In a case in which the above-described constitution is provided, it is possible to collectively transfer the second transparent resin layer and the photosensitive transparent resin layer of the laminate and easily manufacture laminates having no problems of the transparent electrode pattern being visible with favorable productivity.

Meanwhile, the second transparent resin layer is formed on the transparent electrode pattern and, in the non-patterned region, on the transparent film directly or through other layers.

(Surface treatment of transparent substrate)

In addition, in order to enhance the adhesiveness of the respective layers by means of lamination in the subsequent transfer step, it is possible to carry out a surface treatment on the noncontact surface of the transparent

substrate (front plate) in advance. As the surface treatment, it is preferable to carry out a surface treatment using a silane compound (silane coupling treatment). A silane coupling agent is preferably an agent having a functional group that interacts with photosensitive resins. For example, an aqueous solution of 0.3% by mass of a silane coupling liquid ((N-β(aminoethyl)γ-aminopropyltrimethoxysilane), trade name: KBM603, manufactured by Shin-Etsu Chemical Co., Ltd.) is showered on the surface for 20 seconds, and the surface is cleaned by means of pure water showering. After that, a reaction is caused by means of heating. In the heating method, a heating tank may be used, and the reaction can also be accelerated by preliminarily heating the substrate using a laminator.

(Formation of transparent electrode pattern)

The transparent electrode pattern can be formed on the transparent substrate or the transparent film having a refractive index of 1.6 to 1.78 and a film thickness of 55 to 110 nm using the method for forming the first transparent electrode pattern 3, the second transparent electrode pattern 4, and the additional conductive element 6 or the like in the description of the electrostatic capacitance-type input device of the present invention described below or the like, and a method in which a photosensitive film is used is preferred.

(Formation of photosensitive transparent resin layer and second transparent resin layer)

Examples of the method for forming the photosensitive transparent resin layer and the second transparent resin layer includes methods having a protective film-removing step of removing the protective film from the transfer film of the present invention, a transfer step of transferring the photosensitive transparent resin layer and the second transparent resin layer in the transfer film of the present invention from which the protective film has been removed onto the transparent electrode pattern, an exposure step of exposing the photosensitive transparent resin layer and the second transparent resin layer which have been transferred onto the transparent electrode pattern, and a development step of developing the photosensitive transparent resin layer and the second transparent resin layer which have been exposed.

- Transfer step -

The transfer step is preferably a step of transferring the photosensitive transparent resin layer and the second transparent resin layer in the transfer film of the present invention from which the protective film has been removed onto the transparent electrode pattern.

In this case, a method including a step of removing the base material (temporary support) after laminating the photosensitive transparent resin layer and the second transparent resin layer in the transfer film of the present invention on the transparent electrode pattern is preferred.

The photosensitive transparent resin layer and the second transparent resin layer are transferred (attached) onto the surface of the temporary support by overlaying, pressurizing, and heating the photosensitive transparent resin layer and the second transparent resin layer on the surface of the transparent electrode pattern. For the attachment, well-known laminators such as a laminator, a vacuum laminator, and an auto-cut laminator capable of enhancing productivity can be used.

- Exposure step, development step, and other steps -

As examples of the exposure step, the development step, and other steps, it is possible to preferably use the method described in Paragraphs 0035 to 0051 of JP2006-23696A even in the present invention.

The exposure step is a step of exposing the photosensitive transparent resin layer and the second transparent resin layer which have been transferred onto the transparent electrode pattern.

Specific examples thereof include a method in which a predetermined mask is disposed above the photosensitive transparent resin layer and the second transparent resin layer which has been formed on the transparent electrode patterns and then the photosensitive transparent resin layer and the second transparent resin layer are exposed above the mask through the mask and the temporary support.

Here, as the light sources for the exposure, it is possible to appropriately select and use light sources as long as the light sources are capable of radiating light having wavelengths in a range (for example, 365 nm, 405 nm, or the like) with which the photosensitive transparent resin layer and the second transparent resin layer can be cured. Specific examples thereof include an ultrahigh-pressure mercury lamp, a high-pressure mercury lamp, a metal halide lamp, and the like. The exposure amount is, generally, approximately 5 to 200 $mJ/cm^2$ and preferably approximately 10 to 100 $mJ/cm^2$.

The development step is a step of developing the exposed photocurable resin layer.

In the present invention, the development step is a narrowly-defined development step in which the photosensitive transparent resin layer and the second transparent resin layer which have been pattern-exposed are pattern-developed using a developer.

The development can be carried out using a developer. The developer is not particularly limited, and it is possible to use well-known developers such as the developer described in JP1993-72724A (JP-H05-72724A). Furthermore, the developer is preferably a developer in which photocurable resin layers perform dissolution-type development behaviors and, for example, preferably a developer including a compound having a pKa (power of Ka; Ka is the acid dissociation constant) of 7 to 13 at a concentration of 0.05 to 5 mol/L. To the developer, a small amount of a water-miscible organic solvent may be further added. Examples of the water-miscible organic solvent include methanol, ethanol, 2-propanol, 1-propanol, butanol, diacetone alcohol, ethylene glycol monomethyl ether, ethylene glycol monoethyl ether, ethylene glycol mono-n-butyl ether, pentyl alcohol, acetone, methyl ethyl ketone, cyclohexanone, ε-caprolactone, γ-butyrolactone, dimethylformamide, dimethylacetamide, hexamethylphosphoramide, ethyl lactate, methyl lactate, ε-caprolactam, N-methyl pyrrolidone, and the like. The concentration of the organic solvent is preferably 0.1% by mass to 30% by mass.

In addition, to the developer, it is possible to further add a well-known surfactant. The concentration of the surfactant is preferably 0.01% by mass to 10% by mass.

The development method may be any one of puddle development, shower development, shower and spin development, dip development, and the like. In the case of the shower development, a developer is showered onto the photosensitive transparent resin layer and the second transparent resin layer which have been exposed, whereby it is possible to remove non-cured portions. Furthermore, in a case in which the thermoplastic resin layer or the interlayer is provided, it is preferable to shower an alkaline liquid that does not easily dissolve photocurable resin layers to be developed and remove the thermoplastic resin layer, the interlayer, and the like. In addition, after the development, it is preferable to shower a cleaning agent or the like and remove development residue by rubbing the surface with a brush or the like. The liquid temperature of the developer is preferably 20°C to 40°C, and the pH of the developer is preferably 8 to 13.

The method for manufacturing the laminate may have other steps such as a post exposure step.

Furthermore, patterning exposure or full-surface exposure may be carried out after the peeling of the base material (temporary support) or may be carried out before the peeling of the temporary support, which is followed by the peeling of the temporary support. The exposure may be exposure through a mask or digital exposure using a laser or the like.

- Heating step -

The method for manufacturing a laminate of the present invention preferably includes a step of heating the transferred photosensitive transparent resin layer and more preferably includes a step of turning at least a part of the carboxyl group-containing acrylic resin into a carboxylic acid anhydride by heating the transferred photosensitive transparent resin layer from the viewpoint of enhancing heat and moisture resistance after the supply of saline water. The transferred photosensitive transparent resin layer is preferably heated after exposure and development, that is, the step is preferably a post-baking step carried out after exposure and development. In a case in which the photosensitive transparent resin layer and the second transparent resin layer are heat-curable, particularly, a post-baking step is preferably carried out. In addition, the post-baking step is preferably carried out from the viewpoint of adjusting the resistance value of transparent electrode patterns such as ITO.

The heating temperature in the step of turning at least a part of the carboxyl group-containing acrylic resin into a carboxylic acid anhydride by heating the transferred photosensitive transparent resin layer is preferably 100°C to 160°C in a case in which a film substrate is used as the substrate and more preferably 140°C to 150°C.

(Formation of transparent film)

In a case in which the laminate of the present invention further has a transparent film having a refractive index of 1.6 to 1.78 and a film thickness of 55 to 110 nm on a side of the transparent electrode pattern opposite to the side on which the second transparent resin layer is formed, the transparent film is produced on the transparent electrode pattern directly or through other layers such as the third transparent film.

The method for forming the transparent film is not particularly limited, but the transparent film is preferably formed by means of transfer or sputtering.

Among these, the laminate of the present invention is preferably produced by transferring a transparent curable resin film having the transparent film formed on the temporary support onto the transparent substrate and more preferably produced by transferring and then curing the transparent curable resin film. Examples of the method for transferring and curing include a method in which the photosensitive film described in the section of the electrostatic capacitance-type input device of the present invention described below is used and transfer, exposure, development, and other steps are

carried out in the same manner as in the method for transferring the photosensitive transparent resin layer and the second transparent resin layer in the method for manufacturing the laminate. In this case, the refractive index of the transparent film is preferably adjusted to the above-described range by dispersing the metal oxide particles in a photocurable resin layer in the photosensitive film.

Meanwhile, in a case in which the transparent film is an inorganic film, the transparent film is preferably formed by means of sputtering. That is, in the laminate of the present invention, the transparent film is also preferably formed by means of sputtering.

As the method for sputtering, it is possible to preferably use the method used in JP2010-86684A, JP2010-152809A, and JP2010-257492A.

(Formation of third transparent film)

A method for forming the third transparent film is the same as a method for forming the transparent film having a refractive index of 1.6 to 1.78 and a film thickness of 55 to 110 nm on the transparent substrate.

The method for manufacturing the laminate preferably includes a step of curing the photosensitive transparent resin layer and the second transparent resin layer at the same time and more preferably includes a step of pattern-curing the layers at the same time. For the transfer film of the present invention, it is preferable to laminate the photosensitive transparent resin layer and then laminate the second transparent resin layer without curing the photosensitive transparent resin layer. The photosensitive transparent resin layer and the second transparent resin layer which have been transferred from the transfer film of the present invention obtained in the above-described manner can be cured at the same time. Therefore, the photosensitive transparent resin layer and the second transparent resin layer can be developed in a desired pattern by means of photolithography after being transferred onto the transparent electrode pattern from the transfer film of the present invention.

The method for manufacturing the laminate more preferably includes a step of developing and removing non-cured portions (in the case of photocuring, only non-exposed portions or only exposed portions) in the photosensitive transparent resin layer and the second transparent resin layer after the step of curing the photosensitive transparent resin layer and the second transparent resin layer at the same time.

[Electrostatic capacitance-type input device]

The electrostatic capacitance-type input device of the present invention includes the laminate of the present invention.

The electrostatic capacitance-type input device of the present invention is preferably produced by transferring the second transparent resin layer and the photosensitive transparent resin layer disposed adjacent to the second transparent resin layer onto the transparent electrode pattern in the electrostatic capacitance-type input device from the transfer film of the present invention.

The electrostatic capacitance-type input device of the present invention is preferably produced by curing the photosensitive transparent resin layer and the second transparent resin layer which have been transferred from the transfer film of the present invention at the same time and more preferably produced by pattern-curing the photosensitive transparent resin layer and the second transparent resin layer at the same time. Meanwhile, in a case in which the photosensitive transparent resin layer and the second transparent resin layer transferred from the transfer film of the present invention are cured at the same time, it is preferable not to peel the protective film from the transfer film of the present invention.

The electrostatic capacitance-type input device of the present invention is more preferably produced by developing and removing the non-cured portion of the photosensitive transparent resin layer and the second transparent resin layer which have been transferred from the transfer film of the present invention and pattern-cured at the same time. Meanwhile, it is preferable to cure the photosensitive transparent resin layer and the second transparent resin layer transferred from the transfer film of the present invention at the same time and then peel the protective film from the transfer film of the present invention before development. The electrostatic capacitance-type input device of the present invention needs to be connected to a flexible wire formed on a polyimide film at the terminal portion of a guidance wire, and is thus preferably not covered with the photosensitive transparent resin layer (and the second transparent resin layer).

The above-described aspect is illustrated in Fig. 13. Fig. 13 illustrates an electrostatic capacitance-type input device having the following constitution which includes a guidance wire (the additional conductive element 6) of the transparent electrode pattern and a terminal portion 31 of the guidance wire.

The photosensitive transparent resin layer (and the second transparent resin layer) on the terminal portion 31 of the guidance wire forms a non-cured portion (non-exposed portion) and is thus removed by means of development, whereby the terminal portion 31 of the guidance wire is exposed.

Specific exposure and development aspects are illustrated in Figs. 14 and 15. Fig. 14 illustrates a state in which

the transfer film 30 of the present invention which has the photosensitive transparent resin layer and the second transparent resin layer is laminated on the transparent electrode pattern in the electrostatic capacitance-type input device by means of lamination and is to be cured by means of exposure or the like. In a case in which photolithography is used, that is, a case in which the transfer film is cured by means of exposure, the cured portion (exposed portion) 33 of the photosensitive transparent resin layer and the second transparent resin layer having a shape illustrated in Fig. 15 can be obtained by means of pattern exposure using a mask and the development of the non-exposed portions. Specifically, in Fig. 15, an opening portion 34 corresponding to the terminal portion of the guidance wire as the non-cured portion of the photosensitive transparent resin layer and the second transparent resin layer and a cured portion (desired pattern) of the photosensitive transparent resin layer and the second transparent resin layer for preventing the terminal portion (the ejection wire portion) of the guidance wire from being covered, from which the end portion of the transfer film of the present invention having the photosensitive transparent resin layer and the second transparent resin layer which protrude outside the contour of the frame portion of the electrostatic capacitance-type input device are removed, are obtained.

Therefore, it is possible to directly connect the flexible wire produced on the polyimide film to the terminal portion 31 of the guidance wire, and thus it becomes possible to send signals from sensors to electric circuits.

The electrostatic capacitance-type input device of the present invention preferably has a laminate having the transparent electrode pattern, the second transparent resin layer disposed adjacent to the transparent electrode pattern, and the photosensitive transparent resin layer disposed adjacent to the second transparent resin layer, in which the refractive index of the second transparent resin layer is higher than the refractive index of the photosensitive transparent resin layer and the refractive index of the second transparent resin layer is 1.6 or higher.

Hereinafter, the detail of a preferred aspect of the electrostatic capacitance-type input device of the present invention will be described.

The electrostatic capacitance-type input device of the present invention has a front plate (corresponding to the transparent substrate in the laminate of the present invention) and at least the following elements (3) to (5), (7), or (8) on the noncontact surface side of the front plate and preferably has the laminate of the present invention:

(3) a plurality of first transparent electrode patterns in which a plurality of pad portions are formed so as to extend in a first direction through a connection portion;
(4) a plurality of second electrode patterns which are electrically insulated from the first transparent electrode patterns and are made of a plurality of pad portions formed so as to extend in a direction orthogonal to the above-described first direction;
(5) an insulating layer that electrically insulates the first transparent electrode pattern and the second electrode pattern;
(7) a second transparent resin layer formed so as to fully or partially cover the elements (3) to (5); and
(8) a photosensitive transparent resin layer adjacently formed so as to cover the element (7).

Here, the second transparent resin layer (7) corresponds to the second transparent resin layer in the laminate of the present invention. In addition, the photosensitive transparent resin layer (8) corresponds to the photosensitive transparent resin layer in the laminate of the present invention. Meanwhile, generally, the photosensitive transparent resin layer is preferably a so-called transparent protective layer in well-known electrostatic capacitance-type input devices.

In the electrostatic capacitance-type input device of the present invention, the second electrode pattern (4) may or may not be a transparent electrode pattern but is preferably a transparent electrode pattern.

The electrostatic capacitance-type input device of the present invention preferably further has an additional conductive element other than the first transparent electrode pattern and the second electrode pattern which is electrically connected to at least one of the first transparent electrode pattern or the second electrode pattern (6).

Here, in a case in which the second electrode pattern (4) is not a transparent electrode pattern and the additional conductive element (6) is not provided, the first transparent electrode pattern (3) corresponds to the transparent electrode pattern in the laminate of the present invention.

In a case in which the second electrode pattern (4) is a transparent electrode pattern and the additional conductive element (6) is not provided, at least one of the first transparent electrode pattern (3) or the second electrode pattern (4) corresponds to the transparent electrode pattern in the laminate of the present invention.

In a case in which the second electrode pattern (4) is not a transparent electrode pattern and the additional conductive element (6) is provided, at least one of the first transparent electrode pattern (3) or the additional conductive element (6) corresponds to the transparent electrode pattern in the laminate of the present invention.

In a case in which the second electrode pattern (4) is a transparent electrode pattern and the additional conductive element (6) is provided, at least one of the first transparent electrode pattern (3), the second electrode pattern (4), or the additional conductive element (6) corresponds to the transparent electrode pattern in the laminate of the present invention.

The electrostatic capacitance-type input device of the present invention preferably further has the transparent

film (2) between the first transparent electrode pattern (3) and the front plate, between the second electrode pattern (4) and the front plate, or between the additional conductive element (6) and the front plate. Here, the transparent film (2) preferably corresponds to the transparent film having a refractive index of 1.6 to 1.78 and a film thickness of 55 to 110 nm in the laminate of the present invention from the viewpoint of improving the visibility of the transparent electrode pattern.

The electrostatic capacitance-type input device of the present invention preferably has the mask layer (1) and/or a decorative layer as necessary. The mask layer is also provided as a black trim around a region touched by a finger, a stylus, or the like in order to prevent the guidance wire of the transparent electrode pattern from being visible from the touch side or decorate the input device. The decorative layer is provided as a trim around the region touched by a finger, a stylus, or the like in order for decoration, and, for example, a white decorative layer is preferably provided.

The mask layer (1) and/or the decorative layer are preferably provided between the transparent film (2) and the front plate, between the first transparent electrode pattern (3) and the front plate, between the second transparent electrode pattern (4) and the front plate, or between the additional conductive element (6) and the front plate. The mask layer (1) and/or the decorative layer are more preferably provided adjacent to the front plate.

Even in a case in which the electrostatic capacitance-type input device includes a variety of members described above, in a case in which the electrostatic capacitance-type input device of the present invention includes the second transparent resin layer disposed adjacent to the transparent electrode pattern and the photosensitive transparent resin layer disposed adjacent to the second transparent resin layer, it is possible to prevent the transparent electrode pattern from becoming visible and solve a problem of the visibility of the transparent electrode pattern. Furthermore, in a case in which a constitution in which the transparent electrode pattern is sandwiched using the transparent film having a refractive index of 1.6 to 1.78 and a film thickness of 55 to 110 nm and the second transparent resin layer as described above is provided, it is possible to further improve the problem of the visibility of the transparent electrode pattern.

<Constitution of electrostatic capacitance-type input device>

First, a preferred constitution of the electrostatic capacitance-type input device of the present invention will be described together with methods for manufacturing the respective members constituting the device. Fig. 1A is a cross-sectional view illustrating a preferred constitution of the electrostatic capacitance-type input device of the present invention. Fig. 1A illustrates an aspect in which an electrostatic capacitance-type input device 10 is constituted of the transparent substrate (front plate) 1, the mask layer 2, the transparent film 11 having a refractive index of 1.6 to 1.78 and a film thickness of 55 to 110 nm, the first transparent electrode pattern 3, the second transparent electrode pattern 4, the insulating layer 5, the additional conductive element 6, the second transparent resin layer 12, and the photosensitive transparent resin layer 7.

In addition, Fig. 1B which illustrates a cross-sectional view in a direction of X-Y direction in Fig. 3 described below is also, similarly, a cross-sectional view illustrating a preferred constitution of the electrostatic capacitance-type input device of the present invention. Fig. 1B illustrates an aspect in which the electrostatic capacitance-type input device 10 is constituted of the transparent substrate (the front plate) 1, the transparent film 11 having a refractive index of 1.6 to 1.78 and a film thickness of 55 to 110 nm, the first transparent electrode pattern 3, the second transparent electrode pattern 4, the second transparent resin layer 12, and the photosensitive transparent resin layer 7.

For the transparent substrate (the front plate) 1, it is possible to use the materials exemplified as the material of the transparent electrode pattern in the laminate of the present invention. In addition, in Fig. 1A, the side of the transparent substrate 1 on which the respective elements are provided will be referred to as the noncontact surface side. In the electrostatic capacitance-type input device 10 of the present invention, signals are input by touching the contact surface (the surface opposite to the noncontact surface) of the transparent substrate 1 with a finger or the like.

In addition, the mask layer 2 is provided on the noncontact surface of the transparent substrate 1. The mask layer 2 is a trim-shaped pattern around a display region formed on the noncontact surface side of a touch panel front plate and is formed in order to prevent the guidance wire and the like from being visible.

In the electrostatic capacitance-type input device 10 of the present invention, the mask layer 2 is provided so as to cover a part of the region (a region other than the input surface in Fig. 2) of the transparent substrate 1 as illustrated in Fig. 2. Furthermore, an opening portion 8 can be provided in a part of the transparent substrate 1 as illustrated in Fig. 2. In the opening portion 8, a press-type mechanical switch can be installed.

On the contact surface of the transparent substrate 1, a plurality of first transparent electrode patterns 3 in which the plurality of pad portions are formed so as to extend in the first direction through the connection portions, a plurality of second transparent electrode patterns 4 which are electrically insulated from the first transparent electrode pattern 3 and are made of a plurality of pad portions formed so as to extend in a direction orthogonal to the first direction, and the insulating layer 5 that electrically insulates the first transparent electrode pattern 3 and the second transparent electrode pattern 4. For the first transparent electrode pattern 3, the second transparent electrode pattern 4, and the additional conductive element 6 described below, the materials exemplified as the material of the transparent electrode pattern in the laminate of the present invention can be used, and ITO films are preferred.

In addition, at least one of the first transparent electrode pattern 3 or the second transparent electrode pattern 4 can be installed so as to astride both regions of the noncontact surface of the transparent substrate 1 and the surface of the mask layer 2 opposite to the transparent substrate 1. Fig. 1A illustrates a view in which the second transparent electrode pattern is installed so as to astride both regions of the noncontact surface of the transparent substrate 1 and the surface of the mask layer 2 opposite to the transparent substrate 1.

As described above, even in a case in which a photosensitive film is laminated so as to astride the mask layer which requires a certain thickness and the rear surface of the front plate, in a case in which a photosensitive film having a specific layer constitution described below is used, lamination causing no generation of foam in the boundary with the mask portion becomes possible with a simple step without using an expensive facility such as a vacuum laminator.

The first transparent electrode pattern 3 and the second transparent electrode pattern 4 will be described using Fig. 3. Fig. 3 is an explanatory view illustrating an example of the first transparent electrode pattern and the second transparent electrode pattern in the present invention. As illustrated in Fig. 3, in the first transparent electrode pattern 3, the pad portions 3a are formed so as to extend in the first direction C through the connection portion 3b. In addition, the second transparent electrode pattern 4 is electrically insulated from the first transparent electrode pattern 3 using the insulating layer 5 and is constituted of the plurality of pad portions formed so as to extend in a direction orthogonal to the first direction (a second direction D in Fig. 3). Here, in a case in which the first transparent electrode pattern 3 is formed, the pad portions 3a and the connection portions 3b may be integrally produced or it is also possible to produce the connection portions 3b alone and integrally produce (pattern) the pad portions 3a and the second transparent electrode pattern 4. In a case in which the pad portions 3a and the second transparent electrode pattern 4 are integrally produced (patterned), the respective layers are formed so that some of the connection portions 3b and some of the pad portions 3a are coupled together as illustrated in Fig. 3 and the first transparent electrode pattern 3 and the second transparent electrode pattern 4 are electrically insulated from each other using the insulating layer 5.

In addition, in Fig. 3, a region in which the first transparent electrode pattern 3, the second transparent electrode pattern 4, or the additional conductive element 6 described below are not formed corresponds to the non-patterned region 22 in the laminate of the present invention.

In Fig. 1A, the additional conductive element 6 is installed on the surface side of the mask layer 2 opposite to the transparent substrate 1. The additional conductive element 6 is electrically connected to at least one of the first transparent electrode pattern 3 or the second transparent electrode pattern 4 and is a separate element from the first transparent electrode pattern 3 and the second transparent electrode pattern 4.

Fig. 1A illustrates a view in which the additional conductive element 6 is connected to the second transparent electrode pattern 4.

In addition, in Fig. 1A, the photosensitive transparent resin layer 7 is installed so as to cover all of the respective constituent elements. The photosensitive transparent resin layer 7 may be constituted so as to cover only part of the respective constituent elements. The insulating layer 5 and the photosensitive transparent resin layer 7 may be made of the same material or different materials. As the material constituting the insulating layer 5, it is possible to preferably use the material exemplified as the material of the first or second transparent resin layer in the laminate of the present invention.

<Method for manufacturing electrostatic capacitance-type input device>

Examples of an aspect being formed in a process for manufacturing the electrostatic capacitance-type input device of the present invention include aspects of Figs. 4 to 8. Fig. 4 is a top view illustrating an example of the transparent substrate 1 in which the opening portion 8 is formed and which is made of reinforced glass. Fig. 5 is a top view illustrating an example of the front plate in which the mask layer 2 is formed. Fig. 6 is a top view illustrating an example of the front plate in which the first transparent electrode pattern 3 is formed. Fig. 7 is a top view illustrating an example of the front plate in which the first transparent electrode pattern 3 and the second transparent electrode pattern 4 are formed. Fig. 8 is a top view illustrating an example of the front plate in which the additional conductive element 6 other than the first and second transparent electrode patterns is formed. These aspects illustrate examples in which the following description is specified, and the scope of the present invention is not interpreted to be limited by these drawings.

In the method for manufacturing the electrostatic capacitance-type input device, in a case in which the second transparent resin layer 12 and the photosensitive transparent resin layer 7 are formed, the layers can be formed by transferring the second transparent resin layer and the photosensitive transparent resin layer onto the surface of the transparent substrate 1 on which the respective elements are arbitrarily formed using the transfer film of the present invention.

In the method for manufacturing the electrostatic capacitance-type input device, at least one element of the mask layer 2, the first transparent electrode pattern 3, the second transparent electrode pattern 4, the insulating layer 5, or the additional conductive element 6 are preferably formed using the photosensitive film having the temporary support and the photocurable resin layer in this order.

In a case in which the respective elements are formed using the transfer film of the present invention or the photosensitive film, even in the substrate (the front plate) having the opening portion, resist components do not leak through the opening portion, and, particularly, in the mask layer in which a light-blocking pattern needs to be formed up to immediately above the boundary line of the front plate, resist components do not protrude (leak) from the glass end, and thus the rear side of the front plate is not contaminated, and it is possible to manufacture touch panels having a reduced thickness and a reduced weight with simple steps.

In a case in which the mask layer, the insulating layer, and the conductive photocurable resin layer are used, in a case in which the permanent materials of the first transparent electrode pattern, the second transparent electrode pattern, the conductive element, and the like are formed using the photosensitive film, patterns can be obtained by laminating the photosensitive film on a base material, then, exposing the photosensitive film in a pattern shape as necessary, and removing the non-exposed portions in the case of a negative-type material or the exposed portions in the case of a positive-type material by means of a development treatment. In the development, the thermoplastic resin layer and the photocurable resin layer may be developed and removed using separate fluids or may be removed using the same fluid. Well-known development facilities such as a brush and a high-pressure jet may be combined together as necessary. After the development, post exposure and post baking may be carried out as necessary.

(Photosensitive film)

The photosensitive film other than the transfer film of the present invention which is preferably used to manufacture the electrostatic capacitance-type input device of the present invention will be described. The photosensitive film has a temporary support and a photocurable resin layer and preferably has a thermoplastic resin layer between the temporary support and the photocurable resin layer. In a case in which the mask layer and the like are formed using the photosensitive film having the thermoplastic resin layer, air bubbles are not easily generated in elements formed by transferring the photocurable resin layer. As a result, image unevenness or the like is not easily caused in image display devices, and excellent display characteristics can be obtained.

The photosensitive film may be a negative-type material or a positive-type material.

- Layers other than photocurable resin layer and production method -

As the temporary support and the thermoplastic resin layer in the photosensitive film, it is possible to respectively use the same temporary support and thermoplastic resin layer as those respectively used in the transfer film of the present invention. In addition, as the method for producing the photosensitive film, it is possible to use the same method as the method for manufacturing the transfer film.

- Photocurable resin layer -

In the photosensitive film, additives are added to the photocurable resin layer depending on the applications of the photosensitive film. That is, in a case in which the photosensitive film is used to form the mask layer, a colorant is added to the photocurable resin layer. In addition, in a case in which the photosensitive film has a conductive photocurable resin layer, a conductive fiber and the like are added to the photocurable resin layer.

In a case in which the photosensitive film is a negative-type material, the photocurable resin layer preferably includes an alkali-soluble resin, a polymerizable compound, or a polymerization initiator. Furthermore, conductive fibers, colorants, other additives, and the like are used, but the components are not limited thereto.

-- Alkali-soluble resin, polymerizable compound, polymerization initiator --

As the alkali-soluble resin, the polymerizable compound, or the polymerization initiator included in the photosensitive film, it is possible to use the same alkali-soluble resin, polymerizable compound, or polymerization initiator as those used in the transfer film of the present invention.

-- Conductive fiber (in the case of being used as conductive photocurable resin layer) --

In a case in which the photosensitive film on which the conductive photocurable resin layer is laminated is used to form the transparent electrode pattern or the additional conductive element, it is possible to use the following conductive fibers and the like in the photocurable resin layer.

The structure of the conductive fiber is not particularly limited and can be appropriately selected depending on the purposes, but is preferably any one of a solid structure and a hollow structure.

Here, there are cases in which a fiber having a solid structure will be referred to as a "wire" and a fiber having

a hollow structure will be referred to as a "tube". In addition, there are cases in which a conductive fiber having an average short-axis length of 1 nm to 1,000 nm and an average long-axis length of 1 μm to 100 μm will be referred to as a "nanowire".

In addition, there are cases in which a conductive fiber having an average short-axis length of 1 nm to 1,000 nm, an average long-axis length of 0.1 μm to 1,000 μm, and a hollow structure will be referred to as a "nanotube".

The material of the conductive fiber is not particularly limited as long as the material is conductive and can be appropriately selected depending on the purposes, but at least one of metal or carbon is preferred, and, among these, the conductive fiber is particularly preferably at least one of metal nanowires, metal nanotubes, or carbon nanotubes.

The material of the metal nanowire is not particularly limited, and, for example, at least one metal selected from the group consisting of Groups 4, 5, and 6 of the extended periodic table (The International Union of Pure and Applied Chemistry (IUPAC) 1991) is preferred, at least one metal selected from Groups 2 to 14 is more preferred, at least one metal selected from Groups 2, 8, 9, 10, 11, 12, 13, and 14 is still more preferred, and materials including the above-described metal as a main component are particularly preferred.

Examples of the metal include copper, silver, gold, platinum, palladium, nickel, tin, cobalt, rhodium, iridium, iron, ruthenium, osmium, manganese, molybdenum, tungsten, niobium, tantalum, titanium, bismuth, antimony, lead, alloys thereof, and the like. Among these, metals mainly containing silver or metals containing an alloy of silver and a metal other than silver are preferred from the viewpoint of the excellent conductivity.

The "metals mainly containing silver" means that the content of silver in the metal nanowire is 50% by mass or more and preferably 90% by mass or more.

Examples of metals used to form the alloys with silver include platinum, osmium, palladium, iridium, and the like. These metals may be used singly or two or more metals may be jointly used.

The shape of the metal nanowire is not particularly limited, can be appropriately selected depending on the purposes. For example, the shape may be an arbitrary shape such as a cylindrical shape, a cubic shape, or a column shape having a polygonal cross-section. In applications in which high transparency is required, a cylindrical shape or a cross-sectional shape in which the corners of the polygonal shape of the cross-section are rounded is preferred.

The cross-sectional shape of the metal nanowire can be investigated by applying a water dispersion liquid of the metal nanowire onto the base material and observing the cross-section using a transmission electron microscope (TEM).

The corner of the cross-section of the metal nanowire refers to a peripheral portion of a point at which a line extended from a side of the cross-section and a perpendicular line drawn from an adjacent side intersect each other. In addition, "a side of the cross-section" refers to a straight line connecting adjacent corners. In this case, the ratio of the "outer circumferential length of the cross-section" to the total length of "the respective sides of the cross-section" is considered as the degree of sharpness. For example, in the cross-section of a metal nanowire as illustrated in Fig. 9, the degree of sharpness can be represented by the ratio of the outer circumferential length of the cross-section indicated using a solid line to the outer circumferential length of a pentagon indicated using a dotted line. A cross-sectional shape having a degree of sharpness of 75% or less is defined as a cross-sectional shape with round corners. The degree of sharpness is preferably 60% or less and more preferably 50% or less. In a case in which the degree of sharpness exceeds 75%, electrons are locally present in the corners, and plasmon absorption increases, which may cause the remaining of a yellow tint and the consequent deterioration of the transparency. In addition, there are cases in which the linearity of edge portions of a pattern degrades and rattling is caused. The lower limit of the degree of sharpness is preferably 30% and more preferably 40%.

The average short-axis length (in some case, referred to as "average short-axis diameter" or "average diameter") of the metal nanowire is preferably 150 nm or less, more preferably 1 nm to 40 nm, still more preferably 10 nm to 40 nm, and particularly preferably 15 nm to 35 nm.

In a case in which the average short-axis length is less than 1 nm, oxidation resistance deteriorates, and there are cases in which durability deteriorates, and, in a case in which the average short-axis length exceeds 150 nm, the metal nanowire causes scattering, and there are cases in which sufficient transparency cannot be obtained.

The average short-axis length of the metal nanowire is obtained by observing 300 metal nanowires using a transmission electron microscope (TEM; manufactured by JEOL Ltd.; JEM-2000FX) and calculating the average short-axis length of the metal nanowire from the average value.

Meanwhile, in a case in which the short axis of the metal nanowire is not round, the shortest axis is considered as the short-axis length.

The average long-axis length (in some cases, referred to as "average length") of the metal nanowire is preferably 1 μm to 40 μm, more preferably 3 μm to 35 μm, and still more preferably 5 μm to 30 μm.

In a case in which the average long-axis length is shorter than 1 μm, it is difficult to form dense networks, and there are cases in which sufficient conductivity cannot be obtained. In a case in which the average long-axis length exceeds 40 μm, the metal nanowires are too long and are thus tangled during manufacturing, and there are cases in which aggregates are generated in the manufacturing process.

The average long-axis length of the metal nanowire is obtained by, for example, observing 300 metal nanowires using a transmission electron microscope (TEM; manufactured by JEOL Ltd.; JEM-2000FX) and calculating the average long-axis length of the metal nanowire from the average value. Meanwhile, in a case in which the metal nanowire is bent, a circle including the bending of the metal nanowire as an arc is considered, and the value computed from the radius and curvature thereof is used as the long-axis length.
The layer thickness of the conductive photocurable resin layer is preferably 0.1 to 20 μm, more preferably 0.5 to 18 μm, and particularly preferably 1 to 15 μm from the viewpoint of the stability of coating fluids, drying during coating, and the development time during patterning.
The content of the conductive fiber in the total solid contents of the conductive photocurable resin layer is preferably 0.01% to 50% by mass, more preferably 0.05% to 30% by mass, and particularly preferably 0.1% to 20% by mass from the viewpoint of the conductivity and the stability of coating fluids.

-- Colorant (in the case of being used as mask layer) --

In a case in which the photosensitive film is used as the mask layer, it is possible to use a colorant in the photocurable resin layer. As the colorant that is used in the present invention, it is possible to preferably use well-known colorants (organic pigments, inorganic pigments, dyes, and the like). Furthermore, in the present invention, in addition to black colorants, mixtures of red pigments, blue pigments, green pigments, and the like can be used.
In a case in which the photocurable resin layer is used as a black mask layer, a black colorant is preferably included from the viewpoint of the optical density. Examples of the black colorant include carbon black, titanium carbon, iron oxide, titanium oxide, graphite, and the like, and, among these, carbon black is preferred.
In a case in which the photocurable resin layer is used as a white mask layer, it is possible to use the white pigments described in Paragraph 0015 or 0114 of JP2005-7765A. In order to use the photocurable resin layer as mask layers having other colors, the pigments or dyes described in Paragraphs 0183 to 0185 in the specification of JP4546276B may be mixed into the photocurable resin layer. In addition, it is possible to preferably use the pigments and dyes described in Paragraphs 0038 to 0054 of JP2005-17716A, the pigments described in Paragraphs 0068 to 0072 of JP2004-361447A, the colorants described in Paragraphs 0080 to 0088 of JP2005-17521A, and the like.
The colorant (preferably a pigment and more preferably carbon black) is desirably used as a dispersion liquid. This dispersion liquid can be prepared by adding a composition obtained by mixing the colorant and a pigment dispersant in advance to an organic solvent described below (or a vehicle) and dispersing the composition in the organic solvent. The vehicle refers to a portion of a medium in which a pigment is dispersed when paint is in a liquid state and includes a liquid component (a binder) which is a liquid phase and bonded with the pigment so as to form coated films and a component that dissolves and dilutes the above-described component (an organic solvent).
The disperser used in the case of dispersing the pigment is not particularly limited, and examples thereof include well-known dispersers such as kneaders, roll mills, attritors, super mills, dissolvers, homogenizers, sand mills, and beads mills which are described in p 438 of "Pigment Dictionary", Kunizou Asakura, 1st edition, Asakura Publishing Co., Ltd., 2000.
Furthermore, the pigment may be finely ground using a friction force by means of the mechanical grinding described in p. 310 of the same publication.
The colorant is preferably a colorant having a number-average particle diameter of 0.001 μm to 0.1 μm and more preferably a colorant of 0.01 μm to 0.08 μm from the viewpoint of the dispersion stability. The "particle diameter" mentioned herein refers to the diameter of a circle having the same area as the particle in an electron micrograph, and the "number-average particle diameter" refers to the average value of 100 particle diameters arbitrarily selected from the particle diameters of a number of particles.
The layer thickness of the photocurable resin layer including the colorant is preferably 0.5 to 10 μm, more preferably 0.8 to 5 μm, and particularly preferably 1 to 3 μm from the viewpoint of the difference in thickness from other layers. The content ratio of the colorant in the solid content of the colored photosensitive resin composition is not particularly limited, but is preferably 15% to 70% by mass, more preferably 20% to 60% by mass, and still more preferably 25% to 50% by mass from the viewpoint of sufficiently shortening the development time.
The total solid content mentioned in the present specification refers to the total mass of nonvolatile components excluding the solvent and the like from the colored photosensitive resin composition.
In a case in which the insulating layer is formed using the photosensitive film, the layer thickness of the photocurable resin layer is preferably 0.1 to 5 μm, more preferably 0.3 to 3 μm, and particularly preferably 0.5 to 2 μm from the viewpoint of maintaining the insulating property.

-- Other additives --

Furthermore, in the photocurable resin layer, other additives may be used. As the additives, it is possible to

use the same additives as those used in the transfer film of the present invention.

In addition, as the solvent used in the case of manufacturing the photosensitive film by means of coating, it is possible to use the same solvent as that used in the transfer film of the present invention.

Hitherto, a case in which the photosensitive film is a negative-type material has been mainly described, but the photosensitive film may be a positive-type material. In a case in which the photosensitive film is a positive-type material, for example, the material and the like described in JP2005-221726A are used in the photocurable resin layer, but the components are not limited thereto.

(Formation of mask layer and insulating layer using photosensitive film)

The mask layer 2 and the insulating layer 5 can be formed by transferring the photocurable resin layer to the transparent substrate 1 or the like using the photosensitive film. For example, in a case in which a black mask layer 2 is formed, the black mask layer can be formed by transferring the black photocurable resin layer onto the surface of the transparent substrate 1 using the photosensitive film having the black photocurable resin layer as the photocurable resin layer. In a case in which the insulating layer 5 is formed, the insulating layer can be formed by transferring the photocurable resin layer onto the surface of the transparent substrate 1 in which the first transparent electrode pattern has been formed using the photosensitive film having an insulating photocurable resin layer as the photocurable resin layer.

Furthermore, in a case in which the photosensitive film having a specific layer constitution in which the thermoplastic resin layer is provided between the photocurable resin layer and the temporary support is used to form the mask layer 2 in which a light-blocking property is required, it is possible to prevent the generation of air bubbles during the lamination of the photosensitive film and form a high-quality mask layer 2 or the like from which light does not leak.

(Formation of first and second transparent electrode patterns and additional conductive elements using photosensitive film)

The first transparent electrode pattern 3, the second transparent electrode pattern 4, and the additional conductive element 6 can be formed by an etching treatment, using the photosensitive film having the conductive photocurable resin layer, or using the photosensitive film as a liftoff material.

- Etching treatment -

In a case in which the first transparent electrode pattern 3, the second transparent electrode pattern 4, and the additional conductive element 6 are formed by an etching treatment, first, a transparent electrode layer such as ITO is formed on the noncontact surface of the transparent substrate 1 on which the mask layer 2 and the like have been formed by means of sputtering. Next, an etching pattern is formed on the transparent electrode layer by means of exposure and development using the photosensitive film having a photocurable resin layer for etching as the photocurable resin layer. After that, the transparent electrode is patterned by etching the transparent electrode layer, and the etching pattern is removed, whereby the first transparent electrode pattern 3 or the like can be formed.

Even in a case in which the photosensitive film is used as an etching resist (etching pattern), resist patterns can be obtained in the same manner as in the above-described method. As the etching, it is possible to apply etching and resist peeling using the well-known method described in Paragraphs 0048 to 0054 of JP2010-152155A.

Examples of the method for etching include ordinarily-performed wet-etching methods in which subjects are immersed in etching fluids. As the etching fluid used for wet-etching, an acidic-type etching fluid or an alkali-type etching fluid may be appropriately selected depending on etching subjects. Examples of the acidic-type etching fluid include aqueous solutions of a single acidic component such as hydrochloric acid, sulfuric acid, hydrofluoric acid, or phosphoric acid, mixed aqueous solutions of an acidic component and a salt such as iron (III) chloride, ammonium fluoride, or potassium permanganate, and the like. As the acidic component, a component obtained by combining a plurality of acidic components may be used. In addition, examples of the alkali-type etching fluid include aqueous solution of a single alkali component such as a salt of an organic amine such as sodium hydroxide, potassium hydroxide, ammonia, an organic amine, or tetramethyl ammonium hydroxide, mixed aqueous solutions of an alkali component and a salt such as potassium permanganate, and the like. As the alkali component, a component obtained by combining a plurality of alkali components may be used.

The temperature of the etching fluid is not particularly limited, but is preferably 45°C or lower. In the present invention, a resin pattern that is used as an etching mask (etching pattern) is formed using the above-described photocurable resin layer and thus exhibit particularly excellent resistance to acidic and alkaline etching fluids in the above-described temperature range. Therefore, the peeling of the resin pattern during the etching step is prevented, and portions free of the resin pattern are selectively etched.

After the etching, a washing step and a drying step may be carried out as necessary in order to prevent line

contamination. In the washing step, for example, the temporary support is washed for 10 to 300 seconds with pure water at normal temperature, and the drying step may be carried out by appropriately adjusting the air blow pressure (approximately 0.1 to 5 kg/cm$^2$) using an air blow.

Next, the method for peeling the resin pattern is not particularly limited, and examples thereof include a method in which the temporary support is immersed in a peeling fluid under stirring for 5 to 30 minutes at 30°C to 80°C and preferably at 50°C to 80°C. The resin pattern that is used as the etching mask in the present invention exhibits excellent chemical resistance at 45°C or lower as described above, but exhibits a property of being swollen by alkaline peeling fluids in a case in which the chemical temperature reaches 50°C or higher. Due to the above-described properties, in a case in which the peeling step is carried out using a peeling fluid of 50°C to 80°C, there is an advantage that the step time is shortened and the amount of the peeling residue of the resin pattern decreases. That is, in a case in which a difference is caused in the chemical temperature between the etching step and the peeling step, the resin pattern that is used as the etching mask in the present invention exhibits favorable chemical resistance in the etching step and also exhibits a favorable peeling property in the peeling step, and thus both conflicting characteristics such as the chemical resistance and the peeling property can be satisfied.

Examples of the peeling fluid include peeling fluids obtained by dissolving an inorganic alkali component such as sodium hydroxide or potassium hydroxide or an organic alkali component such as a tertiary amine or a quaternary ammonium salt in water, dimethyl sulfoxide, N-methyl pyrrolidone, or a mixed solution thereof. The resin pattern may be peeled using the above-described peeling fluid and a spray method, a shower method, a puddle method, or the like.

- Photosensitive film having conductive photocurable resin layer -

In a case in which the first transparent electrode pattern 3, the second transparent electrode pattern 4, and the additional conductive element 6 are formed using the photosensitive film having a conductive photocurable resin layer, the first transparent electrode pattern, the second transparent electrode pattern, and the additional conductive element can be formed by transferring the conductive photocurable resin layer to the surface of the transparent substrate 1.

In a case in which the first transparent electrode pattern 3 and the like are formed using the photosensitive film having a conductive photocurable resin layer, even in the substrate (the front plate) having an opening portion, resist components do not leak through the opening portion, the rear side of the substrate is not contaminated, and it becomes possible to manufacture touch panels having advantages of thickness reduction and weight reduction with simple steps.

Furthermore, in a case in which the photosensitive film having a specific layer constitution in which the thermoplastic resin layer is provided between the conductive photocurable resin layer and the temporary support is used to form the first transparent electrode pattern 3 and the like, it is possible to prevent the generation of air bubbles during the lamination of the photosensitive film and form the first transparent electrode pattern 3, the second transparent electrode pattern 4, and the additional conductive element 6 which have excellent conductivity and small resistance.

- Use of photosensitive film as liftoff material -

In addition, it is also possible to form the first transparent electrode pattern, the second transparent electrode pattern, and other conductive elements using the photosensitive film as a liftoff material.

In this case, desired transparent conductive layer patterns can be obtained by carrying out patterning using the photosensitive film, then, forming the transparent conductive layer on the entire surface of the temporary support, and then dissolving and removing the photocurable resin layer from each of the accumulated transparent conductive layers (a liftoff method).

<Image display device>

To the electrostatic capacitance-type input device of the present invention and image display devices comprising this electrostatic capacitance-type input device as a constituent element, it is possible to apply the constitution disclosed by "Advanced touch panel technology" (published by Techno Times Co., Ltd. on July 6, 2009), "Technology and development of touch panels" edited by Yuji Mitani, CMC Publishing Co., Ltd. (December 2004), FPD International 2009 Forum T-11 lecture textbook, Cypress Semiconductor Corporation application note AN2292, and the like.

Examples

Hereinafter, the present invention will be more specifically described using examples. Materials, amounts used, ratios, processing contents, processing orders, and the like described in the following examples can be appropriately modified within the scope of the gist of the present invention. Therefore, the scope of the present invention is not limited to specific examples described below. Meanwhile, unless particularly otherwise described, "parts" are mass-based.

[Examples 1 to 20 and Comparative Examples 1 to 5]

[1. Preparation of coating fluids]

<Preparation of coating fluids for photosensitive transparent resin layer>

Materials A-1 to A-20 which were coating fluids for a photosensitive transparent resin layer were prepared so as to obtain compositions shown in Table 1 and Table 2.

[Table 1]

| | | Viscosity Ps·s (25°C) | Material A-1 | Material A-2 | Material A-3 | Material A-4 | Material A-5 | Material A-6 | MaterialA-7 | Material A-8 | Material A-9 | Material A-10 |
|---|---|---|---|---|---|---|---|---|---|---|---|---|
| Binder polymer | Compound G (acid value: 95 mgKOH/g) | - | 430.5 | 430.5 | 430.5 | 430.5 | 430.5 | 430.5 | | | 430.5 | 430.5 |
| | Compound H (acid value: 65 mgKOH/g) | - | | | | | | | 430.5 | | | |
| | Compound I (acid value: 120 mgKOH/g) | - | | | | | | | | 430.5 | | |
| Photopolymerizable compound | Tricyclodecane dimethanol diacrylate (A-DCP, manufactured by Shin-Nakamura Chemical Co., Ltd.) | - | 56.26 | 56.26 | 56.26 | 56.26 | 56.26 | | 56.26 | 56.26 | 65.64 | 84.39 |
| | Carboxylic acid-containing monomer ARONIX TO-2349 | - | 9.38 | 9.38 | 9.38 | 9.38 | 9.38 | 9.38 | 9.38 | 9.38 | | 9.38 |
| | Urethane acrylate 8UX-015A (manufactured by Taisei Fine Chemical Co., Ltd.) | - | 28.13 | 28.13 | 28.13 | 28.13 | 28.13 | 28.13 | 28.13 | 28.13 | 28.13 | |
| | Dipentaerythritol hexaacrylate (A-DPH manufactured by Shin-Nakamura Chemical Co., Ltd.) | - | | | | | | 56.26 | | | | |

(continued)

| | | Viscosity Ps·s (25°C) | Material A-1 | Material A-2 | Material A-3 | Material A-4 | Material A-5 | Material A-6 | MaterialA-7 | Material A-8 | Material A-9 | Material A-10 |
|---|---|---|---|---|---|---|---|---|---|---|---|---|
| Photopolymerizatio n initiator | Ethanone, 1-[9-ethyl-6-(2-methylbenzoyl)-9H-carbazole-3-yl]-, 1-(O-acetyloxime) (trade name: OXE-02, manufactured by BASF) | - | 1.08 | 1.08 | 1.08 | 1.08 | 1.08 | 1.08 | 1.08 | 1.08 | 1.08 | 1.08 |
| | 2-Methyl-1-(4-methyl thiophenyl)-2-morpholino-propan-1-one (trade name: Irgacure 907, manufactured by BASF) | - | 2.15 | 2.15 | 2.15 | 2.15 | 2.15 | 2.15 | 2.15 | 2.15 | 2.15 | 2.15 |

(continued)

| | | Viscosity Ps·s (25°C) | Material A-1 | Material A-2 | Material A-3 | Material A-4 | Material A-5 | Material A-6 | MaterialA-7 | Material A-8 | Material A-9 | Material A-10 |
|---|---|---|---|---|---|---|---|---|---|---|---|---|
| Blocked isocyanate | Compound A (having hydrophilic group) | 30 | 181.3 | 181.3 | | | | 181.3 | 181.3 | 181.3 | 181.3 | 181.3 |
| | Compound B (having hydrophilic group) | 35 | | | 181.3 | | | | | | | |
| | Compound C (having hydrophilic group) | 40 | | | | 181.3 | | | | | | |
| | Compound D (having hydrophilic group) | 20 | | | | | 181.3 | | | | | |
| | Compound E (having no hydrophilic groups) | 30 | | | | | | | | | | |
| | Compound F (having no hydrophilic groups) | 30 | | | | | | | | | | |
| Epoxy compound | EPOX-MK R151 (manufactured by Printec Corporation) | 40 | | | | | | | | | | |
| Compound having EO/PO chains | EMULGEN B-66 (manufactured by Kao Corporation) | - | | | | | | | | | | |
| | EMULGEN A-90 (manufactured by Kao Corporation) | - | | | | | | | | | | |

(continued)

| | | Viscosity Ps·s (25°C) | Material A-1 | Material A-2 | Material A-3 | Material A-4 | Material A-5 | Material A-6 | MaterialA-7 | Material A-8 | Material A-9 | Material A-10 |
|---|---|---|---|---|---|---|---|---|---|---|---|---|
| Additives | MEGAFACE F780 (manufactured by DIC Corporation) | - | | 1.56 | | | | | | | | |
| | MEGAFACE F551 (manufactured by DIC Corporation) | - | 1.56 | | 1.56 | 1.56 | 1.56 | 1.56 | 1.56 | 1.56 | 1.56 | 1.56 |
| Solvent | Methyl ethyl ketone | - | 289.7 | 289.7 | 289.7 | 289.7 | 289.7 | 289.7 | 289.7 | 289.7 | 289.7 | 289.7 |
| Total | | | 1000 | 1000 | 1000 | 1000 | 1000 | 1000 | 1000 | 1000 | 1000 | 1000 |

[Table 2]

| | | Viscosity Ps·s (25°C) | Material A-11 | Material A-12 | Material A-13 | Material A-14 | Material A-15 | Material A-16 | Material A-17 | Material A-18 | Material A-19 | Material A-20 |
|---|---|---|---|---|---|---|---|---|---|---|---|---|
| Binder polymer | Compound G (acid value: 95 mgKOH/g) | - | 467.5 | 430.5 | 430.5 | 430.5 | 430.5 | 492.1 | 430.5 | 430.5 | 467.5 | 430.5 |
| | Compound H (acid value: 65 mgKOH/g) | - | | | | | | | | | | |
| | Compound I (acid value: 120 mgKOH/g) | - | | | | | | | | | | |
| Photopolymerizable compound | Tricyclodecane dimethanol diacrylate (A-DCP, manufactured by Shin-Nakamura Chemical Co., Ltd.) | - | 61.09 | 56.26 | 56.26 | 56.26 | 56.26 | 64.31 | 56.26 | 56.26 | 61.09 | 56.26 |
| | Carboxylic acid-containing monomer ARONIX TO-2349 | - | 10.18 | 9.38 | 9.38 | 9.38 | 9.38 | 10.72 | 9.38 | 9.38 | 10.18 | 9.38 |
| | Urethane acrylate 8UX-015A (manufactured by Taisei Fine Chemical Co., Ltd.) | - | 30.55 | 28.13 | 28.13 | 28.13 | 28.13 | 32.16 | 28.13 | 28.13 | 30.55 | 28.13 |
| | Dipentaerythritol hexaacrylate (A-DPH manufactured by Shin-Nakamura Chemical Co., Ltd.) | | | | | | | | | | | |

(continued)

| | | Viscosity Ps·s (25°C) | Material A-11 | Material A-12 | Material A-13 | Material A-14 | Material A-15 | Material A-16 | Material A-17 | Material A-18 | Material A-19 | Material A-20 |
|---|---|---|---|---|---|---|---|---|---|---|---|---|
| Photopolymerization initiator | Ethanone, 1-[9-ethyl-6-(2-methylbenzoyl)-9H-carbazole-3-yl]-, 1-(O-acetyloxime) (trade name: OXE-02, manufactured by BASF) | - | 1.17 | 1.08 | 1.08 | 1.08 | 1.08 | 1.23 | 1.08 | 1.08 | 1.17 | 1.08 |
| | 2-Methyl-1-(4-methyl thiophenyl)-2-morpholino-propan-1-one (trade name: Irgacure 907, manufactured by BASF) | - | 2.34 | 2.15 | 2.15 | 2.15 | 2.15 | 2.46 | 2.15 | 2.15 | 2.34 | 2.15 |

(continued)

| | | Viscosity Ps·s (25°C) | Material A-11 | Material A-12 | Material A-13 | Material A-14 | Material A-15 | Material A-16 | Material A-17 | Material A-18 | Material A-19 | Material A-20 |
|---|---|---|---|---|---|---|---|---|---|---|---|---|
| Blocked isocyanate | Compound A (having hydrophilic group) | 30 | 72.5 | | | | | | | | | |
| | Compound B (having hydrophilic group) | 35 | | | | | | | | | | |
| | Compound C (having hydrophilic group) | 40 | | | | | | | | | | |
| | Compound D (having hydrophilic group) | 20 | | | | | | | | | | |
| | Compound E (having no hydrophilic groups) | 30 | | 181.3 | 181.3 | 181.3 | | | 181.3 | | 72.5 | |
| | Compound F (having no hydrophilic groups) | 30 | | | | | | | | 181.3 | | |
| Epoxy compound | EPOX-MK R151 (manufactured by Printec Corporation) | 40 | | | | | 36.25 | | | | | 36.25 |
| Compound having EO/PO chains | EMULGEN B-66 (manufactured by Kao Corporation) | - | | 8.7 | 2.9 | | 8.7 | | | | | |
| | EMULGEN A-90 (manufactured by Kao Corporation) | - | | | | 8.7 | | | | | | |

(continued)

| | | Viscosity Ps·s (25°C) | Material A-11 | Material A-12 | Material A-13 | Material A-14 | Material A-15 | Material A-16 | Material A-17 | Material A-18 | Material A-19 | Material A-20 |
|---|---|---|---|---|---|---|---|---|---|---|---|---|
| Additives | MEGAFACE F780 (manufactured by DIC Corporation) | - | | | | | | | | | | |
| | MEGAFACE F551 (manufactured by DIC Corporation) | - | 1.56 | 1.56 | 1.56 | 1.56 | 1.56 | 1.56 | 1.56 | 1.56 | 1.56 | 1.56 |
| Solvent | Methyl ethyl ketone | - | 353.1 | 281.0 | 286.8 | 281.0 | 427.0 | 395.4 | 289.7 | 289.7 | 353.1 | 434.7 |
| Total | | | 1000 | 1000 | 1000 | 1000 | 1001 | 1000 | 1000 | 1000 | 1000 | 1000 |

The compounds used as the materials A-1 to A-20 will be described in detail below.

<Preparation of blocked isocyanates>

Compound A was synthesized using a method in Synthesis Example 1.

- Synthesis Example 1 -

A nitrogen atmosphere was formed in a four-neck flask equipped with a stirrer, a thermometer, a reflux cooling pipe, a nitrogen blowing pipe, and a dripping funnel. Next, hexamethylene diisocyanate (HDI) (600 parts) was prepared in the flask, and the temperature in a reactor was held at 70°C while stirring hexamethylene diisocyanate. Next, tetramethylammoniumcaprylate was added thereto as an isocyanuration catalyst, and phosphoric acid was added thereto when the yield reached 40%, thereby stopping the reaction. The reaction liquid was filtered, and then unreacted HDI was removed using a thin film evaporator, thereby obtaining a polyisocyanate. In a state in which the solvent of the obtained polyisocyanate was extracted, the viscosity at 25°C was 30,000 mPa·s, the concentration of isocyanate groups was 23.0%, the number-average molecular weight was 670, the average number of isocyanate groups was 3.3, and the concentration of the unreacted HDI was 0.2% by mass. The method for measuring the viscosity at 25°C of the polyisocyanate will be described below.

The obtained polyisocyanate (100 parts) and dipropylene glycol monomethyl ether (50 parts) were prepared in a nitrogen atmosphere using the same apparatus as described above and were mixed together at 50°C so as to produce a homogeneous solution. After that, methoxypolyethylene glycol (number-average molecular weight: 680, resin-equivalent hydroxyl value: 82 mgKOH/g) (52.7 parts) was added thereto, and the solution was heated to 120°C and held for two hours. After that, the reaction liquid was cooled to 70°C, and then methyl ethyl ketoxime (40.2 parts) was added thereto. After one hour, the fact that there was no absorption of isocyanate groups was confirmed by measuring the infrared spectrum of the reaction liquid, thereby obtaining a solution including Compound A which was an aqueous blocked isocyanate having a hydrophilic group in the molecule. The concentration of resin components in this solution was 20% by mass.

Blocked isocyanates of Compound B, Compound C, and Compound D which were blocked isocyanates having a hydrophilic group in the molecule and Compound E and Compound F which were blocked isocyanates having no hydrophilic groups in the molecule were obtained by carrying out the same operation as in Synthesis Example 1 except for the fact that the composition and the synthesis solvent shown in Table 3 were changed.

- Measurement of initial Tg's of blocked isocyanates -

A solution including the blocked isocyanate was applied onto a copper plate using an applicator so as to obtain a 30 μm-thick resin thin film, and the thin film was held at 60°C for two hours. The endothermic peak of the layer obtained by coating was measured using a REIBAIBURON (trade name) manufactured by A&D Company, Limited with a pendulum-type RPT-3000W, an edge of knife edge RBE-160, and a temperature-increase speed of 10°C/min. The temperature at which the integral area from the low temperature side of the measured endothermic peak reached 1% was considered as the initial Tg.

The initial Tg of Compound A was measured and found to be -20°C to 0°C. The initial Tg's of the blocked isocyanates used in the respective examples and comparative examples were also measured using the same method. The obtained results are shown in Table 3.

- Measurement of dissociation temperatures of blocked isocyanates -

The dissociation temperatures of the blocked isocyanates used in the respective examples and comparative examples were the temperature of an endothermic peak generated by a deprotection reaction of the blocked isocyanate in the case of being measured by means of DSC using a differential scanning calorimeter (manufactured by Seiko Instruments Inc., DSC6200). The obtained results were shown in Table 3.

- Measurement of viscosities at 25°C of compounds capable of reacting with acids by heating such as blocked isocyanates -

The viscosities at 25°C of the compounds capable of reacting with acids by heating such as blocked isocyanates used in the respective examples and comparative examples were measured using the following method.

The viscosities at 25°C of the compounds capable of reacting with acids by heating such as blocked isocyanates of the respective examples and comparative examples were measured using an E-type viscometer RE-85U (manufactured by Toki Sangyo Co., Ltd.).

The obtained results are shown in Table 3.

[Table 3]

| Blocked isocyanate | Material | | Synthesis solvent | Evaluation | | |
|---|---|---|---|---|---|---|
| | Compound having hydrophilic group (parts by mass) | Blocking agent (parts by mass) | | Initial Tg | Dissociation temperature | Viscosity Pa·s (25°C) |
| Compound A | Methoxy polyethylene glycol: 52.7 | Methyl ethyl ketoxime: 40.2 | Dipropylene glycol monomethyl ether | -20~0 °C | 140°C | 30 |
| Compound B | Methoxy polyethylene glycol: 52.7 | Methyl ethyl ketoxime: 40.2 | Propylene glycol monomethyl ether acetate methoxy propyl acetate | -20~0 °C | 140°C | 35 |
| Compound C | 2-(Dimethylamine) ethanol: 8.2 | Methyl ethyl ketoxime: 33.7 | Dipropylene glycol monomethyl ether | -20~-1 0°C | 140°C | 40 |
| Compound D | Methoxy polyethylene glycol: 52.7 | 3,5-Dimethylpyrazole: 44.3 | Dipropylene glycol monomethyl ether | -10~0 °C | 120°C | 20 |
| Compound E | - | 3,5-Dimethylpyrazole: 54.1 | Dipropylene glycol monomethyl ether | -20~0 °C | 120°C | 30 |
| Compound F | - | Methyl ethyl ketoxime: 49.0 | Dipropylene glycol monomethyl ether | -10~1 0°C | 140°C | 30 |

Compound G

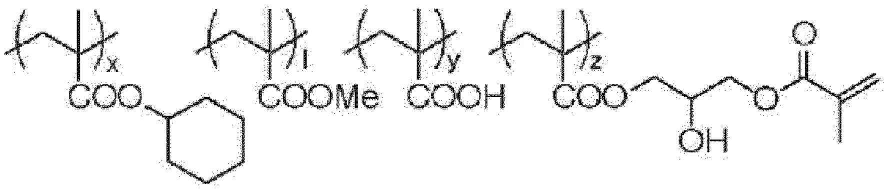

x／l／y／z＝51．5／2／26．5／20

Compound H

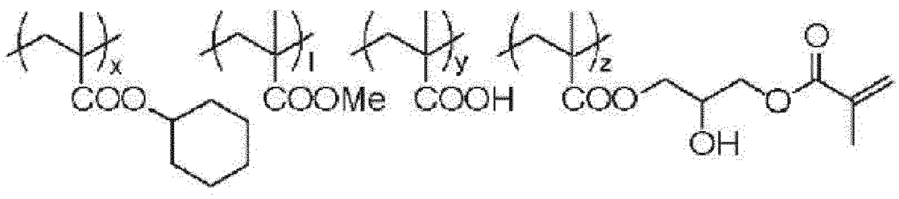

x／l／y／z＝43／2／20／35

Compound I

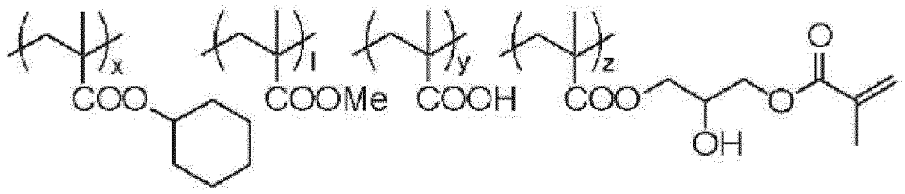

x／l／y／z＝45／2／33／20

<Preparation of coating fluids for second transparent resin layer>

Materials B-1 and B-2 which were coating fluids for a second transparent resin layer were prepared so as to obtain compositions shown in Table 4.

[Table 4]

| Material | Material B-1 | Material B-2 |
|---|---|---|
| NanoUse OZ-S30M: $ZrO_2$ particles, methanol dispersion liquid (nonvolatile component: 30.5%) manufactured by Nissan Chemical Industries, Ltd. | 0.00 | 4.20 |
| Ammonia water (2.5%) | 7.84 | 7.84 |
| Copolymer resin of methacrylic acid/allyl methacrylate (Mw: 25,000, compositional ratio=40/60, nonvolatile component: 99.8%) | 6.00 | 0.50 |
| Carboxylic acid-containing monomer ARONIX TO-2349 (manufactured by Toagosei Co., Ltd.) | 0.50 | 0.04 |
| Benzotriazole BT120 (manufactured by Johoku Chemical Co., Ltd.) | 0.50 | 0.04 |
| MEGAFACE F444 (manufactured by DIC Corporation) | 0.01 | 0.01 |
| Ion-exchange water | 25.16 | 27.38 |
| Methanol | 60.00 | 60.00 |
| Total (parts by mass) | 100 | 100 |

[2. Production of transfer films]

Any one of Materials A-1 to A-15 for the photosensitive transparent resin layer was applied onto a temporary support having a film thickness of 16 μm which was a polyethylene terephthalate film using slit-shaped nozzles while adjusting the application amount so that the film thickness of the dried photosensitive transparent resin layer reached a film thickness shown in Table 6, thereby forming a photosensitive transparent resin layer. After the solvent was volatilized in a drying zone at 120°C, any one of Materials B-1 and B-2 was applied using slit-shaped nozzles and dried while adjusting the application amount so that the dried film thickness reached a film thickness of 0.1 μm, thereby forming a second transparent resin layer.

[3. Production of transparent electrode pattern film used to produce laminates]

<Formation of transparent film>

A corona discharge treatment was carried out for three seconds on a cycloolefin resin film having a film thickness of 38 μm and a refractive index of 1.53 using a high-frequency oscillator, thereby reforming the surface. Meanwhile, the corona treatment was carried out under conditions of an output voltage of 100%, an output of 250 W, a wire electrode having a diameter of 1.2 mm, an electrode length of 240 mm, and a distance between working electrodes of 1.5 mm. The obtained film was used as a transparent film substrate.

Next, the material of Material-C shown in Table 5 was applied onto the transparent film substrate using slit-shaped nozzles, then irradiated with ultraviolet rays (at an integral of light of 300 mJ/$cm^2$), and dried at approximately 110°C, thereby producing a transparent film having a refractive index of 1.60 and a film thickness of 80 nm.

[Table 5]

| Material | MATERIAL-C |
|---|---|
| $ZrO_2$: manufactured by Solar Co., Ltd., ZR-010 | 2.08 |
| DPHA liquid (dipentaerythritol hexaacrylate: 38%, dipentaerythritol pentaacrylate: 38%, 1-methoxy-2-propyl acetate: 24%) | 0.29 |
| Urethane-based monomer: NK OLIGOMER UA-32P, manufactured by Shin-Nakamura Chemical Co., Ltd., nonvolatile component: 75%, 1-methoxy-2-propyl acetate: 25% | 0.14 |
| Monomer mixture (the polymerizable compound (b2-1) described in Paragraph "0111" of JP2012-78528A, n=1: the content ratio of tripentaerythritol octaacrylate: 85%, the sum of n=2 and n=3 as impurities: 15%) | 0.36 |
| Polymer solution 1 (Structural Formula P-25 described in "0058" of JP2008-146018A: the weight-average molecular weight=35,000, solid content: 45%, 1-methoxy-2-propyl acetate: 15%, 1-methoxy-2-propanol: 40%) | 1.89 |
| Photoradical polymerization initiator: 2-benzyl-2-dimethylamino-1-(4-morpholinophenyl)-butanone (IRGACURE 379, manufactured by BASF) | 0.03 |
| Photopolymerization initiator: KAYACURE DETX-S (alkylthioxanthone manufactured by Nippon Kayaku Co., Ltd.) | 0.03 |
| Polymer solution 2 (polymer having a structural formula represented by Formula (3): solution having a weight-average molecular weight=15,000, nonvolatile content: 30wt%, methyl ethyl ketone: 70wt%) | 0.01 |
| 1-Methoxy-2-propyl acetate | 38.73 |
| Methyl ethyl ketone | 56.80 |
| Total (parts by mass) | 100 |

Meanwhile, "wt%" in the specification is identical to "% by mass".

Formula (3)

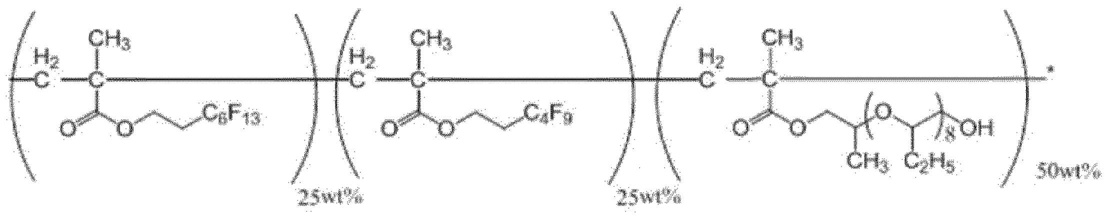

Mw 15000

<Formation of transparent electrode pattern>

The film having the transparent film laminated on the transparent film substrate obtained above was introduced into a vacuum chamber, and an ITO thin film was formed by means of DC magnetron sputtering (conditions: the temperature of the transparent film substrate was 150°C, the argon pressure was 0.13 Pa, and the oxygen pressure was 0.01 Pa) using an ITO target (indium:tin=95:5 (molar ratio)) in which the content ratio of $SnO_2$ was 10% by mass, thereby forming an ITO thin film having a thickness of 40 nm and a refractive index of 1.82 and obtaining a film having the transparent film and the transparent electrode layer formed on the transparent film substrate. The surface electrical resistance of the ITO thin film was 80 Ω/□ (Ω per square).

(Preparation of photosensitive film for etching E1)

A coating fluid for a thermoplastic resin layer made of Formulation H1 was applied and dried on a 75 μm-thick polyethylene terephthalate film temporary support using slit-shaped nozzles. Next, a coating fluid for an interlayer made of Formulation P1 was applied and dried. Furthermore, a coating fluid for a photocurable resin layer for etching made of Formulation E1 was applied and dried. A laminate having a thermoplastic resin layer having a dried thickness of 15.1 μm, an interlayer having a dried thickness of 1.6 μm, and a photocurable resin layer for etching having a thickness of 2.0 μm on the temporary support was obtained in the above-described manner, and finally, a protective film (12 μm-thick polypropylene film) was pressed onto the laminate. A transfer material in which the temporary support, the thermoplastic resin layer, the interlayer (oxygen-shielding film), and the transparent curable resin layer for etching were integrated together was produced in the above-described manner.

- Coating fluid for photocurable resin layer for etching: Formulation E1 -

- Methyl methacrylate/styrene/methacrylic acid copolymer (copolymer composition (% by mass): 31/40/29, weight-average molecular weight of 60,000, acid value: 163 mgKOH/g) : 16 parts by mass
- Monomer 1 (trade name: BPE-500, manufactured by Shin-Nakamura Chemical Co., Ltd.) : 5.6 parts by mass
- Adduct of hexamethylene diisocyanate and 0.5 mol of tetraethylene oxide monomethacrylate : 7 parts by mass
- Cyclohexane dimethanol monoacrylate as a compound having one polymerizable group in the molecule : 2.8 parts by mass
- 2-Chloro-N-butylacridone : 0.42 parts by mass
- 2,2-Bis(ortho-chlorophenyl)-4,4',5,5'-tetraphenyl biimidazole : 2.17 parts by mass
- Malachite green oxalate : 0.02 parts by mass
- Leuco crystal violet : 0.26 parts by mass
- Phenothiazine : 0.013 parts by mass
- Surfactant (trade name: MEGAFACE F-780F, manufactured by DIC Corporation) : 0.03 parts by mass
- Methyl ethyl ketone : 40 parts by mass
- 1-Methoxy-2-propanol : 20 parts by mass

Meanwhile, the viscosity of the coating fluid for a photocurable resin layer for etching E1 after the removal of the solvent at 100°C was 2,500 Pa·sec.

- Coating fluid for thermoplastic resin layer: Formulation H1 -

- Methanol : 11.1 parts by mass
- Propylene glycol monomethyl ether acetate : 6.36 parts by mass
- Methyl ethyl ketone : 52.4 parts by mass
- Methyl methacrylate/2-ethylhexyl acrylate/benzyl methacrylate/methacrylic acid copolymer (copolymerization compositional ratio (molar ratio)=55/11.7/4.5/28.8, molecular weight=100,000, glass transition temperature (Tg)≈70°C) : 5.83 parts by mass
- Styrene/acrylic acid copolymer (copolymerization compositional ratio (molar ratio)=63/37, weight-average molecular weight=10,000, Tg≈100°C) : 13.6 parts by mass
- Monomer 1 (trade name: BPE-500, manufactured by Shin-Nakamura Chemical Co., Ltd.) : 9.1 parts by mass
- Fluorine-based polymer : 0.54 parts by mass

The fluorine-based polymer is a copolymer of 40 parts of $C_6F_{13}CH_2CH_2OCOCH=CH_2$, 55 parts of $H(OCH(CH_3)CH_2)_7OCOCH=CH_2$, and 5 parts of $H(OCH_2CH_2)_7OCOCH=CH_2$ and a solution of 30% by mass of methyl ethyl ketone having a weight-average molecular weight of 30,000 (trade name: MEGAFACE F780F, manufactured by DIC Corporation).

- Coating fluid for interlayer: Formulation P1 -

- Polyvinyl alcohol : 32.2 parts by mass
  (trade name: PVA205, manufactured by Kuraray Co., Ltd., degree of saponification=88%, degree of polymerization 550)
- Polyvinyl pyrrolidone : 14.9 parts by mass (trade name: K-30, manufactured by ISB Corporation)
- Distilled water : 524 parts by mass
- Methanol : 429 parts by mass

(Formation of transparent electrode pattern)

The film having the transparent film and the transparent electrode layer formed on the transparent film substrate was washed, and the photosensitive film for etching E1 from which the protective film had been removed was laminated thereon (the temperature of the transparent film substrate of 130°C, the rubber roller temperature of 120°C, the linear pressure of 100 N/cm, and the transportation rate of 2.2 m/minute). After the temporary support was peeled off, the distance between an exposure mask (a silica exposure mask having a transparent electrode pattern) surface and the photocurable resin layer for etching was set to 200 μm, and pattern-exposure was carried out at an exposure amount of 50 mJ/cm$^2$ (i rays).

Next, a treatment was carried out using a triethanolamine-based developer (containing 30% by mass of triethanolamine, a liquid obtained by diluting trade name: T-PD2 (manufactured by Fujifilm Corporation) with pure water ten times) at 25°C for 100 seconds and using a surfactant-containing washing liquid (a liquid obtained by diluting T-SD3 (trade name, manufactured by Fujifilm Corporation) with pure water ten times) at 33°C for 20 seconds, and residues were removed with a rotary brush and ultrahigh-pressure washing nozzles. Furthermore, a post-baking treatment was carried out at 130°C for 30 minutes, thereby obtaining a film having the transparent film, the transparent electrode layer, and the photocurable resin layer pattern for etching formed on the transparent film layer.

The film having the transparent film, the transparent electrode layer, and the photocurable resin layer pattern for etching formed on the transparent film layer was immersed in an etching tank filled with an ITO etchant (an aqueous solution of hydrochloric acid and potassium chloride, liquid temperature: 30°C) and treated for 100 seconds. With this treatment, the transparent electrode layer in exposed regions that were not covered with the photocurable resin layer for etching was dissolved and removed, and a transparent electrode pattern-attached film to which the photocurable resin layer pattern for etching was attached was obtained.

Next, the transparent electrode pattern-attached film to which the photocurable resin layer pattern for etching was attached was immersed in a resist peeling tank filled with a resist peeling fluid (N-methyl-2-pyrrolidone, monoethanolamine, and a surfactant (trade name: SURFYNOL 465, manufactured by Air Products and Chemicals, Inc.), the liquid temperature of: 45°C) and treated for 200 seconds. With this treatment, the photocurable resin layer for etching was removed, and a film having the transparent film and the transparent electrode pattern (the electrode of the electrostatic capacitance-type input device) formed on the transparent film substrate was obtained.

[4. Production of laminates of examples and comparative examples]

Using the transfer film of each of the examples and the comparative examples, from which the protective film had been peeled off, the second transparent resin layer, the photosensitive transparent resin layer, and the temporary support were transferred in this order so that the second transparent resin layer covered the transparent film and the transparent electrode pattern (the electrode of the electrostatic capacitance-type input device) of the film having the transparent film and the transparent electrode pattern formed on the transparent film substrate (the substrate including the electrode of the electrostatic capacitance-type input device) (the temperature of the transparent film substrate of 40°C, the rubber roller temperature of 110°C, the linear pressure of 3 N/cm, and the transportation rate of 2 m/minute).

After that, using a proximity-type stepper having an ultrahigh-pressure mercury lamp (manufactured by Hitachi High-Tech Fielding Corporation), the distance between an exposure mask (a silica exposure mask having a pattern for forming an overcoat layer) surface and the temporary support was set to 125 μm, and pattern-exposure was carried out through the temporary support at an exposure amount of 100 mJ/cm$^2$ (i rays). After the exposure, the temporary support was peeled off, and a development treatment was carried out at 32°C for 60 seconds using an aqueous solution of 2% sodium carbonate. Ultrapure water was sprayed to the development-treated transparent film substrate from ultrahigh-pressure washing nozzles, thereby removing residues. Subsequently, moisture on the transparent film substrate was removed by blowing the air, and a heating (post-basking) treatment was carried out at 145°C for 30 minutes, thereby producing a laminate in which the transparent film, the transparent electrode pattern (the electrode of the electrostatic capacitance-type input device), the second transparent resin layer, and the photosensitive transparent resin layer were continuously provided in this order on the transparent film substrate.

[Evaluation of transfer film]

<Evaluation of heat and moisture resistance after supply of saline water>

Using the transfer film of each of the examples and the comparative examples, from which the protective film had been peeled off, the second transparent resin layer and the photosensitive transparent resin layer were transferred onto a PET film on which a copper foil (alternatively used as the electrode of the electrostatic capacitance-type input device) was laminated (manufactured by Geomatec Co., Ltd.) in the same manner as in the method for transferring the film having the transparent film and the transparent electrode pattern formed on the transparent film substrate, thereby a specimen on which post processes (the peeling of the temporary support, development, post baking, and the like) were carried out.

Saline water having a concentration of 50 g/L (5 $cm^3$) was added dropwise to the film surface of the photosensitive transparent resin layer in the specimen, was evenly spread to 50 $cm^2$, then, moisture was volatilized at normal temperature, and the specimen was stored at a high temperature and a high humidity (85°C, a relative humidity: 85%) for 72 hours. After that, the saline water was wiped, and the surface state of the specimen was observed and evaluated according to the following evaluation points.

The heat and moisture resistance after the supply of saline water being A or B is a practically necessary level, and A is preferred. The evaluation results are shown in Table 6.

A: All of copper, the second transparent resin layer surface, and the photosensitive transparent resin layer surface did not change.
B: A small number of marks were observed on the second transparent resin layer surface or the photosensitive transparent resin layer surface, but copper did not change.
C: Copper was discolored.

[Evaluation of laminate]

<Evaluation of development residues>

After the transfer film of each of the examples and the comparative examples was transferred onto the film having the transparent film and the transparent electrode pattern formed on the transparent film substrate (the substrate including the electrode of the electrostatic capacitance-type input device), using a proximity-type stepper having an ultrahigh-pressure mercury lamp (manufactured by Hitachi High-Tech Fielding Corporation), the distance between an exposure mask (a silica exposure mask having a pattern for forming an overcoat) surface and the temporary support was set to 125 μm, and pattern-exposure was carried out through the temporary support at an exposure amount of 100 $mJ/cm^2$ (i rays). After the exposure, the temporary support was peeled off, and a development treatment was carried out at 32°C for 40 seconds using an aqueous solution of 2% sodium carbonate. After that, non-exposed portions were observed using an optical microscope. In all of the examples and the comparative examples, it was not possible to observe development residues in the non-exposed portions.

In order to evaluate the latitude with respect to development conditions, development residue evaluation (forcible conditions) was carried out under conditions in which development was hard, that is, the development temperature was set to 30°C.

Even in a case in which the development conditions were set to be hard from standard development conditions, it is desirable that regions in which no development residues are observed are present in non-exposed portions, A and B are practically necessary levels, and A is preferred. The evaluation results are shown in Table 6.

«Evaluation standards»

A: It was not possible to observe development residues in the non-exposed portions with the microscope.
B: It was not possible to visually observe development residues on the non-exposed portions, but possible to observe less than one residue per square meter with the microscope.
C: It was not possible to visually observe development residues on the non-exposed portions, but possible to observe one residue per square meter or more with the microscope.
D: There were non-developed portions in the non-exposed portions, and it was possible to visually observe a number of development residues.

<Evaluation of transparent electrode pattern-covering properties>

The laminate in which the transparent film, the transparent electrode pattern, the second transparent resin layer, and the photosensitive transparent resin layer were laminated in this order on the transparent film substrate and a black PET material were made to adhere together through transparent adhesive tape (manufactured by 3M Company, trade name: OCA tape 8171CL) so as to shield the entire substrate from light.

The transparent electrode pattern-covering properties were evaluated in the following manner: light was incident on the transparent film substrate surface side of the produced substrate using a fluorescent lamp (light source) in a dark room, and reflected light from the surface of the transparent film substrate was visually observed at an inclined angle. The transparent electrode pattern-covering properties are preferably A, B, or C, more preferably A or B, and particularly preferably A. The evaluation results are shown in Table 6.

«Evaluation standards»

A: The transparent electrode pattern was not observed.
B: The transparent electrode pattern was slightly observed, but barely observed.
C: The transparent electrode pattern was observed (not easy to be recognized).
D: The transparent electrode pattern was observed within a practically permissible range.
E: The transparent electrode pattern was clearly observed (easy to be recognized).

[Table 6]

| | Photosensitive transparent resin layer | | | | | | Second transparent resin layer | | Heat and moisture resistance after supply of saline water | Development residues | Transparent electrode pattern-masking properties |
|---|---|---|---|---|---|---|---|---|---|---|---|
| | Material | (D) Compound capable of reacting with acids by heating | Hydrophilic group in (D) (condition 1) | Viscosity of (D) Pa·s (25°C) | (E) Compound having ethylene oxide chain or propylene oxide chain (condition 2) | Thickness μm | Material | Refractive index | | | |
| Example 1 | Material A-1 | Blocked isocyanate compound A | Methoxypolyethylene glycol | 30 | None | 8 | Material B-2 | 1.65 | A | A | A |
| Example 2 | Material A-2 | Blocked isocyanate compound A | Methoxypolyethylene glycol | 30 | None | 8 | Material B-2 | 1.65 | A | A | A |
| Example 3 | Material A-3 | Blocked isocyanate compound B | Methoxypolyethylene glycol | 35 | None | 8 | Material B-2 | 1.65 | A | A | A |
| Example 4 | Material A-4 | Blocked isocyanate compound C | 2-(Dimethylamino) ethanol | 40 | None | 8 | Material B-2 | 1.65 | B | A | A |
| Example 5 | Material A-5 | Blocked isocyanate compound D | Methoxypolyethylene glycol | 20 | None | 8 | Material B-2 | 1.65 | A | A | A |
| Example 6 | Material A-6 | Blocked isocyanate compound A | Methoxypolyethylene glycol | 30 | None | 8 | Material B-2 | 1.65 | A | B | A |
| Example 7 | Material A-7 | Blocked isocyanate compound A | Methoxypolyethylene glycol | 30 | None | 8 | Material B-2 | 1.65 | A | B | A |
| Example 8 | Material A-8 | Blocked isocyanate compound A | Methoxypolyethylene glycol | 30 | None | 8 | Material B-2 | 1.65 | A | A | A |

(continued)

| | Photosensitive transparent resin layer | | | | | | Second transparent resin layer | | Heat and moisture resistance after supply of saline water | Development residues | Transparent electrode pattern-masking properties |
|---|---|---|---|---|---|---|---|---|---|---|---|
| | Material | (D) Compound capable of reacting with acids by heating | Hydrophilic group in (D) (condition 1) | Viscosity of (D) Pa·s (25°C) | (E) Compound having ethylene oxide chain or propylene oxide chain (condition 2) | Thickness µm | Material | Refractive index | | | |
| Example 9 | Material A-9 | Blocked isocyanate compound A | Methoxypolyethylene glycol | 30 | None | 8 | Material B-2 | 1.65 | A | A | A |
| Example 10 | Material A-10 | Blocked isocyanate compound A | Methoxypolyethylene glycol | 30 | None | 8 | Material B-2 | 1.65 | A | A | A |
| Example 11 | Material A-11 | Blocked isocyanate compound A | Methoxypolyethylene glycol | 30 | None | 8 | Material B-2 | 1.65 | A | A | A |
| Example 12 | Material A-12 | Blocked isocyanate compound E | None | 30 | EMULGEN B-66 | 8 | Material B-2 | 1.65 | A | A | A |
| Example 13 | Material A-13 | Blocked isocyanate compound E | None | 30 | EMULGEN B-66 | 8 | Material B-2 | 1.65 | A | B | A |
| Example 14 | Material A-14 | Blocked isocyanate compound E | None | 30 | EMULGEN A-90 | 8 | Material B-2 | 1.65 | B | A | A |
| Example 15 | Material A-15 | Epoxy compound EPOX-MK R151 | None | 40 | EMULGEN B-66 | 8 | Material B-2 | 1.65 | B | A | A |

(continued)

| | Photosensitive transparent resin layer | | | | | | Second transparent resin layer | | Heat and moisture resistance after supply of saline water | Development residues | Transparent electrode pattern-masking properties |
|---|---|---|---|---|---|---|---|---|---|---|---|
| | Material | (D) Compound capable of reacting with acids by heating | Hydrophilic group in (D) (condition 1) | Viscosity of (D) Pa·s (25°C) | (E) Compound having ethylene oxide chain or propylene oxide chain (condition 2) | Thickness µm | Material | Refractive index | | | |
| Example 16 | Material A-1 | Blocked isocyanate compound A | Methoxypolyethylene glycol | 30 | None | 8 | N one | - | A | A | E |
| Example 17 | Material A-1 | Blocked isocyanate compound A | Methoxypolyethylene glycol | 30 | None | 8 | Material B-1 | 1.50 | A | A | D |
| Example 18 | Material A-1 | Blocked isocyanate compound A | Methoxypolyethylene glycol | 30 | None | 2 | Material B-2 | 1.65 | B | A | A |
| Example 19 | Material A-1 | Blocked isocyanate compound A | Methoxypolyethylene glycol | 30 | None | 4 | Material B-2 | 1.65 | A | A | A |
| Example 20 | Material A-1 | Blocked isocyanate compound A | Methoxypolyethylene glycol | 30 | None | 25 | Material B-2 | 1.65 | A | B | A |
| Comparative Example 1 | Material A-16 | None | | - | None | 8 | Material B-2 | 1.65 | C | A | A |
| Comparative Example 2 | Material A-17 | Blocked isocyanate compound E | None | 30 | None | 8 | Material B-2 | 1.65 | A | D | A |
| Comparative Example 3 | Material A-18 | Blocked isocyanate compound F | None | 30 | None | 8 | Material B-2 | 1.65 | A | D | A |

(continued)

| | Photosensitive transparent resin layer | | | | | | Second transparent resin layer | | Heat and moisture resistance after supply of saline water | Development residues | Transparent electrode pattern-masking properties |
|---|---|---|---|---|---|---|---|---|---|---|---|
| | Material | (D) Compound capable of reacting with acids by heating | Hydrophilic group in (D) (condition 1) | Viscosity of (D) Pa·s (25°C) | (E) Compound having ethylene oxide chain or propylene oxide chain (condition 2) | Thickness µm | Material | Refractive index | | | |
| Comparative Example 4 | Material A-19 | Blocked isocyanate compound E | None | 30 | None | 8 | Material B-2 | 1.65 | B | C | A |
| Comparative Example 5 | Material A-20 | Epoxy compound EPOX-MK R151 | None | 40 | None | 9 | Material B-2 | 1.65 | B | D | A |

From Table 6, it was found that the transfer film of the present invention can be used to form electrode protective films for electrostatic capacitance-type input devices being excellent in terms of both the heat and moisture resistance after the supply of saline water and development residues.

Meanwhile, in Comparative Examples 2 to 5 in which (D) the compound capable of reacting with acids by heating which has a hydrophilic group in the molecule or the compound having an ethylene oxide chain or a propylene oxide chain was not added, it was found that development residues were observed and there was a problem with the appearance. In addition, in Comparative Example 1 in which (D) the compound capable of reacting with acids by heating such as a blocked isocyanate or an epoxy compound was not added, development residues were favorable, but the heat and moisture resistance after the supply of saline water was poor.

In addition, in the constitutions in which $ZrO_2$ particles were added to the second transparent resin layer in Examples 1 to 15 and 18 to 20, it was found that the refractive index of the second transparent resin layer reached 1.65, and it was possible to form electrode protective films for electrostatic capacitance-type input devices being excellent in terms of transparent electrode pattern-masking properties.

Furthermore, the content of metal oxide particles in the photosensitive transparent resin layer or the second transparent resin layer of the laminate of each of the examples and the comparative examples was measured using the following method.

A cross section of the laminate is cut and then observed using a transmission electron microscope (TEM). The fractions of the occupancy area of metal oxide particles in the film cross-sectional area of the photosensitive transparent resin layer or the second transparent resin layer of the laminate are measured at three arbitrary places, and the average value thereof is considered as the volume ratio (VR).

The volume ratio (VR) and the weight ratio (WR) are converted using the following expression, thereby computing the weight ratio (WR) of the metal oxide particles in the photosensitive transparent resin layer or the second transparent resin layer of the laminate.

$$WR=D*VR/(1.1*(1-VR)+D*VR)$$

D: The specific weight of the metal oxide particles

The metal oxide particles can be calculated with D that is 4.0 in the case of titanium oxide or 6.0 in the case of zirconium oxide.

Meanwhile, the content of metal oxide particles in the photosensitive transparent resin layer or the second transparent resin layer of the laminate of each of the examples and the comparative examples was measured can also be computed from the composition of the photosensitive transparent resin layer or the second transparent resin layer. The content of metal oxide particles in the photosensitive transparent resin layer or the second transparent resin layer of the laminate was the same as the content computed from the composition of the photosensitive transparent resin layer or the second transparent resin layer.

[Production of image display device (touch panel)]

To a liquid crystal display device manufactured using the method described in <0097> to <0119> of JP2009-47936A, the previously-manufactured laminate of each example was attached, and, furthermore, a front glass plate was bound thereto, thereby producing image display devices including the laminates of the respective examples comprising the electrostatic capacitance-type input device as a constituent element using a well-known method in the above-described manner.

<Evaluation of electrostatic capacitance-type input devices and image display devices>

The electrostatic capacitance-type input devices and the image display devices including the laminates of Examples 1 to 20 were excellent in terms of both heat and moisture resistance after the supply of saline water and development residues.

The electrostatic capacitance-type input devices and the image display devices including the laminates of Examples 1 to 15 and 18 to 20 did not have a problem of the transparent electrode pattern being visible.

In the image display devices including the laminate of each example, the photosensitive transparent resin layer and the second transparent resin layer did not have any defects such as air bubbles, and image display devices having excellent display characteristics were obtained.

Explanation of References

1: transparent substrate (front plate)
2: mask layer
3: transparent electrode pattern (first transparent electrode pattern)
3a: pad portion
3b: connection portion
4: transparent electrode pattern (second transparent electrode pattern)
5: insulating layer
6: additional conductive element
7: photosensitive transparent resin layer (preferably having function of transparent protective layer)
8: opening portion
10: electrostatic capacitance-type input device
11: transparent film
12: second transparent resin layer (which may have function of transparent insulating layer)
13: laminate
21: region in which transparent electrode pattern, second transparent resin layer, and photosensitive transparent resin layer are laminated in this order
22: non-patterned region
$\alpha$: taper angle
26: temporary support
27: thermoplastic resin layer
28: interlayer
29: protective peeling layer (protective film)
30: transfer film
31: terminal portion of guidance wire
33: cured portion of photosensitive transparent resin layer and second transparent resin layer
34: opening portion corresponding to edge portion of guidance wire (non-cured portion of photosensitive transparent resin layer and second transparent resin layer)
C: first direction
D: second direction

## Claims

**1.** A transfer film comprising:

a temporary support; and
a photosensitive transparent resin layer located on the temporary support, wherein the photosensitive transparent resin layer includes (A) a binder polymer, (B) a photopolymerizable compound having an ethylenic unsaturated group, (C) a photopolymerization initiator, and (D) a compound capable of reacting with acids by heating,
at least one of the following condition 1 or the following condition 2 is satisfied, and
the transfer film is used for an electrode protective film in an electrostatic capacitance-type input device;
condition 1: (D) the compound capable of reacting with acids by heating has a hydrophilic group in a molecule; and
condition 2: the photosensitive transparent resin layer further includes (E) a compound having an ethylene oxide chain or a propylene oxide chain.

**2.** The transfer film according to claim 1,
wherein a viscosity at 25°C of (D) the compound capable of reacting with acids by heating is 0.1 to 100 Pa·s.

**3.** The transfer film according to claim 1 or 2,
wherein the viscosity at 25°C of (D) the compound capable of reacting with acids by heating is 5 to 60 Pa·s.

**4.** The transfer film according to any one of claims 1 to 3,
wherein (D) the compound capable of reacting with acids by heating is a blocked isocyanate.

**5.** The transfer film according to any one of claims 1 to 4, wherein the hydrophilic group in the molecule of (D) the compound capable of reacting with acids by heating is an ethylene oxide chain or a propylene oxide chain.

**6.** The transfer film according to any one of claims 1 to 5, wherein a thickness of the photosensitive transparent resin layer is 1 to 20 μm.

**7.** The transfer film according to any one of claims 1 to 6, further comprising:

a second transparent resin layer on the photosensitive transparent resin layer, wherein a refractive index of the second transparent resin layer is higher than a refractive index of the photosensitive transparent resin layer.

**8.** An electrode protective film for an electrostatic capacitance-type input device, wherein the temporary support is removed from the transfer film according to any one of claims 1 to 7.

**9.** A laminate comprising:

a substrate including an electrode of an electrostatic capacitance-type input device; and
a photosensitive transparent resin layer located on the substrate,
wherein the photosensitive transparent resin layer is formed by transferring the photosensitive transparent resin layer from the transfer film according to any one of claims 1 to 7 onto the substrate.

**10.** A laminate comprising:

a substrate including an electrode of an electrostatic capacitance-type input device; and
a photosensitive transparent resin layer located on the substrate,
wherein the photosensitive transparent resin layer includes (A) a binder polymer, (B) a photopolymerizable compound having an ethylenic unsaturated group, (C) a photopolymerization initiator, and (D) a compound capable of reacting with acids by heating, and
at least one of the following condition 1 or the following condition 2 is satisfied;
condition 1: (D) the compound capable of reacting with acids by heating has a hydrophilic group in a molecule; and
condition 2: the photosensitive transparent resin layer further includes (E) a compound having an ethylene oxide chain or a propylene oxide chain.

**11.** The laminate according to claim 10, wherein a viscosity at 25°C of (D) the compound capable of reacting with acids by heating is 0.1 to 100 Pa·s.

**12.** The laminate according to claim 10 or 11, wherein the viscosity at 25°C of (D) the compound capable of reacting with acids by heating is 5 to 60 Pa·s.

**13.** The laminate according to any one of claims 9 to 12, wherein the electrode is a transparent electrode pattern.

**14.** The laminate according to any one of claims 9 to 13, wherein the substrate is a transparent film substrate.

**15.** A method for manufacturing a laminate comprising: transferring a photosensitive transparent resin layer from the transfer film according to any one of claims 1 to 7 onto a substrate including an electrode of an electrostatic capacitance-type input device.

**16.** The method for manufacturing a laminate according to claim 15, wherein the substrate is a transparent film substrate.

**17.** A laminate manufactured by using the method for manufacturing a laminate according to claim 15 or 16.

**18.** An electrostatic capacitance-type input device comprising: the laminate according to any one of claims 9 to 14 and 17.

FIG. 1A

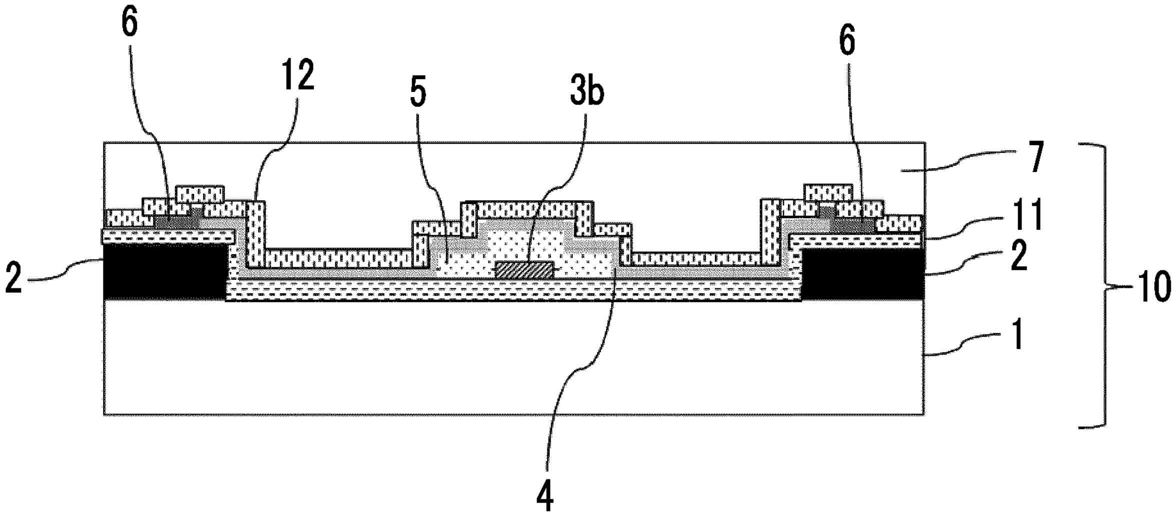


FIG. 1B

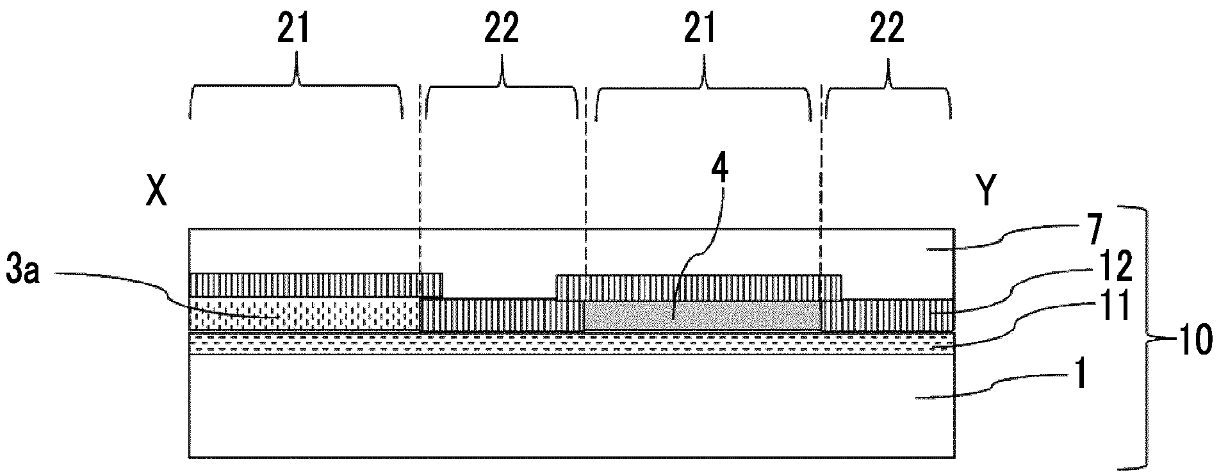

FIG. 2

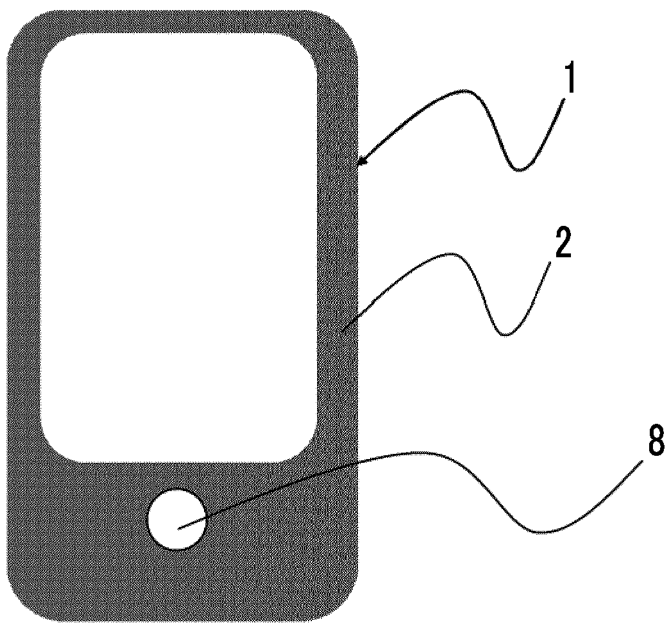

FIG. 3

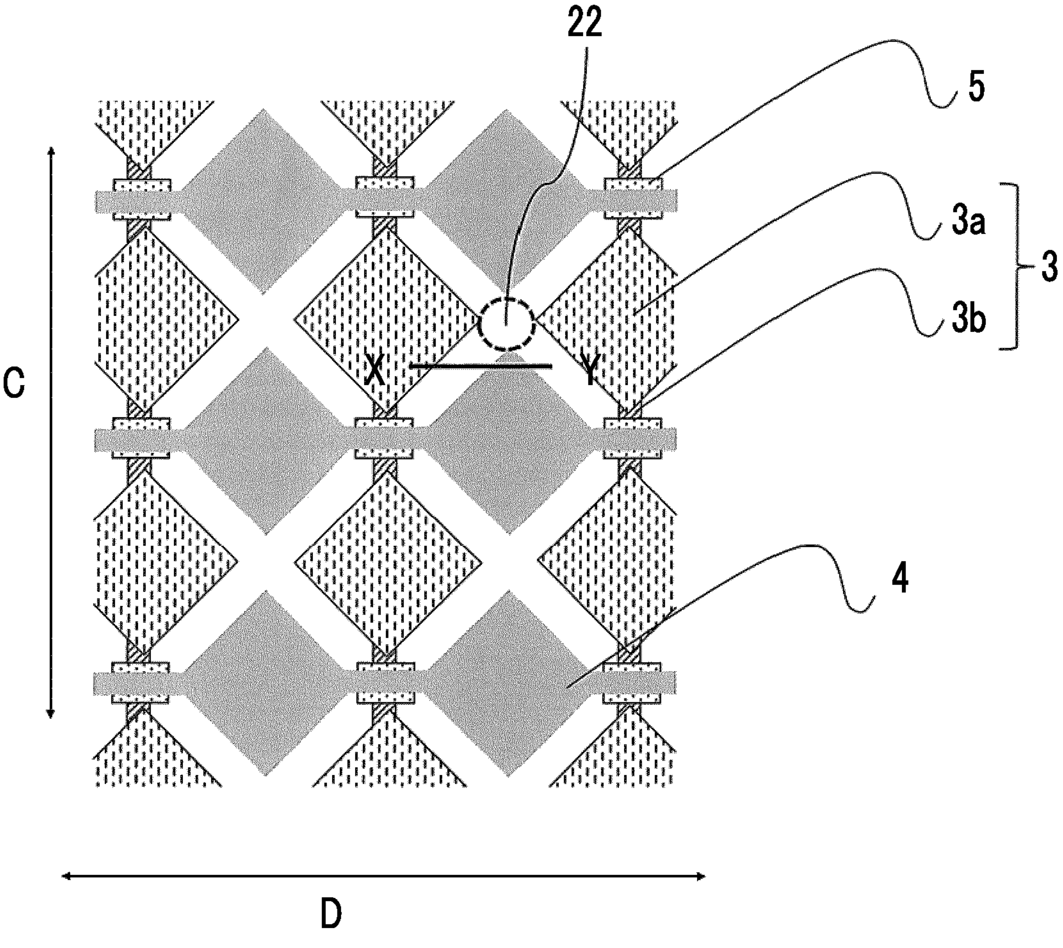

FIG. 4

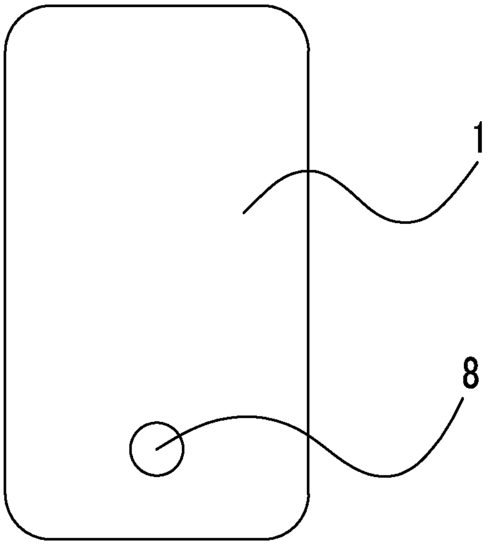


FIG. 5

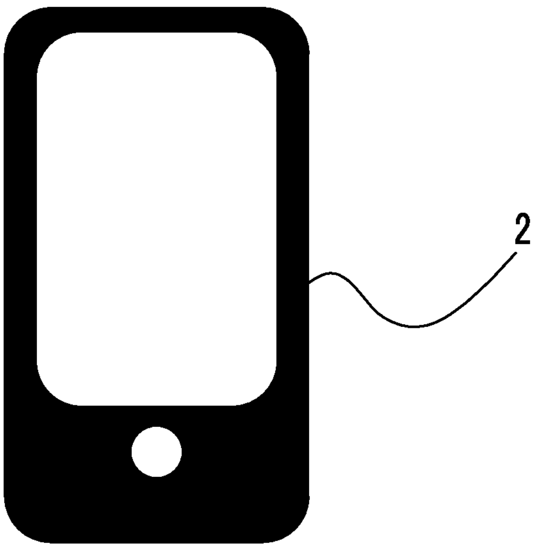

FIG. 6

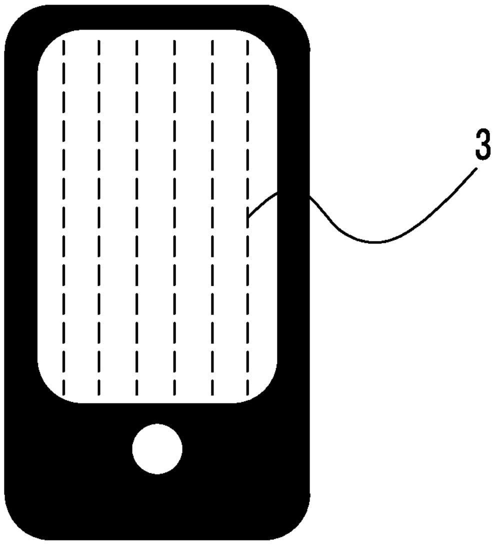


FIG. 7

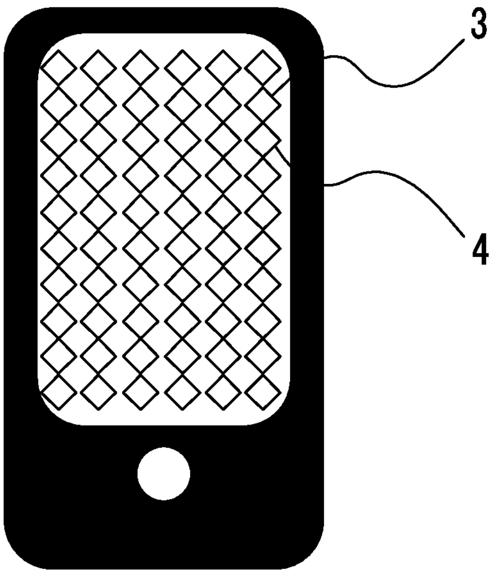

FIG. 8

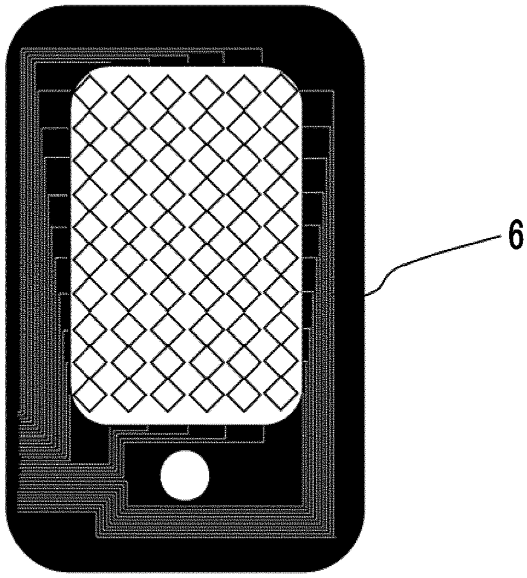


FIG. 9

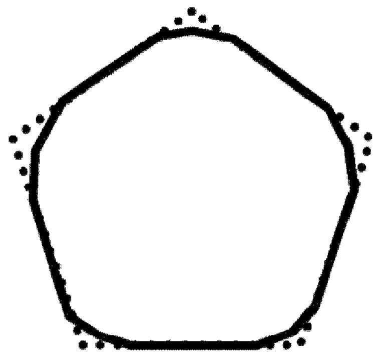

FIG. 10

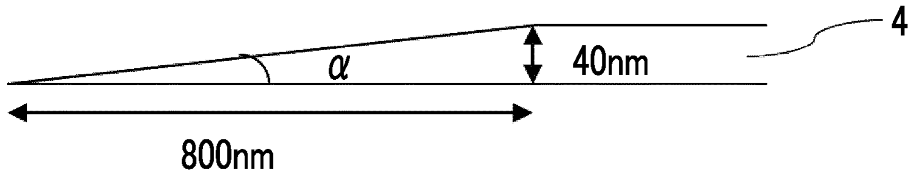

FIG. 11

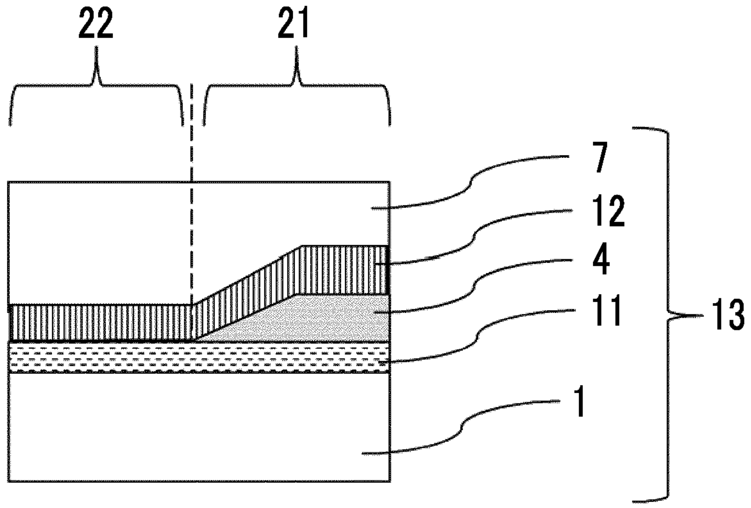


FIG. 12

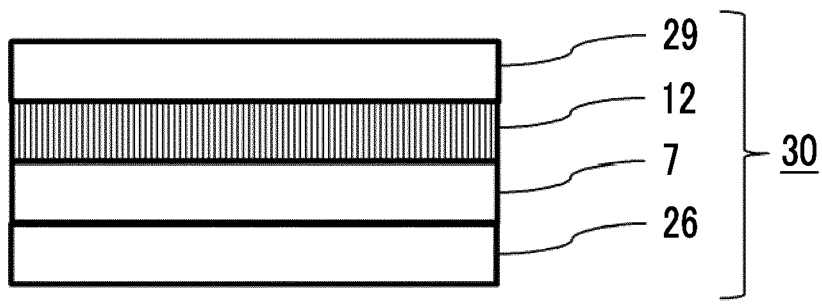

FIG. 13

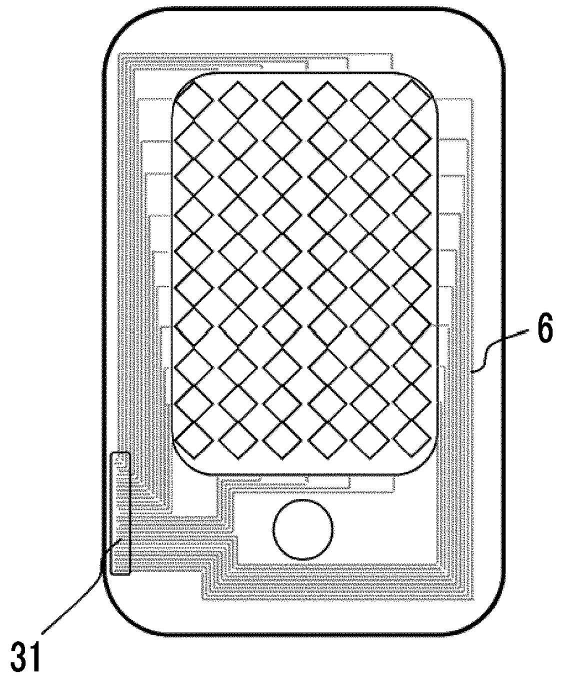


FIG. 14

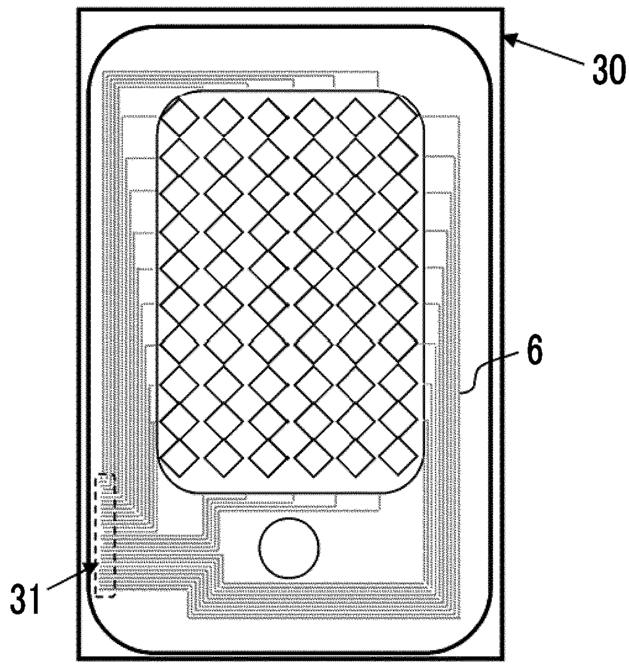

FIG. 15

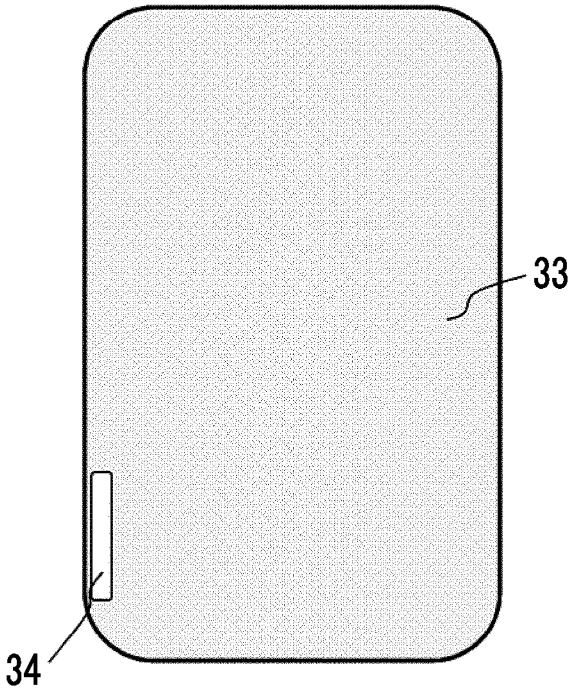

**INTERNATIONAL SEARCH REPORT**

International application No.
PCT/JP2016/071128

A. CLASSIFICATION OF SUBJECT MATTER
*G03F7/004*(2006.01)i, *G06F3/041*(2006.01)i, *G06F3/044*(2006.01)i

According to International Patent Classification (IPC) or to both national classification and IPC

B. FIELDS SEARCHED

Minimum documentation searched (classification system followed by classification symbols)
G03F7/004-7/18, G06F3/041

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 2013-076821 A (Toray Industries, Inc.), 25 April 2013 (25.04.2013), claims; paragraphs [0070] to [0071]; paragraph [0094], example 8; paragraph [0111], table 2 (Family: none) | 1,5-10,13-18<br>2-4,11-12 |
| Y<br><br>A | JP 2012-022304 A (Sumitomo Chemical Co., Ltd.), 02 February 2012 (02.02.2012), paragraph [0114]; paragraph [0128], table 1, photosensitive resin composition 8 & CN 102289150 A & KR 10-2011-0137739 A & TW 201214033 A | 1-2,5-11,<br>13-18<br>3-4,12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 September 2016 (29.09.16) | 11 October 2016 (11.10.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2016/071128

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2013/084873 A1 (Hitachi Chemical Co., Ltd.), 13 June 2013 (13.06.2013), claims; paragraphs [0119], [0134] to [0135] & US 2014/0377704 A1 claims; paragraphs [0122], [0137] to [0138] & CN 103975296 A & KR 10-2014-0097353 A & TW 201337677 A | 1-2,5-11, 13-18 |
| Y | WO 2014/084112 A1 (Fujifilm Corp.), 05 June 2014 (05.06.2014), claims & JP 2014-108541 A & US 2015/0251393 A1 claims & CN 104812569 A & KR 10-2015-0082338 A | 7 |
| P,X<br>P,A | WO 2016/047691 A1 (Asahi Kasei E-materials Corp.), 31 March 2016 (31.03.2016), claims; paragraphs [0113] to [0125], [0130] to [0131]; paragraph [0172], table 3, examples 24 to 25, 27, 29 & TW 201619705 A | 1-3,5-6,8-18<br>4,7 |
| A | JP 2010-160418 A (Hitachi Chemical Co., Ltd.), 22 July 2010 (22.07.2010), claims; paragraph [0117], table 1, examples 1 to 2 (Family: none) | 1-18 |
| A | JP 2007-316574 A (Hitachi Chemical Co., Ltd.), 06 December 2007 (06.12.2007), claims; paragraph [0101], table 1 (Family: none) | 1-18 |
| A | JP 2000-241969 A (Hitachi Chemical Co., Ltd.), 08 September 2000 (08.09.2000), claims; paragraphs [0082] to [0083] (Family: none) | 1-18 |
| A | JP 2012-063747 A (JSR Corp.), 29 March 2012 (29.03.2012), claims & CN 102385251 A & KR 10-2012-0024426 A & TW 201300946 A | 1-18 |
| A | JP 2015-152726 A (Sanyo Chemical Industries, Ltd.), 24 August 2015 (24.08.2015), claims (Family: none) | 1-18 |

Form PCT/ISA/210 (continuation of second sheet) (January 2015)

**INTERNATIONAL SEARCH REPORT**

International application No.
PCT/JP2016/071128

C (Continuation). DOCUMENTS CONSIDERED TO BE RELEVANT

| Category* | Citation of document, with indication, where appropriate, of the relevant passages | Relevant to claim No. |
|---|---|---|
| A | JP 2002-365797 A (Asahi Kasei Corp.), 18 December 2002 (18.12.2002), claims (Family: none) | 1-18 |
| A | JP 2012-159651 A (Asahi Kasei E-materials Corp.), 23 August 2012 (23.08.2012), claims (Family: none) | 1-18 |
| A | JP 2004-020726 A (Hitachi Chemical Co., Ltd.), 22 January 2004 (22.01.2004), claims (Family: none) | 1-18 |

Form PCT/ISA/210 (continuation of second sheet) (January 2015)

INTERNATIONAL SEARCH REPORT

International application No.
PCT/JP2016/071128

With respect to the "compound capable of reacting with acids upon heating" in the invention in claims 1-3 and 5-18, the description (paragraph [0040]) indicates that the compound is not especially limited and that examples thereof include carboxylic acid compounds, alcohol compounds, amine compounds, blocked isocyanates, epoxy compounds, and the like.

However, isocyanate compounds and epoxy compounds are the only examples disclosed in the meaning of PCT Article 5.

In view of technical knowledge which was common at the time of the filing of this application, it is considered that carboxylic acid compounds, alcohol compounds, amine compounds, etc. differ from isocyanate compounds and epoxy compounds in chemical structure and reactivity. Hence, claims 1-3 and 5-18 cannot be generalized or extended, and lack a support in the meaning of PCT Article 6.

Therefore, a search was made for the subject matters in which the compound is an isocyanate compound or epoxy compound.

Form PCT/ISA/210 (extra sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006208824 A
- JP 2014065833 A
- JP 2005221726 A
- JP 4502784 B
- JP 2009237362 A
- JP 2000310706 A
- JP 2011095716 A
- JP 2010237589 A
- JP 2004149806 A
- JP 2012211228 A
- JP 2015135396 A
- WO 2011052620 A
- JP 59044615 A
- JP S5944615 A
- JP 54034327 B
- JP S5434327 B
- JP 58012577 B
- JP S5812577 B
- JP 54025957 B
- JP S5425957 B
- JP 59053836 A
- JP S5953836 A
- JP 59071048 A
- JP S5971048 A
- JP 46002121 A
- JP S462121 A
- JP 56040824 B
- JP S5640824 B
- JP 7140654 A
- JP H07140654 A
- JP 2004239942 A
- JP 4098550 B
- JP 5072724 A
- JP H0572724 A
- JP 2006259138 A
- JP 2010086684 A
- JP 2010152809 A
- JP 2010257492 A
- JP 4506785 B
- JP 2006023696 A
- JP 2005007765 A
- JP 4546276 B
- JP 2005017716 A
- JP 2004361447 A
- JP 2005017521 A
- JP 2010152155 A
- JP 2012078528 A
- JP 2008146018 A
- JP 2009047936 A

### Non-patent literature cited in the description

- Emulsion Latex Handbook. Taiseisha Ltd, 1975
- **KUNIZOU ASAKURA.** Pigment Dictionary. Asakura Publishing Co., Ltd, 2000, 438
- Advanced touch panel technology. Techno Times Co., Ltd, 06 July 2009
- Technology and development of touch panels. CMC Publishing Co., Ltd, December 2004